(19) Europäisches Patentamt
European Patent Office
Office européen des brevets

(11) **EP 4 471 756 A1**

(12) **EUROPEAN PATENT APPLICATION**
published in accordance with Art. 153(4) EPC

(43) Date of publication:
**04.12.2024 Bulletin 2024/49**

(21) Application number: **23743411.3**

(22) Date of filing: **12.01.2023**

(51) International Patent Classification (IPC):
*G09G 3/32* (2016.01)   *H01L 33/38* (2010.01)
*H01L 33/62* (2010.01)   *H01L 27/12* (2006.01)

(52) Cooperative Patent Classification (CPC):
**H01L 25/0753; G06F 3/1446; G09G 3/2081;**
**G09G 3/32; H01L 33/62;** G09G 2300/026;
G09G 2300/0426; G09G 2320/041; H01L 25/167

(86) International application number:
**PCT/KR2023/000539**

(87) International publication number:
**WO 2023/140563 (27.07.2023 Gazette 2023/30)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **24.01.2022   KR 20220010242**

(71) Applicant: **Samsung Display Co., Ltd.**
**Gyeonggi-do 17113 (KR)**

(72) Inventors:
• **HWANG, Jung Hwan**
  **Yongin-si Gyeonggi-do 17113 (KR)**
• **KIM, Hyun Joon**
  **Yongin-si Gyeonggi-do 17113 (KR)**
• **LEE, Kye Uk**
  **Yongin-si Gyeonggi-do 17113 (KR)**
• **JEON, Sang Jin**
  **Yongin-si Gyeonggi-do 17113 (KR)**

(74) Representative: **Marks & Clerk LLP**
**15 Fetter Lane**
**London EC4A 1BW (GB)**

(54) **DISPLAY DEVICE**

(57)     A display includes a first sub-pixel and a second sub-pixel emitting different lights. The first sub-pixel includes a first anode pad electrode and a second anode pad electrode spaced apart from each other in plan view, a first cathode pad electrode spaced apart from the first anode pad electrode and the second anode pad electrode in plan view, and a first light emitting element comprising a first sub-light emitting element disposed on the first anode pad electrode and the first cathode pad electrode, and a second sub-light emitting element disposed on the second anode pad electrode and the first cathode pad electrode. An area of the first cathode pad electrode is larger than an area of the first anode pad electrode or an area of the second anode pad electrode. The first sub-light emitting element and the second sub-light emitting element emit light during different periods, and the first sub-light emitting element and the second sub-light emitting element emit the same light.

**FIG. 6**

**Description**

[Technical Field]

The present disclosure relates to a display device.

[Background of the Invention]

With the advance of information-oriented society, more and more demands are placed on display devices for displaying images in various ways. The display device may be a flat panel display device such as a liquid crystal display, a field emission display and a light emitting display.

A light emitting display device may include an organic light emitting display device including an organic light emitting diode as a light emitting element or a light emitting diode display device including an inorganic light emitting diode such as a light emitting diode (LED) as a light emitting element. As the temperature of the inorganic light emitting diode increases due to heat generated by the inorganic light emitting diode, the luminous efficiency of the inorganic light emitting diode may decrease.

[Summary of the Invention]

[Aspects to be Achieved by the Invention]

Embodiments may provide a display device capable of suppressing or preventing a decrease in an emission luminance of an inorganic light emitting diode due to heat generated by the inorganic light emitting diode.

Additional features of embodiments will be set forth in the description which follows, and in part may be apparent from the description, or may be learned by practice of an embodiment or embodiments herein.

[Means for Achieving the Aspects of the Invention]

According to an embodiment, a display includes a first sub-pixel and a second sub-pixel emitting different lights. The first sub-pixel includes a first anode pad electrode and a second anode pad electrode spaced apart from each other in plan view, a first cathode pad electrode spaced apart from the first anode pad electrode and the second anode pad electrode in plan view, and a first light emitting element comprising a first sub-light emitting element disposed on the first anode pad electrode and the first cathode pad electrode, and a second sub-light emitting element disposed on the second anode pad electrode and the first cathode pad electrode. An area of the first cathode pad electrode is larger than an area of the first anode pad electrode or an area of the second anode pad electrode. The first sub-light emitting element and the second sub-light emitting element emit light during different periods, and the first sub-light emitting element and the second sub-light emitting element emit the same light.

A length of the first cathode pad electrode in one direction may be greater than a length of the first anode pad electrode in one direction or a length of the second anode pad electrode in one direction.

The second sub-pixel may include a third anode pad electrode, a second cathode pad electrode spaced apart from the third anode pad electrode, and a second light emitting element disposed on the third anode pad electrode and the second cathode pad electrode.

An area of the first cathode pad electrode may be larger than an area of the second cathode pad electrode.

A length of the first cathode pad electrode in one direction may be greater than a length of the second cathode pad electrode in one direction.

The display device may further include a third sub-pixel emitting light different from those of the first sub-pixel and the second sub-pixel. The third sub-pixel may include a fourth anode pad electrode, a third cathode pad electrode spaced apart from the third anode pad electrode in plan view, and a third light emitting element disposed on the fourth anode pad electrode and the third cathode pad electrode.

An area of the first cathode pad electrode may be larger than an area of the third cathode pad electrode.

A length of the first cathode pad electrode in one direction may be greater than a length of the third cathode pad electrode in one direction.

The first sub-light emitting element and the second sub-light emitting element may emit first light, the second light emitting element may emit second light, and the third light emitting element may emit third light.

The first light may be red light, the second light may be green light, and the third light may be blue light.

According to an embodiment, a display includes a first data line to which a first data voltage is applied, a second data line to which a second data voltage is applied, a first emission control line to which a first emission control signal is applied, a second emission control line to which a second emission control signal is applied, and a first sub-pixel connected

**EP 4 471 756 A1**

to the first data line, the second data line, the first emission control line, and the second emission control line. The first sub-pixel include a first light emitting element comprising a first sub-light emitting element and a second sub-light emitting element emitting first light, a first pixel driver configured to generate a control current in response to the first data voltage of the first data line, a second pixel driver configured to generate a first driving current applied to the first sub-light emitting element or the second sub-light emitting element in response to the second data voltage of the second data line, and a third pixel driver configured to control a period in which the first driving current is applied to the first sub-light emitting element or the second sub-light emitting element in response to the control current of the first pixel driver. The third pixel driver include a first transistor configured to supply the first driving current to the first light emitting element in response to the first emission control signal, and a second transistor configured to supply the first driving current to the second light emitting element in response to the second emission control signal. The first emission control signal has a gate-on voltage during an Nth frame period and a gate-off voltage during an (N+1)th frame period, and the second emission control signal has the gate-off voltage during the Nth frame period and has the gate-on voltage during the (N+1)th frame period.

The display device may further include a first initialization signal line to which a first initialization signal is applied, and an initialization voltage line to which an initialization voltage is applied. The first sub-pixel may further include a third transistor configured to supply the initialization voltage to a first electrode of the first sub-light emitting element in response to the first initialization signal, and a fourth transistor configured to supply the initialization voltage to a first electrode of the second light emitting element in response to the first initialization signal.

The display device may further include an emission signal line to which an emission signal is applied, and a second sub-pixel connected to the emission signal line and the first initialization signal line. The second sub-pixel may include a second light emitting element emitting second light, a fifth transistor configured to supply a second driving current to the second light emitting element in response to the first emission signal, and a sixth transistor configured to supply the initialization voltage to the first electrode of the second light emitting element in response to the first initialization signal.

The first light may be red light, and the second light may be green light or blue light.

According to an embodiment, a display includes a first data line to which a first data voltage is applied, a second data line to which a second data voltage is applied, a first emission signal line to which a first emission signal is applied, a second emission signal line to which a second emission signal is applied, and a first sub-pixel connected to the first data line, the second data line, the first emission signal line, and the second emission signal line. The first sub-pixel include a first light emitting element comprising a first sub-light emitting element and a second sub-light emitting element emitting first light, a first pixel driver configured to generate a control current in response to the first data voltage of the first data line, a second pixel driver configured to generate a first driving current applied to the first sub-light emitting element or the second sub-light emitting element in response to the second data voltage of the second data line, and a third pixel driver configured to control a period in which the first driving current is applied to the first sub-light emitting element or the second sub-light emitting element in response to the control current of the first pixel driver. The third pixel driver include a first transistor configured to supply the first driving current to the first sub-light emitting element in response to the first emission signal, and a second transistor configured to supply the first driving current to the second light emitting element in response to the second emission signal. One frame period includes a plurality of emission periods, and the first transistor and the second transistor are turned on during different emission periods among the plurality of emission periods.

The first transistor may be turned on during odd emission periods among the plurality of emission periods, and the second transistor may be turned on during even emission periods among the plurality of emission periods.

During odd emission periods among the plurality of emission periods, the first emission signal may have a gate-on voltage, and the second emission signal may have a gate-off voltage. During even emission periods among the plurality of emission periods, the second emission signal may have the gate-on voltage, and the first emission signal may have the gate-off voltage.

The display device may further include a first initialization signal line to which a first initialization signal is applied, and an initialization voltage line to which an initialization voltage is applied. The first sub-pixel may further include a third transistor configured to supply the initialization voltage to a first electrode of the first sub-light emitting element in response to the first initialization signal, and a fourth transistor configured to supply the initialization voltage to a first electrode of the second light emitting element in response to the first initialization signal.

The display device may further include a second sub-pixel connected to the first emission signal line and the second emission line. The second sub-pixel may include a second light emitting element emitting second light, a fifth transistor configured to supply a second driving current to the second light emitting element in response to the first emission signal, and a sixth transistor configured to supply the second driving current to the second light emitting element in response to the second emission signal.

The display device may further include a first initialization signal line to which a first initialization signal is applied, and an initialization voltage line to which an initialization voltage is applied. The second sub-pixel may further include a seventh transistor configured to supply the initialization voltage to the first electrode of the second light emitting element in response to the first initialization signal.

The first light may be red light, and the second light may be green light or blue light.

Other features and embodiments may be apparent from the following detailed description, the drawings, and the claims.

[Effects of the Invention]

According to an embodiment, a sub-pixel emitting red light includes a first sub-light emitting element and a second sub-light emitting element that emit light during different periods. Accordingly, the emission period of the first sub-light emitting element of a first sub-pixel emitting red light and the emission period of the second sub-light emitting element of the first sub-pixel emitting red light may be reduced to a half compared to the emission period of the light emitting element of a sub-pixel emitting green light or blue light. Since it is possible to reduce the amount of heat generated by the first sub-light emitting element and the amount of heat generated by the second sub-light emitting element, the temperature of the first sub-light emitting element and the temperature of the second sub-light emitting element may be lowered. Therefore, it is possible to suppress or prevent a decrease in the emission luminance of the first sub-light emitting element and the emission luminance of the second sub-light emitting element due to the heat generated by the first sub-light emitting element emitting red light and the heat generated by the second sub-light emitting element emitting red light.

However, the effects of the present disclosure are not limited to the aforementioned effects, and various other effects are included in the present disclosure.

[Brief Description of the Drawings]

FIG. 1 is a plan view illustrating a display device according to one embodiment.

FIG. 2 is an exemplary diagram showing an example of a pixel of FIG. 1.

FIG. 3 is an exemplary diagram showing another example of the pixel of FIG. 1.

FIG. 4 is a block diagram illustrating a display device according to one embodiment.

FIG. 5 is a graph showing luminous efficiency corresponding to temperatures of a first light emitting element and a third light emitting element according to one embodiment.

FIG. 6 is an equivalent circuit diagram illustrating a first sub-pixel according to another embodiment.

FIG. 7 is an equivalent circuit diagram illustrating a second sub-pixel according to one embodiment.

FIG. 8 is an equivalent circuit diagram illustrating a third sub-pixel according to one embodiment.

FIG. 9 shows one example of the operation of a display device during $N^{th}$ to $(N+2)^{th}$ frame periods.

FIG. 10 shows another example of the operation of the display device during the $N^{th}$ to $(N+2)^{th}$ frame periods.

FIG. 11 is a waveform diagram showing the $k^{th}$ scan initialization signal, the $k^{th}$ scan write signal, the $k^{th}$ scan control signal, the $k^{th}$ PWM emission signal, the $k^{th}$ PAM emission signal, and the $k^{th}$ sweep signal applied to the first sub-pixel disposed in the $k^{th}$ row line, the voltage of the third node, the emission timing of the light emitting element, the first emission control signal, and the second emission control signal in an $N^{th}$ period and an $(N+1)^{th}$ period according to one embodiment.

FIG. 12 is a timing diagram showing the $k^{th}$ sweep signal, the voltage of the gate electrode of the first transistor, the turn-on timing of the first transistor, and the turn-on timing of the fifteenth transistor during the fifth period and the sixth period according to one embodiment.

FIGS. 13 to 16 are circuit diagrams showing operations of the first sub-pixel during the first period, the second period, the third period, the fifth period, and the sixth period of the $N^{th}$ frame period of FIG. 11.

FIG. 17 is a circuit diagram showing the operation of the first sub-pixel during the sixth period of the $(N+1)^{th}$ frame period of FIG. 11.

FIG. 18 is a circuit diagram showing the operation of the second sub-pixel during the sixth period of the $N^{th}$ frame period and the $(N+1)^{th}$ frame period of FIG. 11.

FIGS. 19 and 20 are layout diagrams showing pixels according to one embodiment.

FIG. 21 is an enlarged layout view illustrating area A of FIG. 19 in detail.

FIG. 22 is an enlarged layout view illustrating area B of FIG. 19 in detail.

FIG. 23 is an enlarged layout view illustrating area A of FIG. 20 in detail.

FIG. 24 is an enlarged layout view illustrating area C of FIG. 19 in detail.

FIG. 25 is an enlarged layout view illustrating area D of FIG. 19 in detail.

FIG. 26 is an enlarged layout view illustrating area C of FIG. 20 in detail.

FIG. 27 is a cross-sectional view illustrating an example of the display panel taken along line A-A' of FIG. 21.

FIG. 28 is a cross-sectional view illustrating an example of a display panel taken along line B-B' of FIGS. 21 and 24.

FIG. 29 is an equivalent circuit diagram showing a first sub-pixel according to one embodiment.

FIG. 30 is an equivalent circuit diagram illustrating a second sub-pixel according to one embodiment.

FIG. 31 is an equivalent circuit diagram illustrating a third sub-pixel according to one embodiment.

FIG. 32 is a waveform diagram showing the kth scan initialization signal, the kth scan write signal, the kth scan control signal, the kth PWM emission signal, the kth PAMA emission signal, the kth PAMB emission signal, and the kth sweep signal applied to the first sub-pixel disposed in the kth row line, the voltage of the third node, and the period in which a driving current is applied to a light emitting element in the Nth frame period according to one embodiment.

FIG. 33 is an exemplary diagram showing a PAMA emission signal output unit and a PAMB emission signal output unit according to one embodiment.

FIG. 34 is a waveform diagram showing the PAMA clock signals and the PAMB clock signals.

FIG. 35 is a perspective view illustrating a tiled display device including a plurality of display devices according to one embodiment.

FIG. 36 is an enlarged layout view illustrating area E of FIG. 35 in detail.

FIG. 37 is a cross-sectional view illustrating an example of a tiled display device taken along line E-E" of FIG. 36.

FIG. 38 is an enlarged layout view illustrating area F of FIG. 35 in detail.

FIG. 39 is a cross-sectional view illustrating an example of a tiled display device taken along line I-I' of FIG. 38.

FIG. 40 is a block diagram illustrating a tiled display device according to one embodiment.

[Detailed Description of the Preferred Embodiments]

Advantages and features of the present disclosure and methods for accomplishing these advantages and features will become apparent from exemplary embodiments to be described later in detail with reference to the accompanying drawings. However, the present disclosure is not limited to exemplary embodiments disclosed below, and may be implemented in various different forms, these exemplary embodiments will be provided only in order to make the present disclosure complete and allow one of ordinary skill in the art to which the present disclosure pertains to completely recognize the scope of the present disclosure, and the present disclosure will be defined by the scope of the claims.

The phrase "one element or layer 'on' another element or layer" includes both of a case where one element or layer is disposed immediately above another element or layer and a case where one element or layer is disposed above another element or layer with the other layer or element interposed therebetween. Throughout the specification, the same components will be denoted by the same reference numerals. The shape, size, ratio, angle, number and the like shown in the drawings to illustrate the embodiments of the present disclosure are only for illustration and are not limited to the contents shown in the drawings.

The terms "first", "second", and the like are used to describe various components, but these components are not limited by these terms. These terms are used only in order to distinguish one component from another component. Therefore, a first component mentioned below may be a second component within the technical spirit of the present disclosure.

Features of various embodiments of the present disclosure may be coupled to or combined with each other partially or wholly and may be technically linked and operated in various ways as being easily understood by those having ordinary skill in the art. In addition, embodiments may be implemented independently or associated together.

Hereinafter, embodiments of the present invention will be described with reference to the attached drawings.

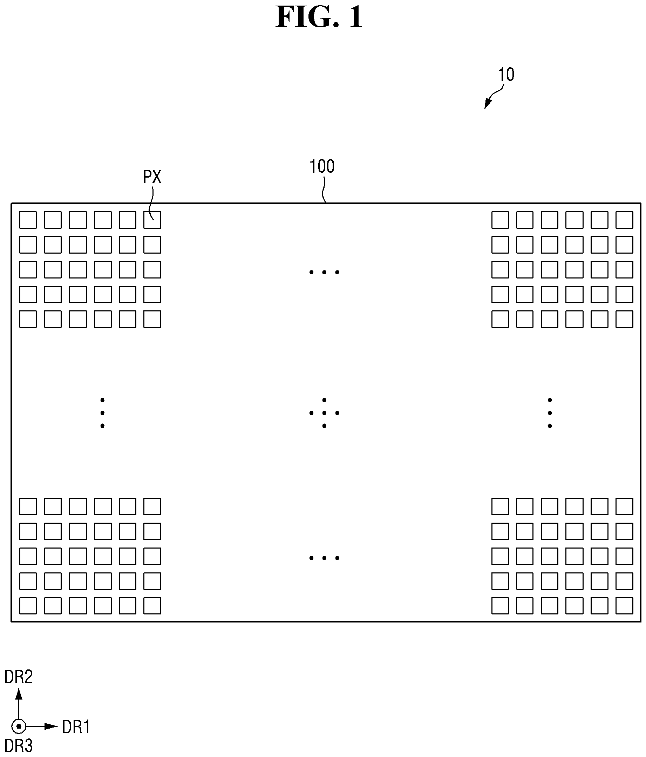

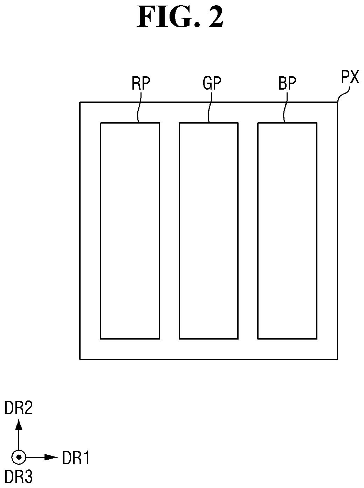

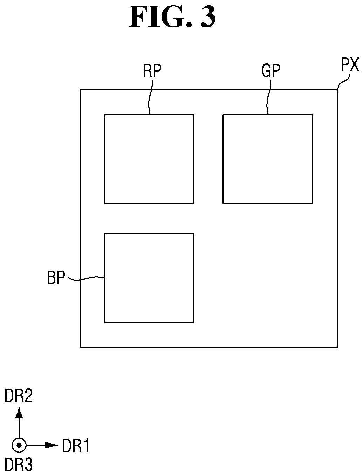

FIG. 1 is a plan view illustrating a display device according to one embodiment. FIG. 2 is an exemplary diagram showing an example of a pixel of FIG. 1. FIG. 3 is an exemplary diagram showing another example of the pixel of FIG. 1.

Referring to FIGS. 1 to 3, a display device 10 is a device for displaying a moving image or a still image. The display device 10 may be used as a display screen of various devices, such as a television, a laptop computer, a monitor, a billboard and an Internet-of Things (IOT) device, as well as portable electronic devices such as a mobile phone, a smartphone, a tablet personal computer (PC), a smart watch, a watch phone, a mobile communication terminal, an electronic notebook, an electronic book, a portable multimedia player (PMP), a navigation device and an ultra-mobile PC (UMPC).

The display panel 100 may, in plan view, be formed in a rectangular shape having long sides in a first direction DR1 and short sides in a second direction DR2 crossing the first direction DR1. The corners formed by meeting of the long sides in the first direction DR1 and the short sides in the second direction DR2 may be rounded to have a predetermined curvature or may be right-angled. The planar shape of the display panel 100 is not limited to the rectangular shape, and may be formed in another polygonal shape, a circular shape or an elliptical shape. The display panel 100 may be formed to be flat, but is not limited thereto. For example, the display panel 100 may include a curved portion formed at left and right ends and having a predetermined curvature or a varying curvature. In addition, the display panel 100 may be formed flexibly so that it can be curved, bent, folded, or rolled.

The display panel 100 may further include pixels PXs, scan lines extending in the first direction DR1, and data lines extending in the second direction DR2 in order to display an image. The pixels PX may be arranged in a matrix form in the first direction DR1 and the second direction DR2.

Each of the pixels PX may include a plurality of sub-pixels RP, GP, and BP as shown in FIGS. 2 and 3. Although FIGS. 2 and 3 illustrate that each of the pixels PX includes three sub-pixels RP, GP, and BP, i.e., a first sub-pixel RP, a second sub-pixel GP, and a third sub-pixel BP, the embodiment of the present specification is not limited thereto.

The first sub-pixel RP, the second sub-pixel GP, and the third sub-pixel BP may be connected to any one of the data lines and at least one of the scan lines.

Each of the first sub-pixel RP, the second sub-pixel GP, and the third sub-pixel BP may have a rectangular, square, or rhombus planar shape. For example, each of the first sub-pixel RP, the second sub-pixel GP, and the third sub-pixel BP may have a rectangular planar shape having a short side in the first direction DR1 and a long side in the second direction DR2 as shown in FIG. 2. Alternatively, each of the first sub-pixel RP, the second sub-pixel GP, and the third sub-pixel BP may have a square or rhombus planar shape including sides having the same length in the first direction DR1 and the second direction DR2 as shown in FIG. 3.

As shown in FIG. 2, the first sub-pixel RP, the second sub-pixel GP, and the third sub-pixel BP may be arranged in the first direction DR1. Alternatively, the first sub-pixel RP and any one of the second sub-pixel GP and the third sub-pixel BP may be arranged in the first direction DR1, and the other one and the first sub-pixel RP may be arranged in the second direction DR2. For example, as shown in FIG. 3, the first sub-pixel RP and the second sub-pixel GP may be arranged in the first direction DR1, and the first sub-pixel RP and the third sub-pixel BP may be arranged in the second direction DR2.

Alternatively, the second sub-pixel GP and any one of the first sub-pixel RP and the third sub-pixel BP may be arranged in the first direction DR1, and the other one and the second sub-pixel GP may be arranged in the second direction DR2. Alternatively, the third sub-pixel BP and any one of the first sub-pixel RP and the second sub-pixel GP may be arranged in the first direction DR1, and the other one and the third sub-pixel BP may be arranged in the second direction DR2.

The first sub-pixel RP may include a first light (e.g., light of a first color) emitting element emitting first light, the second sub-pixel GP may include a second light (e.g., light of a second color) emitting element emitting second light, and the third sub-pixel BP may include a third light (e.g., light of a third color) emitting element emitting third light. Here, the first light may be light of a red wavelength band, the second light may be light of a green wavelength band, and the third light may be light of a blue wavelength band. Although the red wavelength band may be a wavelength band of about 600 nm to 750 nm, the green wavelength band may be a wavelength band of about 480 nm to 560 nm, and the blue wavelength band may be a wavelength band of about 370 nm to 460 nm, but the embodiment of the present disclosure is not limited thereto.

Each of the first sub-pixel RP, the second sub-pixel GP, and the third sub-pixel BP, which is a light emitting element emitting light, may include an inorganic light emitting element having an inorganic semiconductor. For example, the inorganic light emitting element may be a flip chip type micro light emitting diode (LED), but the embodiment of the present specification is not limited thereto.

The area of the first sub-pixel RP, the area of the second sub-pixel GP, and the area of the third sub-pixel BP may be substantially the same as shown in FIGS. 2 and 3, but the embodiment of the present specification is not limited thereto. At least one of the area of the first sub-pixel RP, the area of the second sub-pixel GP, and the area of the third sub-pixel BP may be different from another one. Alternatively, any two of the area of the first sub-pixel RP, the area of the second sub-pixel GP, and the area of the third sub-pixel BP may be substantially the same, and the other one may be different from the two areas. Alternatively, the area of the first sub-pixel RP, the area of the second sub-pixel GP, and the area of the third sub-pixel BP may be different from each other.

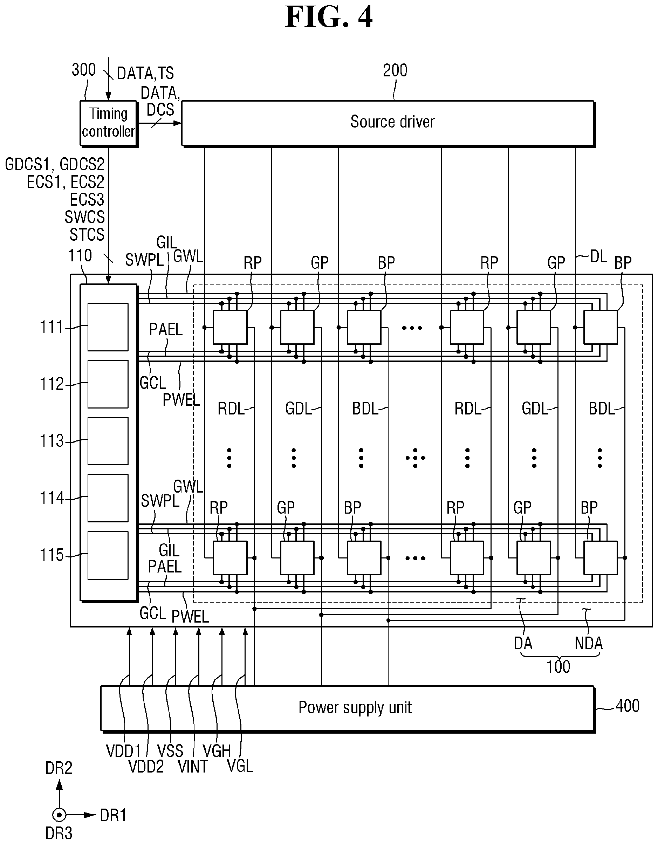

FIG. 4 is a block diagram illustrating a display device according to one embodiment.

Referring to FIG. 4, the display device 10 includes a display panel 100, a scan driver 110, a source driver 200, a timing controller 300, and a power supply unit 400.

A display area DA of the display panel 100 may include sub-pixels RP, GP, and BP for displaying an image, scan write lines GWL connected to the sub-pixels RP, GP, and BP, scan initialization lines GIL, scan control lines GCL, sweep signal lines SWPL, pulse width modulation (PWM) emission lines PWEL, pulse amplitude modulation (PAM) emission lines PAEL, PWM data lines DL, first PAM data lines RDL, second PAM data lines GDL, and third PAM data lines BDL.

The scan write lines GWL, the scan initialization lines GIL, the scan control lines GCL, the sweep signal lines SWPL, the PWM emission lines PWEL, and the PAM emission lines PAEL may extend in a first direction DR1, and may be disposed in a second direction DR2 intersecting the first direction DR1. The PWM data lines DL, the first PAM data lines RDL, the second PAM data lines GDL, and the third PAM data lines BDL may extend in the second direction DR2, and may be disposed in the first direction DR1. The first PAM data lines RDL may be electrically connected to each other, the second PAM data lines GDL may be electrically connected to each other, and the third PAM data lines BDL may be electrically connected to each other.

Each of the sub-pixels RP, GP, and BP may be connected to any one of the scan write lines GWL, any one of the scan initialization lines GIL, any one of the scan control lines GCL, any one of the sweep signal lines SWPL, any one of the PWM emission lines PWEL, and any one of the PAM emission lines PAEL. Further, each of the first sub-pixels RP may be connected to any one of the PWM data lines DL and any one of the first PAM data lines RDL. Further, each of the second sub-pixels GP may be connected to any one of the PWM data lines DL and any one of the second PAM data lines GDL.

Further, each of the third sub-pixels BP may be connected to any one of the PWM data lines DL and any one of the third PAM data lines BDL.

In a non-display area NDA of the display panel 100, a scan driver 110 for applying signals to the scan write lines GWL, the scan initialization lines GIL, the scan control lines GCL, the sweep signal lines SPWL, the PWM emission lines PWEL, and the PAM emission lines PAEL may be disposed. Although FIG. 4 illustrates that the scan driver 110 is disposed at one edge of the display panel 100, the present disclosure is not limited thereto. The scan driver 110 may be disposed at both edges of the display panel 100.

The scan driver 110 may include a first scan signal driver 111, a second scan signal driver 112, a sweep signal driver 113, an emission signal driver 114, and an emission control signal driver 115.

The first scan signal driver 111 may receive a first scan driving control signal GDCS1 from the timing controller 300. The first scan signal driver 111 may output scan initialization signals to the scan initialization lines GIL in response to the first scan driving control signal GDCS1, and may output scan write signals to the scan write lines GWL. In other words, the first scan signal driver 111 may output two types of scan signals, i.e., the scan initialization signals and the scan write signals.

The second scan signal driver 112 may receive a second scan driving control signal GDCS2 from the timing controller 300. The second scan signal driver 112 may output scan control signals to the scan control lines GCL in response to the second scan driving control signal GDCS2.

The sweep signal driver 113 may receive a first emission control signal ECS1 and a sweep control signal SWCS from the timing controller 300. The sweep signal driver 113 may output PWM emission signals to the PWM emission lines PWEL in response to the first emission control signal ECS1, and may output sweep signals to the sweep signal lines SWPL. That is, the sweep signal driver 113 may output the PWM emission signals and the sweep signals.

The emission signal output unit 114 may receive a second emission control signal ECS2 from the timing controller 300. The emission signal output unit 114 may output PAM emission signals to the PAM emission lines PAEL in response to the second emission control signal ECS2.

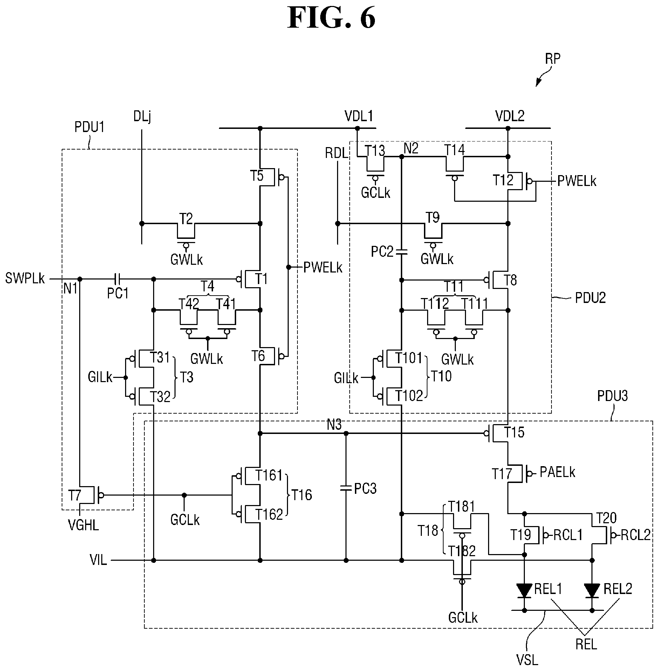

The emission control signal output unit 115 may receive a third emission control signal ECS3 from the timing controller 300. The emission control signal output unit 115 may output emission control signals to emission control lines RCL1 and RCL2 (see FIG. 6) in response to the third emission control signal ECS3. The emission control lines RCL1 and RCL2 (see FIG. 6) may be connected to the first sub-pixel RP, and may not be connected to the second sub-pixel GP and the third sub-pixel BP.

The timing controller 300 receives digital video data DATA and timing signals TS. The timing controller 300 may generate a scan timing control signal STCS for controlling the operation timing of the scan driver 110 in response to the timing signals TS. The scan timing control signal STCS may generate a first scan driving control signal GDSC1, a second scan driving control signal GDSC2, a first emission control signal ECS1, a second emission control signal ECS2, a third emission control signal ECS3, and a sweep control signal SWCS. Further, the timing controller 300 may generate a source control signal DCS for controlling the operation timing of the source driver 200.

The timing controller 300 outputs the first scan driving control signal GDCS1, the second scan driving control signal GDSC2, the first emission control signal ECS1, the second emission control signal ECS2, the third emission control signal ECS3, and the sweep control signal SWCS to the scan driver 110. The timing controller 300 outputs the digital video data DATA and the source control signal DCS to the source driver 200.

The source driver 200 converts the digital video data DATA to analog PWM data voltages and outputs them to the PWM data lines DL. Accordingly, the sub-pixels SP may be selected by the scan write signals of the scan driver 110, and PWM data voltages may be supplied to the selected sub-pixels RP, GP, and BP.

The power supply unit 400 may commonly output a first PAM data voltage to the first PAM data lines RDL, commonly output a second PAM data voltage to the second PAM data lines GDL, and commonly output a third PAM data voltage to the third PAM data lines BDL. Further, the power supply unit 400 may generate a plurality of power voltages and output them to the display panel 100.

The power supply unit 400 may output a first power voltage VDD1, a second power voltage VDD2, a third power voltage VSS, an initialization voltage VINT, a gate-on voltage VGL, and a gate-off voltage VGH to the display panel 100. The first power voltage VDD1 and the second power voltage VDD2 may be a high potential driving voltage for driving the light emitting element of each of the sub-pixels RP, GP, and BP. The initialization voltage VINT may be a low potential driving voltage for driving the light emitting element of each of the sub-pixels RP, GP, and BP. The initialization voltage VINT and the gate-off voltage VGH may be applied to each of the sub-pixels RP, GP, and BP, and the gate-on voltage VGL and the gate-off voltage VGH may be applied to the scan driver 110.

Each of the source driver 200, the timing controller 300, and the power supply unit 400 may be formed of an integrated circuit. Further, the source driver 200 may be formed of a plurality of integrated circuits.

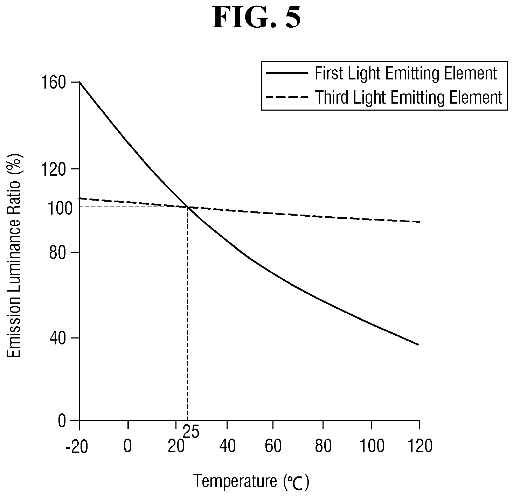

FIG. 5 is a graph showing luminous efficiency corresponding to temperatures of a first light emitting element and a third light emitting element according to one embodiment.

In FIG. 5, the X-axis represents the temperatures of the first light emitting element and the third light emitting element, and the Y-axis represents relative emission luminance ratios of the first light emitting element and the third light emitting element. In FIG. 5, the emission luminances of the first light emitting element and the third light emitting element were calculated to be 100% when the temperatures of the first light emitting element and the third light emitting element were 25 degrees.

Referring to FIG. 5, each of the first light emitting element and the third light emitting element emits light by a driving current, thereby emitting heat. That is, each of the first light emitting element and the third light emitting element is exposed to heat when it is driven.

The emission luminance ratio of the first light emitting element changes considerably depending on a temperature change. For example, when the temperature of the first light emitting element is -20 degrees, the first light emitting element has an emission luminance ratio of approximately 160%. On the other hand, when the temperature of the first light emitting element is 120 degrees, the first light emitting element has an emission luminance ratio of approximately 40%. That is, even when the same driving current is applied to the first light emitting element, the emission luminance ratio of the first light emitting element has a difference of approximately 120% within a temperature range from -20 degrees to 120 degrees.

The emission luminance ratio of the third light emitting element changes slightly depending on a temperature change. For example, when the same driving current is applied to the third light emitting element, the emission luminance ratio of the third light emitting element hardly changes within the temperature range from -20 degrees to 120 degrees.

Although the first light emitting element and the third light emitting element are compared without mentioning the second light emitting element in FIG. 5, the emission luminance ratio of the second light emitting element corresponding to a temperature change may be smaller than the emission luminance ratio of the first light emitting element corresponding to a temperature change. That is, the first light emitting element is more sensitive to the temperature change than the second light emitting element and the third light emitting element, so that it is necessary to maintain the temperature of the first light emitting element at a low level.

FIG. 6 is an equivalent circuit diagram illustrating a first sub-pixel according to another embodiment.

Referring to FIG. 6, the first sub-pixel RP according to one embodiment may be connected to the $k^{th}$ (k being a positive integer) scan write line GWLk, the $k^{th}$ scan initialization line GILk, the $k^{th}$ scan control line GCLk, the $k^{th}$ sweep signal line SWPLk, the $k^{th}$ PWM emission line PWELk, the $k^{th}$ PAM emission line PAELk, a first emission control line RCL1, and a second emission control line RCL2. Further, the first sub-pixel RP may be connected to the $j^{th}$ PWM data line DLj and the first PAM data line RDL. Further, the first sub-pixel RP may be connected to the first power line VDL1 to which the first power voltage VDD1 is applied, the second power line VDL2 to which the second power voltage VDD2 is applied, the third power line VSL to which the third power voltage VSS is applied, the initialization voltage line VIL to which the initialization voltage VINT is applied, and the gate-off voltage line VGHL to which the gate-off voltage VGH is applied. Meanwhile, for simplicity of description, the $j^{th}$ PWM data line DLj may be referred to as a first data line, and the first PAM data line RDL may be referred to as a second data line.

The first sub-pixel RP may include a first light emitting element REL including a first sub-light emitting element REL1 and a second sub-light emitting element REL2, a first pixel driver PDU1, a second pixel driver PDU2, and a third pixel driver PDU3.

Each of the first sub-light emitting element REL1 and the second sub-light emitting element REL2 emits the first light by a driving current Ids generated by the second pixel driver PDU2. The first sub-light emitting element REL1 may be disposed between a nineteenth transistor T19 and the third power line VSL, and the second sub-light emitting element REL2 may be disposed between a twentieth transistor T20 and the third power line VSL. The first electrode of the first sub-light emitting element REL1 may be connected to the second electrode of the nineteenth transistor T19, and the second electrode thereof may be connected to the third power line VSL. The first electrode of the second sub-light emitting element REL2 may be connected to the second electrode of the twentieth transistor T20, and the second electrode thereof may be connected to the third power line VSL.

The first electrode of each of the first sub-light emitting element REL1 and the second sub-light emitting element REL2 may be an anode electrode, and the second electrode thereof may be a cathode electrode. Each of the first sub-light emitting element REL1 and the second sub-light emitting element REL2 may be an inorganic light emitting element including a first electrode, a second electrode, and an inorganic semiconductor disposed between the first electrode and the second electrode. For example, each of the first sub-light emitting element REL1 and the second sub-light emitting element REL2 may be a micro light emitting diode made of an inorganic semiconductor, but is not limited thereto.

The first pixel driver PDU1 generates a control current Ic in response to a $j^{th}$ PWM data voltage of the $j^{th}$ PWM data line DLj to control the voltage of the third node N3 of the third pixel driver PDU3. Since the pulse width of the driving current Ids flowing through the first light emitting element REL may be adjusted by the control current Ic of the first pixel driver PDU1, the first pixel driver PDU1 may be a pulse width modulation (PWM) unit for performing pulse width modulation of the driving current Ids flowing through the first light emitting element REL.

The first pixel driver PDU1 may include first to seventh transistors T1 to T7 and the first capacitor PC 1.

The first transistor T1 controls the control current Ic flowing between the second electrode and the first electrode in response to the PWM data voltage applied to the gate electrode.

The second transistor T2 is turned on by the $k^{th}$ scan write signal of the $k^{th}$ scan write line GWLk to supply the PWM data voltage of the $j^{th}$ PWM data line DLj to the first electrode of the first transistor T1. The gate electrode of the second transistor T2 may be connected to the $k^{th}$ scan write line GWLk, the first electrode thereof may be connected to the $j^{th}$ PWM data line DLj, and the second electrode thereof may be connected to the first electrode of the first transistor T1.

The third transistor T3 is turned on by a $k^{th}$ scan initialization signal of the $k^{th}$ scan initialization line GILk to connect the initialization voltage line VIL to the gate electrode of the first transistor T1. Accordingly, during the turn-on period of the third transistor T3, the gate electrode of the first transistor T1 may be discharged to the initialization voltage VINT of the initialization voltage line VIL. In this case, the gate-on voltage VGL of the $k^{th}$ scan initialization signal may be different from the initialization voltage VINT of the initialization voltage line VIL. In particular, since the difference voltage between the gate-on voltage VGL and the initialization voltage VINT is greater than the threshold voltage of the third transistor T3, the third transistor T3 may be stably turned on even after the initialization voltage VINT is applied to the gate electrode of the first transistor T1. Therefore, when the third transistor T3 is turned on, the initialization voltage VINT may be stably applied to the gate electrode of the first transistor T1 regardless of the threshold voltage of the third transistor T3.

The third transistor T3 may include a plurality of transistors connected in series. For example, the third transistor T3 may include a first sub-transistor T31 and a second sub-transistor T32. Accordingly, it is possible to prevent the voltage of the gate electrode of the first transistor T1 from leaking through the third transistor T3. The gate electrode of the first sub-transistor T31 may be connected to the $k^{th}$ scan initialization line GILk, the first electrode thereof may be connected to the gate electrode of the first transistor T1, and the second electrode thereof may be connected to the first electrode of the second sub-transistor T32. The gate electrode of the second sub-transistor T32 may be connected to the $k^{th}$ scan initialization line GILk, the first electrode thereof may be connected to the second electrode of the first sub-transistor T31, and the second electrode thereof may be connected to the initialization voltage line VIL.

The fourth transistor T4 is turned on by the $k^{th}$ scan write signal of the $k^{th}$ scan write line GWLk to connect the gate electrode and the second electrode of the first transistor T1. Accordingly, during the turn-on period of the fourth transistor T4, the first transistor T1 may operate as a diode.

The fourth transistor T4 may include a plurality of transistors connected in series. For example, the fourth transistor T4 may include a third sub-transistor T41 and a fourth sub-transistor T42. Accordingly, it is possible to prevent the voltage of the gate electrode of the first transistor T1 from leaking through the fourth transistor T4. The gate electrode of the third sub-transistor T41 may be connected to the $k^{th}$ scan write line GWLk, the first electrode thereof may be connected to the second electrode of the first transistor T1, and the second electrode thereof may be connected to the first electrode of the fourth sub-transistor T42. The gate electrode of the fourth sub-transistor T42 may be connected to the $k^{th}$ scan write line GWLk, the first electrode thereof may be connected to the second electrode of the third sub-transistor T41, and the second electrode thereof may be connected to the gate electrode of the first transistor T1.

The fifth transistor T5 is turned on by the $k^{th}$ PWM emission signal of the $k^{th}$ PWM emission line PWELk to connect the first electrode of the first transistor T1 to the first power line VDL1. The gate electrode of the fifth transistor T5 may be connected to the $k^{th}$ PWM emission line PWELk, the first electrode thereof may be connected to the first power line VDL1, and the second electrode thereof may be connected to the first electrode of the first transistor T1.

The sixth transistor T6 is turned on by the $k^{th}$ PWM emission signal of the $k^{th}$ PWM emission line PWELk to connect the second electrode of the first transistor T1 to the third node N3 of the third pixel driver PDU3. The gate electrode of the sixth transistor T6 may be connected to the $k^{th}$ PWM emission line PWELk, the first electrode thereof may be connected to the second electrode of the first transistor T1, and the second electrode thereof may be connected to the third node N3 of the third pixel driver PDU3.

The seventh transistor T7 is turned on by the $k^{th}$ scan control signal of the $k^{th}$ scan control line GCLk to supply the gate-off voltage VGH of the gate-off voltage line VGHL to the first node N1 connected to the $k^{th}$ sweep signal line SWPLk. Accordingly, it is possible to prevent the change in the voltage of the gate electrode of the first transistor T1 from being reflected in the $k^{th}$ sweep signal of the $k^{th}$ sweep signal line SWPLk by the first capacitor PC1 during the period in which the initialization voltage VINT is applied to the gate electrode of the first transistor T1 and the period in which the PWM data voltage of the $j^{th}$ PWM data line DLj and a threshold voltage Vth1 of the first transistor T1 are programmed. The gate electrode of the seventh transistor T7 may be connected to the $k^{th}$ scan control line GCLk, the first electrode thereof may be connected to the gate-off voltage line VGHL, and the second electrode thereof may be connected to the first node N1.

The first capacitor PC1 may be disposed between the gate electrode of the first transistor T1 and the first node N1. One electrode of the first capacitor PC1 may be connected to the gate electrode of the first transistor T1, and the other electrode thereof may be connected to the first node N1.

The first node N1 may be the contact point of the $k^{th}$ sweep signal line SWPLk, the second electrode of the seventh transistor T7, and the other electrode of the first capacitor PC1.

The second pixel driver PDU2 generates the driving current Ids applied to the first light emitting element REL in response to the first PAM data voltage of the first PAM data line RDL. The second pixel driver PDU2 may be a pulse amplitude modulation (PAM) unit for performing pulse amplitude modulation. The second pixel driver PDU2 may be a constant current generator for generating a constant driving current Ids in response to the first PAM data voltage.

Further, the second pixel driver PDU2 of each of the first sub-pixels RP may receive the same first PAM data voltage regardless of the luminance of the first sub-pixel RP to generate the same driving current Ids. Similarly, the second pixel driver PDU2 of each of the second sub-pixels GP may receive the same second PAM data voltage regardless of the luminance of the second sub-pixel GP to generate the same driving current Ids. The second pixel driver PDU2 of each of the third sub-pixels BP may receive the same third PAM data voltage regardless of the luminance of the third sub-pixel BP to generate the same driving current Ids.

The second pixel driver PDU2 may include eighth to fourteenth transistors T8 to T14 and a second capacitor PC2.

The eighth transistor T8 controls the driving current Ids flowing to the first light emitting element REL in response to the voltage applied to the gate electrode.

The ninth transistor T9 is turned on by the $k^{th}$ scan write signal of the $k^{th}$ scan write line GWLk to supply the first PAM data voltage of the first PAM data line RDL to the first electrode of the eighth transistor T8. The gate electrode of the ninth transistor T9 may be connected to the $k^{th}$ scan write line GWLk, the first electrode thereof may be connected to the first PAM data line RDL, and the second electrode thereof may be connected to the first electrode of the eighth transistor T8.

The tenth transistor T10 is turned on by the $k^{th}$ scan initialization signal of the $k^{th}$ scan initialization line GILk to connect the initialization voltage line VIL to the gate electrode of the eighth transistor T8. Accordingly, during the turn-on period of the tenth transistor T10, the gate electrode of the eighth transistor T8 may be discharged to the initialization voltage VINT of the initialization voltage line VIL. In this case, the gate-on voltage VGL of the $k^{th}$ scan initialization signal may be different from the initialization voltage VINT of the initialization voltage line VIL. In particular, since the difference voltage between the gate-on voltage VGL and the initialization voltage VINT is greater than the threshold voltage of the tenth transistor T10, the tenth transistor T10 may be stably turned on even after the initialization voltage VINT is applied to the gate electrode of the eighth transistor T8. Therefore, when the tenth transistor T10 is turned on, the initialization voltage VINT may be stably applied to the gate electrode of the eighth transistor T8 regardless of the threshold voltage of the tenth transistor T10.

The tenth transistor T10 may include a plurality of transistors connected in series. For example, the tenth transistor T10 may include a fifth sub-transistor T101 and a sixth sub-transistor T102. Accordingly, the voltage of the gate electrode of the eighth transistor T8 may be prevented from leaking through the tenth transistor T10. The gate electrode of the fifth sub-transistor T101 may be connected to the $k^{th}$ scan initialization line GILk, the first electrode thereof may be connected to the gate electrode of the eighth transistor T8, and the second electrode thereof may be connected to the first electrode of the sixth sub-transistor T102. The gate electrode of the sixth sub-transistor T102 may be connected to the $k^{th}$ scan initialization line GILk, the first electrode thereof may be connected to the second electrode of the fifth sub-transistor T101, and the second electrode thereof may be connected to the initialization voltage line VIL.

The eleventh transistor T11 is turned on by the $k^{th}$ scan write signal of the $k^{th}$ scan write line GWLk to connect the gate electrode and the second electrode of the eighth transistor T8. Accordingly, during the turn-on period of the eleventh transistor T11, the eighth transistor T8 may operate as a diode.

The eleventh transistor T11 may include a plurality of transistors connected in series. For example, the eleventh transistor T11 may include a seventh sub-transistor T111 and an eighth sub-transistor T112. Accordingly, it is possible to prevent the voltage of the gate electrode of the eighth transistor T8 from leaking through the eleventh transistor T11. The gate electrode of the seventh sub-transistor T111 may be connected to the $k^{th}$ scan write line GWLk, the first electrode thereof may be connected to the second electrode of the eighth transistor T8, and the second electrode thereof may be connected to the first electrode of the eighth sub-transistor T112. The gate electrode of the eighth sub-transistor T112 may be connected to the $k^{th}$ scan write line GWLk, the first electrode thereof may be connected to the second electrode of the seventh sub-transistor T111, and the second electrode thereof may be connected to the gate electrode of the eighth transistor T8.

The twelfth transistor T12 is turned on by the $k^{th}$ PWM emission signal of the $k^{th}$ PWM emission line PWELk to connect the first electrode of the eighth transistor T8 to the second power line VDL2. The gate electrode of the twelfth transistor T12 may be connected to the $k^{th}$ PWM emission line PWELk, the first electrode thereof may be connected to the first power line VDL1, and the second electrode thereof may be connected to the first electrode of the eighth transistor T8.

The thirteenth transistor T13 is turned on by the $k^{th}$ scan control signal of the $k^{th}$ scan control line GCLk to connect the first power line VDL1 to the second node N2. The gate electrode of the thirteenth transistor T13 may be connected to the $k^{th}$ scan control line GCLk, the first electrode thereof may be connected to the second power line VDL2, and the second electrode thereof may be connected to the second node N2.

The fourteenth transistor T14 is turned on by the $k^{th}$ PWM emission signal of the $k^{th}$ PWM emission line PWELk to connect the second power line VDL2 to the second node N2. Accordingly, when the fourteenth transistor T14 is turned on, the second power voltage VDD2 of the second power line VDL2 may be supplied to the second node N2. The gate electrode of the fourteenth transistor T14 may be connected to the $k^{th}$ PWM emission line PWELk, the first electrode thereof may be connected to the second power line VDL2, and the second electrode thereof may be connected to the second node N2.

The second capacitor PC2 may be disposed between the gate electrode of the eighth transistor T8 and the second node N2. One electrode of the second capacitor PC2 may be connected to the gate electrode of the eighth transistor T8, and the other electrode thereof may be connected to the second node N2.

The second node N2 may be the contact point of the second electrode of the thirteenth transistor T13, the second electrode of the fourteenth transistor T14, and the other electrode of the second capacitor PC2.

The third pixel driver PDU3 adjusts the period in which the driving current Ids is applied to the first light emitting element REL depending on the voltage of the third node N3.

The third pixel driver PDU3 may include fifteenth to twentieth transistors T15 to T20 and a third capacitor PC3.

The fifteenth transistor T15 is turned on or turned off depending on the voltage of the third node N3. When the fifteenth transistor T15 is turned on, the driving current Ids of the eighth transistor T8 may be supplied to the first light emitting element REL, and when the fifteenth transistor T15 is turned off, the driving current Ids of the eighth transistor T8 may not be supplied to the first light emitting element REL. Therefore, the turn-on period of the fifteenth transistor T15 may be substantially the same as the emission period of the first light emitting element REL. The gate electrode of the fifteenth transistor T15 may be connected to the third node N3, the first electrode thereof may be connected to the second electrode of the eighth transistor T8, and the second electrode thereof may be connected to the first electrode of the seventeenth transistor T17.

The sixteenth transistor T16 is turned on by the k$^{th}$ scan control signal of the k$^{th}$ scan control line GCLk to connect the initialization voltage line VIL to the third node N3. Accordingly, during the turn-on period of the sixteenth transistor T16, the third node N3 may be discharged to the initialization voltage VINT of the initialization voltage line VIL.

The sixteenth transistor T16 may include a plurality of transistors connected in series. For example, the sixteenth transistor T16 may include a ninth sub-transistor T161 and a tenth sub-transistor T162. Accordingly, it is possible to prevent the voltage V_N3 of the third node N3 from leaking through the sixteenth transistor T16. The gate electrode of the ninth sub-transistor T161 may be connected to the k$^{th}$ scan control line GCLk, the first electrode thereof may be connected to the third node N3, and the second electrode thereof may be connected to the first electrode of the tenth sub-transistor T162. The gate electrode of the tenth sub-transistor T162 may be connected to the k$^{th}$ scan control line GCLk, the first electrode thereof may be connected to the second electrode of the ninth sub-transistor T161, and the second electrode thereof may be connected to the initialization voltage line VIL.

The seventeenth transistor T17 is turned on by the k$^{th}$ PAM emission signal of the k$^{th}$ PAM emission line PAELk to connect the second electrode of the fifteenth transistor T15 to the first electrode of the nineteenth transistor T19 and the first electrode of the twentieth transistor T20. The gate electrode of the seventeenth transistor T17 may be connected to the k$^{th}$ PAM emission line PAELk, the first electrode thereof may be connected to the second electrode of the fifteenth transistor T15, and the second electrode thereof may be connected to the first electrode of the nineteenth transistor T19 and the first electrode of the twentieth transistor T20.

The eighteenth transistor T18 may include an eleventh sub-transistor T181 and a twelfth sub-transistor T182.

The eleventh sub-transistor T181 is turned on by the k$^{th}$ scan control signal of the k$^{th}$ scan control line GCLk to connect the initialization voltage line VIL to the first electrode of the first sub-light emitting element REL1. Accordingly, during the turn-on period of the eleventh sub-transistor T181, the first electrode of the first sub-light emitting element REL1 may be discharged to the initialization voltage VINT of the initialization voltage line VIL. The gate electrode of the eleventh sub-transistor T181 may be connected to the k$^{th}$ scan control line GCLk, the first electrode thereof may be connected to the first electrode of the first sub-light emitting element REL1, and the second electrode thereof may be connected to the initialization voltage line VIL.

The twelfth sub-transistor T182 is turned on by the k$^{th}$ scan control signal of the k$^{th}$ scan control line GCLk to connect the initialization voltage line VIL to the first electrode of the second sub-light emitting element REL2. Accordingly, during the turn-on period of the twelfth sub-transistor T182, the first electrode of the second sub-light emitting element REL2 may be discharged to the initialization voltage VINT of the initialization voltage line VIL. The gate electrode of the twelfth sub-transistor T182 may be connected to the k$^{th}$ scan control line GCLk, the first electrode thereof may be connected to the first electrode of the second sub-light emitting element REL2, and the second electrode thereof may be connected to the initialization voltage line VIL.

The nineteenth transistor T19 is turned on by the first emission control signal of the first emission control line RCL1 to connect the first electrode of the first sub-light emitting element REL1 to the second electrode of the seventeenth transistor T17. Accordingly, the driving current Ids may be supplied to the first sub-light emitting element REL1 during the turn-on period of the nineteenth transistor T19. The gate electrode of the nineteenth transistor T19 may be connected to the first emission control line RCL1, the first electrode thereof may be connected to the second electrode of the seventeenth transistor T17, and the second electrode thereof may be connected to the first electrode of the first sub-light emitting element REL1.

The twentieth transistor T20 is turned on by the second emission control signal of the second emission control line RCL2 to connect the first electrode of the second sub-light emitting element REL2 to the second electrode of the seventeenth transistor T17. Accordingly, the driving current Ids may be supplied to the second sub-light emitting element REL2 during the turn-on period of the twentieth transistor T20. The gate electrode of the twentieth transistor T20 may be connected to the second emission control line RCL2, the first electrode thereof may be connected to the second electrode of the seventeenth transistor T17, and the second electrode thereof may be connected to the first electrode of the second sub-light emitting element REL2.

Any one of the first electrode and the second electrode of each of the first to twentieth transistors T1 to T20 may be a source electrode, and the other may be a drain electrode. The active layer of each of the first to twentieth transistors T1 to T20 may be formed of any one of polysilicon, amorphous silicon, and an oxide semiconductor. When the active layer of each of the first to twentieth transistors T1 to T20 is polysilicon, it may be formed by a low temperature poly silicon (LTPS) process.

Further, although FIG. 6 mainly describes the case in which each of the first to twentieth transistors T1 to T20 is formed as the P-type metal oxide semiconductor field effect transistor (MOSFET), the embodiment of the present specification is not limited thereto. For example, each of the first to twentieth transistors T1 to T20 may be formed as the N-type MOSFET.

Alternatively, in order to improve the black display capability of the first light emitting element REL by blocking a leakage current, in the first sub-pixel RP, the first sub-transistor T31 and the second sub-transistor T32 of the third transistor T3 the third sub-transistor T41 and the fourth sub-transistor T42 of the fourth transistor T4, the fifth sub-transistor T101 and the sixth sub-transistor T102 of the tenth transistor T10, and the seventh sub-transistor T111 and the eighth sub-transistor T112 of the eleventh transistor T11 may be formed as the N-type MOSFET. In this case, the first sub-transistor T31 and the second sub-transistor T32 of the third transistor T3, the third sub-transistor T41 and the fourth sub-transistor T42 of the fourth transistor T4, the fifth sub-transistor T101 and the sixth sub-transistor T102 of the tenth transistor T10, and the seventh sub-transistor T111 and the eighth sub-transistor T112 of the eleventh transistor T11 may be turned on when the gate-off voltage VGH is applied to the gate electrode. Therefore, the gate electrode of the third sub-transistor T41 and the gate electrode of the fourth sub-transistor T42 of the fourth transistor T4, and the gate electrode of the seventh sub-transistor T111 and the gate electrode of the eighth sub-transistor T112 of the eleventh transistor T11 may be connected to the $k^{th}$ control line to which the $k^{th}$ control signal is applied, instead of the $k^{th}$ scan write line GWLk. Further, the active layers of the first sub-transistor T31 and the second sub-transistor T32 of the third transistor T3, the third sub-transistor T41 and the fourth sub-transistor T42 of the fourth transistor T4, the fifth sub-transistor T101 and the sixth sub-transistor T102 of the tenth transistor T10, and the seventh sub-transistor T111 and the eighth sub-transistor T112 of the eleventh transistor T11 may be formed of an oxide semiconductor, and the active layers of the other transistors may be formed of polysilicon.

Alternatively, any one of the first sub-transistor T31 and the second sub-transistor T32 of the third transistor T3 may be formed as the N-type MOSFET and the other may be formed as the P-type MOSFET. In this case, between the first sub-transistor T31 and the second sub-transistor T32 of the third transistor T3, the active layer of the transistor formed as the N-type MOSFET may be formed of an oxide semiconductor, and the active layer of the transistor formed as the P-type MOSFET may be formed of polysilicon.

Alternatively, any one of the third sub-transistor T41 and the fourth sub-transistor T42 of the fourth transistor T4 may be formed as the N-type MOSFET, and the other may be formed as the P-type MOSFET. In this case, between the third sub-transistor T41 and the fourth sub-transistor T42 of the fourth transistor T4, the active layer of the transistor formed as the N-type MOSFET may be formed of an oxide semiconductor, and the active layer of the transistor formed as the P-type MOSFET may be formed of polysilicon.

Alternatively, any one of the fifth sub-transistor T101 and the sixth sub-transistor T102 of the tenth transistor T10 may be formed as the N-type MOSFET, and the other may be formed as the P-type MOSFET. In this case, between the fifth sub-transistor T101 and the sixth sub-transistor T102 of the tenth transistor T10, the active layer of the transistor formed as the N-type MOSFET may be formed of an oxide semiconductor, and the active layer of the transistor formed as the P-type MOSFET may be formed of polysilicon.

Alternatively, any one of the seventh sub-transistor T111 and the eighth sub-transistor T112 of the eleventh transistor T11 may be formed as the N-type MOSFET, and the other may be formed as the P-type MOSFET. In this case, between the seventh sub-transistor T111 and the eighth sub-transistor T112 of the eleventh transistor T11, the active layer of the transistor formed as the N-type MOSFET may be formed of an oxide semiconductor, and the active layer of the transistor formed as the P-type MOSFET may be formed of polysilicon.

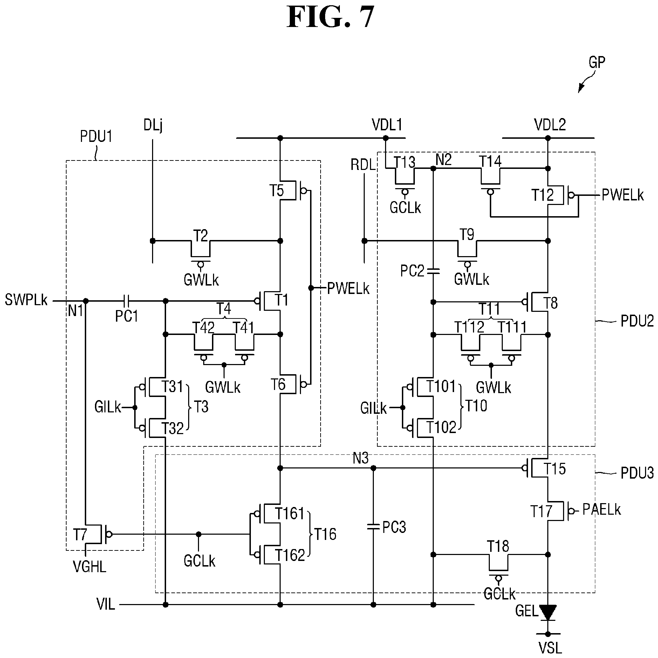

FIG. 7 is an equivalent circuit diagram illustrating a second sub-pixel according to one embodiment.

The embodiment of FIG. 7 is different from the embodiment of FIG. 6 in that the second sub-pixel GP includes one light emitting element GEL and does not include the nineteenth transistor T19 and the twentieth transistor T20. In FIG. 7, redundant description of parts already described in the embodiment of FIG. 6 will be omitted.

Referring to FIG. 7, the second light emitting element GEL emits the second light by the driving current Ids generated by the second pixel driver PDU2. The second light emitting element GEL may be disposed between the seventeenth transistor T17 and the third power line VSL. The first electrode of the second light emitting element GEL may be connected to the second electrode of the seventeenth transistor T17, and the second electrode thereof may be connected to the third power line VSL.

The first electrode of the second light emitting element GEL may be an anode electrode and the second electrode thereof may be a cathode electrode. The second light emitting element GEL may be an inorganic light emitting element including a first electrode, a second electrode, and an inorganic semiconductor disposed between the first electrode and the second electrode. For example, the second light emitting element GEL may be a micro light emitting diode formed of an inorganic semiconductor, but is not limited thereto.

The seventeenth transistor T17 is turned on by the $k^{th}$ PAM emission signal of the $k^{th}$ PAM emission line PAELk to connect the second electrode of the fifteenth transistor T15 to the first electrode of the second light emitting element GEL. The gate electrode of the seventeenth transistor T17 may be connected to the $k^{th}$ PAM emission line PAELk, the first electrode thereof may be connected to the second electrode of the fifteenth transistor T15, and the second electrode thereof may be connected to the first electrode of the second light emitting element GEL.

The eighteenth transistor T18 is turned on by the $k^{th}$ scan control signal of the $k^{th}$ scan control line GCLk to connect the initialization voltage line VIL to the first electrode of the second light emitting element GEL. Accordingly, during the turn-on period of the eighteenth transistor T18, the first electrode of the second light emitting element GEL may be discharged to the initialization voltage VINT of the initialization voltage line VIL. The gate electrode of the eighteenth transistor T18 may be connected to the $k^{th}$ scan control line GCLk, the first electrode thereof may be connected to the first electrode of the second light emitting element GEL, and the second electrode thereof may be connected to the initialization voltage line VIL.

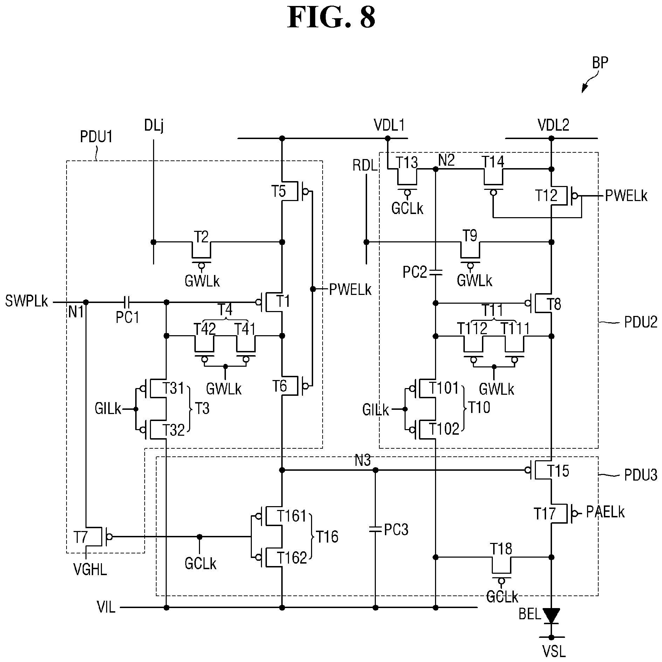

FIG. 8 is an equivalent circuit diagram illustrating a third sub-pixel according to one embodiment.

The embodiment of FIG. 8 is different from the embodiment of FIG. 6 in that the third sub-pixel BP includes one third light emitting element BEL and does not include the nineteenth transistor T19 and the twentieth transistor T20. In FIG. 8, redundant description of parts already described in the embodiment of FIG. 6 will be omitted.

Referring to FIG. 8, the third light emitting element BEL emits the third light by the driving current Ids generated by the second pixel driver PDU2. The third light emitting element BEL may be disposed between the seventeenth transistor T17 and the third power line VSL. The first electrode of the third light emitting element BEL may be connected to the second electrode of the seventeenth transistor T17, and the second electrode thereof may be connected to the third power line VSL.

The first electrode of the third light emitting element BEL may be an anode electrode and the second electrode thereof may be a cathode electrode. The third light emitting element BEL may be an inorganic light emitting element including a first electrode, a second electrode, and an inorganic semiconductor disposed between the first electrode and the second electrode. For example, the third light emitting element BEL may be a micro light emitting diode formed of an inorganic semiconductor, but is not limited thereto.

Since the seventeenth transistor T17 and the eighteenth transistor T18 are substantially the same as those described in conjunction with FIG. 7 except that they are connected to the third light emitting element BEL instead of the second light emitting element GEL, description thereof will be omitted.

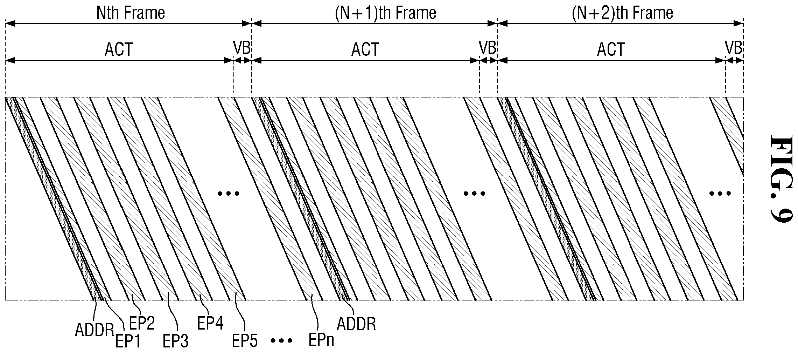

FIG. 9 shows one example of the operation of a display device during $N^{th}$ to $(N+2)^{th}$ frame periods.

Referring to FIG. 9, each of the $N^{th}$ to $(N+2)^{th}$ frame periods may include an active period ACT and a blank period VB. The active period ACT may include a data address period ADDR in which a PWM data voltage and first/second/third PAM data voltages are supplied to each of the first to third sub-pixels RP, GP, and BP, and a plurality of emission periods EP1, EP2, EP3, EP4, EP5, ..., EPn in which the light emitting element EL of each of the sub-pixels SP emits light. The blank period VB may be the period in which the sub-pixels RP, GP, and BP of the display panel 100 are idle.

The address period ADDR and the first emission period EP1 may be shorter than each of the second to $n^{th}$ emission periods EP2, EP3, EP4, EP5, ..., EPn. For example, the address period ADDR and a first emission period EP1 may be about 5 horizontal periods, and each of second to $n^{th}$ emission periods EP2, EP3, EP4, EP5, ..., EPn may be about 12 horizontal periods, but the embodiment of the present specification is not limited thereto. Further, the active period ACT may include 25 emission periods, but the number of emission periods EP1, EP2, EP3, EP4, EP5, ..., EPn of the active period ACT is not limited thereto.

The PWM data voltage and the first/second/third PWM data voltages may be sequentially inputted to the sub-pixels RP, GP, and BP of the display panel 100 for each row line during the address period ADDR. For example, the PWM data voltage and the first/second/third PAM data voltages may be sequentially inputted to the sub-pixels RP, GP, and BP in the order from the sub-pixels RP, GP, and BP disposed on a first row line to the sub-pixels RP, GP, and BP disposed on an $n^{th}$ row line that is the last row line.

The sub-pixels RP, GP, and BP of the display panel 100 may sequentially emit light for each row line in each of the plurality of emission periods EP1, EP2, EP3, EP4, EP5, ..., EPn. For example, the sub-pixels RP, GP, and BP may sequentially emit light in the order from the sub-pixels RP, GP, and BP disposed on the first row line to the sub-pixels RP, GP, and BP disposed on the last row line.

The address period ADDR may overlap at least one of the emission periods EP1, EP2, EP3, EP4, ..., EPn. For example, as shown in FIG. 9, the address period ADDR may overlap the first to third emission periods EP1, EP2, and EP3.

In this case, when the sub-pixels RP, GP, and BP disposed on a $p^{th}$ (p being a positive integer) row line receive the PWM data voltage and the first/second/third PAM data voltages, the sub-pixels RP, GP, and BP disposed on a $q^{th}$ (q being a positive integer smaller than p) row line may emit light.

Further, each of the emission periods EP1, EP2, EP3, EP4, ..., EPn may overlap emission periods adjacent thereto. For example, the second emission period EP2 may overlap the first emission period EP1 and the third emission period EP3. In this case, the sub-pixels RP, GP, and BP disposed on the $p^{th}$ row line may emit light in the second emission period EP2, whereas the sub-pixels RP, GP, and BP disposed on the $q^{th}$ row line may emit light in the first emission period EP1.

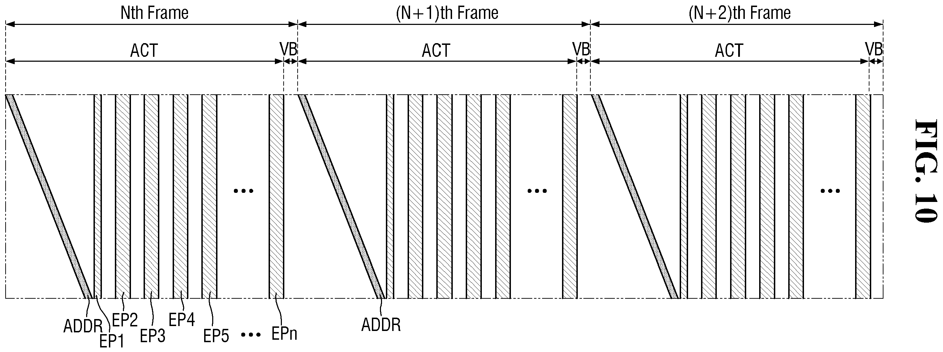

FIG. 10 shows another example of the operation of the display device during the $N^{th}$ to $(N+2)^{th}$ frame periods.

The embodiment of FIG. 10 is different from the embodiment of FIG. 9 only in that the sub-pixels RP, GP, and BP of the display panel 100 simultaneously emit light in each of the plurality of emission periods EP1, EP2, EP3, EP4, EP5, ..., EPn.

Referring to FIG. 10, the address period ADDR may not overlap the plurality of emission periods EP1, EP2, EP3, EP4, ..., EPn. The first emission period EP1 may occur after the address period ADDR is completely ended.

The plurality of emission periods EP1, EP2, EP3, EP4, ..., EPn may not overlap each other. In each of the plurality of emission periods EP1, EP2, EP3, EP4, EP5, ..., EPn, the sub-pixels RP, GP, and BP disposed in all row lines may simultaneously emit light.

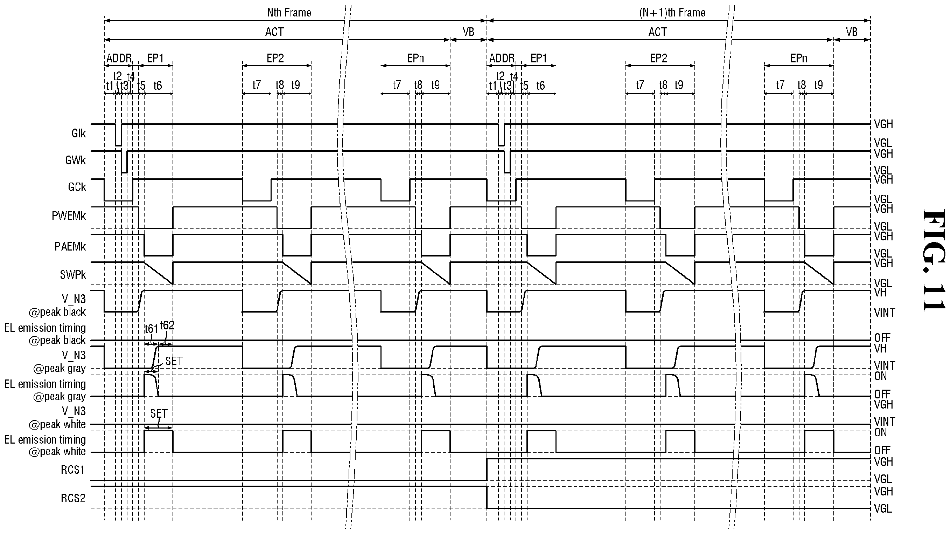

FIG. 11 is a waveform diagram showing the $k^{th}$ scan initialization signal, the $k^{th}$ scan write signal, the $k^{th}$ scan control signal, the $k^{th}$ PWM emission signal, the $k^{th}$ PAM emission signal, and the $k^{th}$ sweep signal applied to the first sub-pixel disposed in the $k^{th}$ row line, the voltage of the third node, the emission timing of the light emitting element, the first emission control signal, and the second emission control signal in an $N^{th}$ period and an $(N+1)^{th}$ period according to one embodiment.

Referring to FIG. 11, the first sub-pixel RP disposed in the $k^{th}$ row line may be connected to the $k^{th}$ scan initialization line GILk, the $k^{th}$ scan write line GWLk, the $k^{th}$ scan control line GCLk, the $k^{th}$ PWM emission line PWELk, the $k^{th}$ PAM emission line PAELk, the $k^{th}$ sweep signal line SWPLk, the first emission control line RCL1, and the second emission control line RCL2. The $k^{th}$ scan initialization signal GIk indicates the signal applied to the $k^{th}$ scan initialization line GILk, and the $k^{th}$ scan write signal GWk indicates the signal applied to the $k^{th}$ scan write line GWLk. A $k^{th}$ scan control signal GCk indicates the signal applied to the $k^{th}$ scan control line GCLk, and the $k^{th}$ PWM emission signal PWEMk indicates the signal applied to the $k^{th}$ PWM emission line PWELk. The $k^{th}$ PAM emission signal PAEMk indicates the signal applied to the $k^{th}$ PAM emission line PAELk, and the $k^{th}$ sweep signal SWPk indicates the signal applied to the $k^{th}$ sweep signal line SWPLk. The first emission control signal RCS1 indicates the signal applied to the first emission control line RCL1, and the second emission control signal RCS2 indicates the signal applied to the second emission control line RCL2.

Scan initialization signals GIk to GIk+5, scan write signals GWk to GWk+5, scan control signals GCk to GCk+5, PWM emission signals PWEMk to PAEMk+5, PAM emission signals PAEMk to PAEMk+5, and sweep signals SWPk to SWPk+5 may be sequentially shifted by one horizontal period. The $k^{th}$ scan write signal GWk may be the signal obtained by shifting the $k^{th}$ scan initialization signal GIk by one horizontal period, and a $(k+1)^{th}$ scan write signal GWk+1 may be the signal obtained by shifting a $(k+1)^{th}$ scan initialization signal GIk+1 by one horizontal period. In this case, since the $(k+1)^{th}$ scan initialization signal GIk+1 is the signal obtained by shifting the $k^{th}$ scan initialization signal GIk by one horizontal period, the $k^{th}$ scan write signal GWk and the $(k+1)^{th}$ scan initialization signal GIk+1 may be substantially the same.

The $k^{th}$ scan initialization signal GIk is the signal for controlling turn-on and turn-off of the third transistor T3 and the tenth transistor T10 of each of the sub-pixels RP, GP, and BP. The $k^{th}$ scan write signal GWk is the signal for controlling turn-on and turn-off of the second, fourth, ninth, and eleventh transistors T2, T4, T9, and T11 of each of the sub-pixels RP, GP, and BP. The $k^{th}$ scan control signal GCk is the signal for controlling turn-on and turn-off of the seventh, thirteenth, sixteenth, and eighteenth transistors T7, T13, T16, and T18 of each of the sub-pixels RP, GP, and BP. The $k^{th}$ PWM emission signal PWEMk is the signal for controlling turn-on and turn-off of the fifth, sixth, twelfth, and fourteenth transistors T5, T6, T12, and T14. The $k^{th}$ PAM emission signal PAEMk is the signal for controlling turn-on and turn-off of the seventeenth transistor T17. The first emission control signal RCS1 is the signal for controlling turn-on and turn-off of the nineteenth transistor T19. The second emission control signal RCS2 is the signal for controlling turn-on and turn-off of the twentieth transistor T20. The $k^{th}$ scan initialization signal, the $k^{th}$ scan write signal, the $k^{th}$ scan control signal, the $k^{th}$ PWM emission signal, the $k^{th}$ PAM emission signal, and the $k^{th}$ sweep signal may be generated at a cycle of one frame period.

The address period ADDR includes first to fourth periods t1 to t4. The first period t1 and the fourth period t4 are a first initialization period for initializing the first electrode of the light emitting element EL and the voltage V_N3 of the third node N3. The second period t2 is a second initialization period for initializing the gate electrode of the first transistor T1 and the gate electrode of the eighth transistor T8. The third period t3 is the period for sampling a PWM data voltage Vdata of the $j^{th}$ PWM data line DLj and the threshold voltage Vth1 of the first transistor T1 at the gate electrode of the first transistor T1 and sampling a first PAM data voltage Rdata of the first PAM data line RDL and a threshold voltage Vth8 of the eighth transistor T8 at the gate electrode of the eighth transistor T8.

The first emission period EM1 includes a fifth period t5 and a sixth period t6. The first emission period EM1 is the period for controlling the turn-on period of the fifteenth transistor T15 depending on the control current Ic and supplying the driving current Ids to the light emitting element EL.

Each of the second to $n^{th}$ emission periods EM2 to EMn includes seventh to ninth periods t7 to t9. The seventh period t7 is a third initialization period for initializing the third node N3, the eighth period t8 is substantially the same as the fifth period t5, and the ninth period t9 is substantially the same as the sixth period t6.

Among the first to $n^{th}$ emission periods EM1 to EMn, emission periods adjacent to each other may be spaced apart from each other by about several to several tens of horizontal periods.

The $k^{th}$ scan initialization signal GIk may have the gate-on voltage VGL during the second period t2, and may have the gate-off voltage VGH during the remaining periods. That is, the $k^{th}$ scan initialization signal GIk may have a scan initialization pulse generated by the gate-on voltage VGL during the second period t2. The gate-off voltage VGH may be the voltage having a level higher than that of the gate-on voltage VGL.

The $k^{th}$ scan write signal GWk may have the gate-on voltage VGL during the third period t3, and may have the gate-off voltage VGH during the remaining periods. That is, the $k^{th}$ scan write signal GWk may have a scan write pulse generated by the gate-on voltage VGL during the third period t3.

The $k^{th}$ scan control signal GCk may have the gate-on voltage VGL during the first to fourth periods t1 to t4 and the seventh period t7, and may have the gate-off voltage VGH during the remaining periods. That is, the $k^{th}$ scan control signal GCk may have a scan control pulse generated by the gate-on voltage VGL during the first to fourth periods t1 to t4 and the seventh period t7.

The $k^{th}$ sweep signal SWPk may have a triangular wave sweep pulse during the sixth period t6 and the ninth period t9, and may have the gate-off voltage VGH during the remaining periods. For example, the sweep pulse of the $k^{th}$ sweep signal SWPk may have a triangular wave pulse that linearly decreases from the gate-off voltage VGH to the gate-on voltage VGL in each of the sixth period t6 and the ninth period t9 and immediately increases from the gate-on voltage VGL to the gate-off voltage VGH at the end of the sixth period t6 and at the end of the ninth period t9.

The $k^{th}$ PWM emission signal PWEMk may have the gate-on voltage VGL during the fifth and sixth periods t5 and t6 and the eighth and ninth periods t8 and t9, and may have the gate-off voltage VGH during the remaining periods. That is, the $k^{th}$ PWM emission signal PWEMk may include PWM pulses generated by the gate-on voltage VGL during the fifth and sixth periods t5 and t6 and the eighth and ninth periods t8 and t9. The PWM pulse width of the $k^{th}$ PWM emission signal PWEMk may be greater than the sweep pulse width of the $k^{th}$ sweep signal SWPk.

The $k^{th}$ PAM emission signal PAEMk may have the gate-on voltage VGL during the sixth period t6 and the ninth period t9, and may have the gate-off voltage VGH during the remaining periods. That is, the $k^{th}$ PAM emission signal PAEMk may include PAM pulses generated by the gate-on voltage VGL during the sixth period t6 and the ninth period t9.

The first emission control signal RCS1 may have the gate-on voltage VGL during the $N^{th}$ frame period, and may have the gate-off voltage VGH during the $(N+1)^{th}$ frame period. The second emission control signal RCS2 may have the gate-off voltage VGH during the $N^{th}$ frame period, and may have the gate-on voltage VGL during the $(N+1)^{th}$ frame period. That is, the first emission control signal RCS1 and the second emission control signal RCS2 may have different voltages in one frame period.

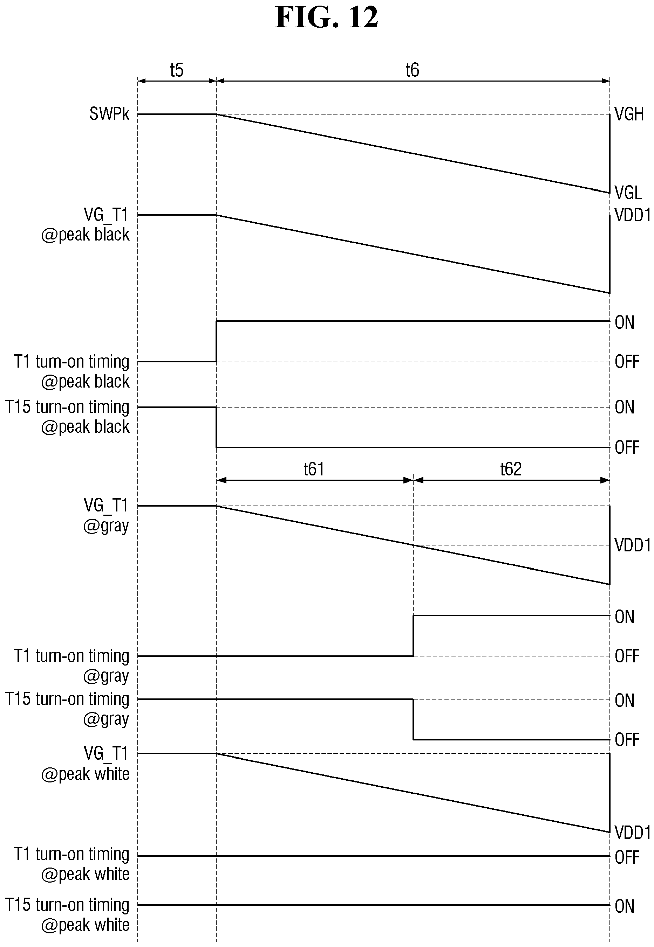

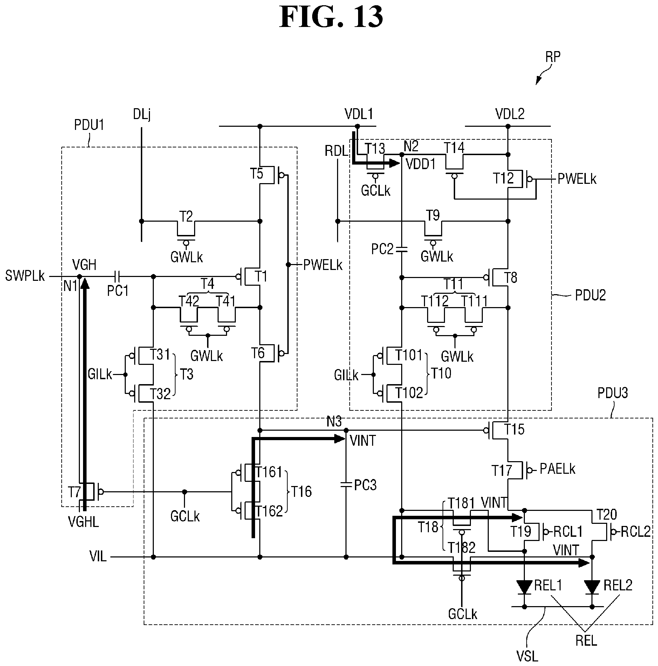

FIG. 12 is a timing diagram showing the $k^{th}$ sweep signal, the voltage of the gate electrode of the first transistor, the turn-on timing of the first transistor, and the turn-on timing of the fifteenth transistor during the fifth period and the sixth period according to one embodiment. FIGS. 13 to 16 are circuit diagrams showing operations of the first sub-pixel during the first period, the second period, the third period, the fifth period, and the sixth period of the $N^{th}$ frame period of FIG. 11.

Hereinafter, the operation of the first sub-pixel RP according to one embodiment during the first to ninth periods t1 to t9 of the $N^{th}$ frame period will be described in detail with reference to FIGS. 11 to 16.

During the $N^{th}$ frame period, the nineteenth transistor T19 is turned on by the first emission control signal RCS1 of the gate-on voltage VGL, and the twentieth transistor T20 is turned off by the second emission control signal RCS2 of the gate-off voltage VGH.

First, during the first period t1, as shown in FIG. 13, the seventh transistor T7, the thirteenth transistor T13, the sixteenth transistor T16, and the eleventh sub-transistor T181 and the twelfth sub-transistor T182 of the eighteenth transistor T18 are turned on by the $k^{th}$ scan control signal GCk of the gate-on voltage VGL.

Due to the turn-on of the seventh transistor T7, the gate-off voltage VGH of the gate-off voltage line VGHL is applied to the first node N1. Due to the turn-on of the thirteenth transistor T13, the first power voltage VDD1 of the first power line VDL1 is applied to the second node N2.

Due to the turn-on of the sixteenth transistor T16, the third node N3 is initialized to the initialization voltage VINT of the initialization voltage line VIL, and the fifteenth transistor T15 is turned on by the initialization voltage VINT of the third node N3.

Due to the turn-on of the first sub-transistor T181 and the second sub-transistor T182 of the eighteenth transistor T18, the first electrode of the first sub-light emitting element REL1 and the first electrode of the second sub-light emitting element REL2 are initialized to the initialization voltage VINT of the initialization voltage line VIL.

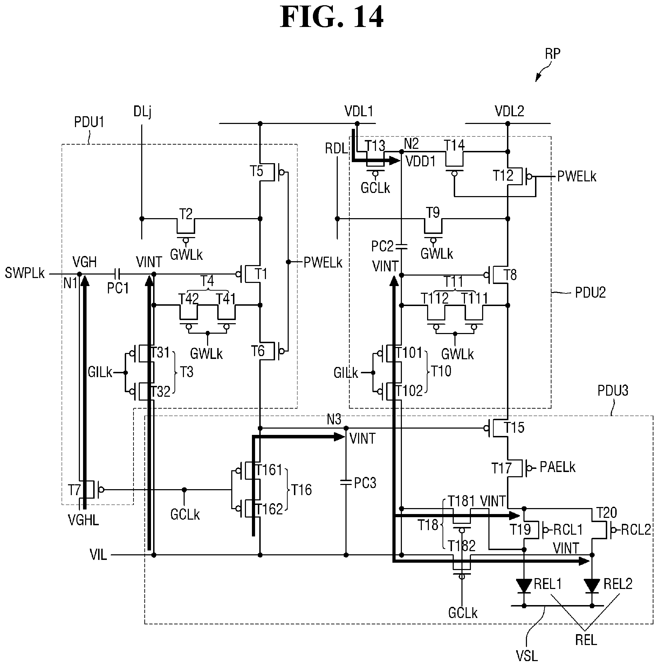

Second, during the second period t2, as shown in FIG. 14, the seventh transistor T7, the thirteenth transistor T13, the sixteenth transistor T16, and the first sub-transistor T181 and the second sub-transistor T182 of the eighteenth transistor T18 are turned on by the $k^{th}$ scan control signal GCk of the gate-on voltage VGL. Further, during the second period t2, the third transistor T3 and the tenth transistor T10 are turned on by the $k^{th}$ scan initialization signal GIk of the gate-on voltage VGL.

The seventh transistor T7, the thirteenth transistor T13, the fifteenth transistor T15, the sixteenth transistor T16, and the first sub-transistor T181 and the second sub-transistor T182 of the eighteenth transistor T18 are substantially the same as those described in the first period t1.

Due to the turn-on of the third transistor T3, the gate electrode of the first transistor T1 is initialized to the initialization voltage VINT of the initialization voltage line VIL. Further, due to the turn-on of the tenth transistor T10, the gate electrode of the eighth transistor T8 is initialized to the initialization voltage VINT of the initialization voltage line VIL.

At this time, since the gate-off voltage VGH of the gate-off voltage line VGHL is applied to the first node N1, it is possible to prevent variation in the gate-off voltage VGH of the $k^{th}$ sweep signal SWPk due to the reflection of voltage variation of the gate electrode of the first transistor T1 in the $k^{th}$ sweep signal line SWPLk by a first capacitor PC1.

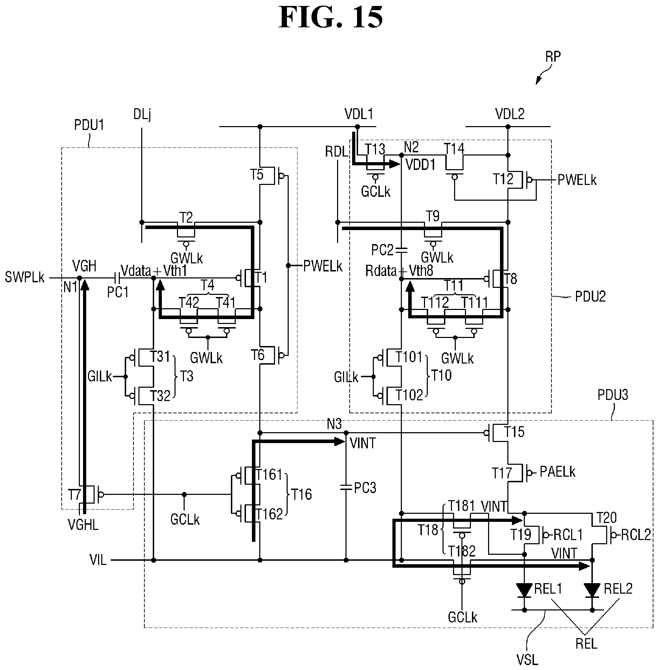

Third, during the third period t3, as shown in FIG. 15, the seventh transistor T7, the thirteenth transistor T13, the sixteenth transistor T16, and the first sub-transistor T181 and the second sub-transistor T182 of the eighteenth transistor T18 are turned on by the $k^{th}$ scan control signal GCk of the gate-on voltage VGL. Further, during the third period t3, the second transistor T2, the fourth transistor T4, the ninth transistor T9, and the eleventh transistor T11 are turned on by the $k^{th}$ scan write signal GWk of the gate-on voltage VGL.

The seventh transistor T7, the thirteenth transistor T13, the fifteenth transistor T15, the sixteenth transistor T16, and the first sub-transistor T181 and the second sub-transistor T182 of the eighteenth transistor T18 are substantially the same as those described in the first period t1.

Due to the turn-on of the second transistor T2, the PWM data voltage Vdata of the $j^{th}$ PWM data line DLj is applied to the first electrode of the first transistor T1. Due to the turn-on of the fourth transistor T4, the gate electrode and the second electrode of the first transistor T1 are connected to each other, so that the first transistor T1 operates as a diode.

In this case, since the voltage (Vgs=VINT-Vdata) between the gate electrode and the first electrode of the first transistor T1 is greater than the threshold voltage Vth1, the first transistor T1 is turned on to form a current path until the voltage Vgs between the gate electrode and the first electrode reaches the threshold voltage Vth1. Accordingly, the voltage of the gate electrode of the first transistor T1 may increase from "VINT" to "Vdata+Vth1." Since the first transistor T1 is formed as the P-type MOSFET, the threshold voltage Vth1 of the first transistor T1 may be less than 0V.

Further, since the gate-off voltage VGH of the gate-off voltage line VGHL is applied to the first node N1, it is possible to prevent variation in the gate-off voltage VGH of the $k^{th}$ sweep signal SWPk due to the reflection of voltage variation of the gate electrode of the first transistor T1 in the $k^{th}$ sweep signal line SWPLk by a first capacitor PC1.

Due to the turn-on of the ninth transistor T9, a first PAM data voltage Rdata of the first PAM data line RDL is applied to the first electrode of the eighth transistor T8. Due to the turn-on of the ninth transistor T9, the gate electrode and the second electrode of the eighth transistor T8 are connected to each other, so that the eighth transistor T8 operates as a diode.

In this case, since the voltage (Vgs=VINT-Rdata) between the gate electrode and the first electrode of the eighth transistor T8 is greater than the threshold voltage Vth8, the eighth transistor T8 forms a current path until the voltage Vgs between the gate electrode and the first electrode reaches the threshold voltage Vth8. Accordingly, the voltage of the gate electrode of the eighth transistor T8 may increase from "VINT" to "Rdata+Vth8."

Fourth, during the fourth period t4, the seventh transistor T7, the thirteenth transistor T13, the sixteenth transistor T16, and the first sub-transistor T181 and the second sub-transistor T182 of the eighteenth transistor T18 are turned on by the $k^{th}$ scan control signal GCk of the gate-on voltage VGL.

The seventh transistor T7, the thirteenth transistor T13, the sixteenth transistor T16, and the first sub-transistor T181 and the second sub-transistor T182 of the eighteenth transistor T18 are substantially the same as those described in the first period 11.

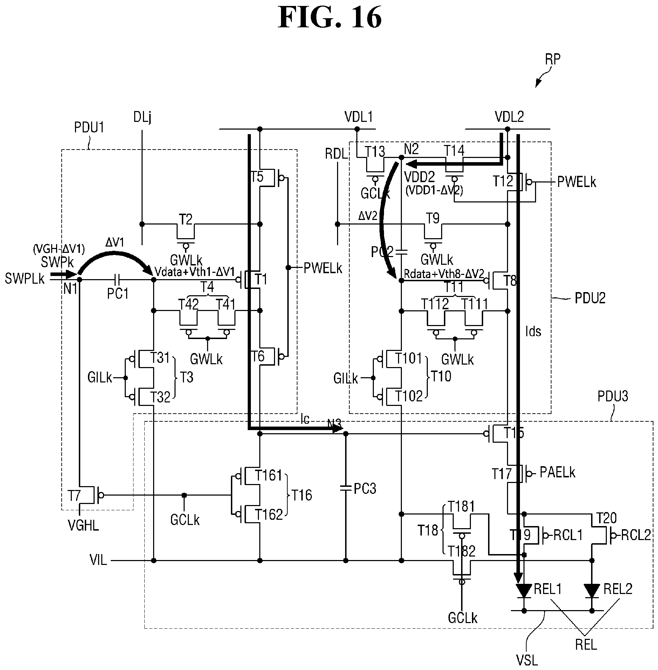

Fifth, during the fifth period t5, as shown in FIG. 16, the fifth transistor T5, the sixth transistor T6, the twelfth transistor T12, and the fourteenth transistor T14 are turned on by the $k^{th}$ PWM emission signal PWEMk of the gate-on voltage VGL.

Due to the turn-on of the fifth transistor T5, the first power voltage VDD1 is applied to the first electrode of the first transistor T1. Further, due to the turn-on of the sixth transistor T6, the second electrode of the first transistor T1 is connected to the third node N3.

During the fifth period t5, the control current Ic flowing in response to the voltage (Vdata + Vth1) of the gate electrode of the first transistor T1 may not depend on the threshold voltage Vth1 of the first transistor T1 as shown in Equation 1.

[Equation 1]

$$Ids = k'' \times (Vgs - Vth1)^2 = k'' \times (Vdata + Vth1 - VDD1 - Vth1)^2 = k'' \times (Vdata - VDD1)^2$$

In Equation 1, k" refers to the proportional coefficient determined by the structure and physical characteristics of the first transistor T1, Vth1 refers to the threshold voltage of the first transistor T1, VDD1 refers to the first power voltage, and Vdata refers to the PWM data voltage. In Equation 1, Vgs refers to the voltage between the gate electrode and the first electrode of the first transistor T1.

Further, due to the turn-on of the twelfth transistor T12, the first electrode of the eighth transistor T8 may be connected to the second power line VDL2.

Further, due to the turn-on of the fourteenth transistor T14, the second power voltage VDD2 of the second power line VDL2 is applied to the second node N2. When the second power voltage VDD2 of the second power line VDL2 varies due to a voltage drop or the like, a voltage difference ΔV2 between the first power voltage VDD1 and the second power voltage VDD2 may be reflected in the gate electrode of the eighth transistor T8 by a second capacitor PC2.

Due to the turn-on of the fourteenth transistor T14, the driving current Ids flowing in response to the voltage (Rdata+Vth8) of the gate electrode of the eighth transistor T8 may be supplied to the fifteenth transistor T15. The driving current Ids may not depend on the threshold voltage Vth8 of the eighth transistor T8 as shown in Equation 2.

[Equation 2]

$$Ids = k' \times (Vgs - Vth8)^2 = k' \times (Rdata + Vth8 - \Delta V2 - VDD2 - Vth8)^2 = k' \times (Rdata - \Delta V2 - VDD2)^2$$

In Equation 2, k' refers to the proportional coefficient determined by the structure and physical characteristics of the eighth transistor T8, Vth8 refers to the threshold voltage of the eighth transistor T8, VDD2 refers to the second power voltage, and Rdata refers to the first PAM data voltage. In Equation 2, Vgs refers to the voltage between the gate electrode and the first electrode of the eighth transistor T8.

Sixth, during the sixth period t6, as shown in FIG. 16, the fifth transistor T5, the sixth transistor T6, the twelfth transistor T12, and the fourteenth transistor T14 are turned on by the $k^{th}$ PWM emission signal PWMk of the gate-on voltage VGL. During the sixth period t6, as shown in FIG. 16, the seventeenth transistor T17 is turned on by the $k^{th}$ PAM emission signal PAEMk of the gate-on voltage VGL. During the sixth period t6, the $k^{th}$ sweep signal SWPk linearly decreases from the gate-off voltage VGH to the gate-on voltage Von.

The fifth transistor T5, the sixth transistor T6, the twelfth transistor T12, and the fourteenth transistor T14 are substantially the same as those described in the fifth period t5.

During the $N^{th}$ frame period, the nineteenth transistor T19 is turned on by the first emission control signal RCS1 of the gate-on voltage VGL. Accordingly, when the seventeenth transistor T17 is turned on, the first electrode of the first sub-light emitting element REL1 may be connected to the second electrode of the fifteenth transistor T15.

During the sixth period t6, the $k^{th}$ sweep signal SWPk linearly decreases from the gate-off voltage VGH to the gate-on voltage Von, and voltage variation ΔV1 of the $k^{th}$ sweep signal SWPk is reflected in the gate electrode of the first transistor T1 by the first capacitor PC1, so that the voltage of the gate electrode of the first transistor T1 may be Vdata+Vth1-ΔV1. That is, as the voltage of the $k^{th}$ sweep signal SWPk decreases during the sixth period t6, the voltage of the gate electrode of the first transistor T1 may linearly decrease.

The period in which the control current Ic is applied to the third node N3 may vary depending on the magnitude of the PWM data voltage Vdata applied to the first transistor T1. Since the voltage V_N3 of the third node N3 varies depending on the magnitude of the PWM data voltage Vdata applied to the first transistor T1, the turn-on period of the fifteenth transistor T15 may be controlled. Therefore, it is possible to control the period SEP in which the driving current Ids is applied to the first sub-light emitting element REL1 during the sixth period t6 by controlling the turn-on period of the fifteenth transistor T15.

First, as shown in FIG. 12, when the PWM data voltage Vdata of the gate electrode of the first transistor T1 is the PWM data voltage of a peak black gray level, a voltage VG_T1 of the gate electrode of the first transistor T1 may be lower than the first power voltage VDD1 that is the voltage of the first electrode of the first transistor T1 throughout the sixth period t6 due to a decrease in the voltage of the $k^{th}$ sweep signal SWPk. Therefore, the first transistor T1 may be turned on throughout the sixth period t6. Accordingly, the control current Ic of the first transistor T1 may flow to the third node N3 throughout the fifth period t5 and the sixth period t6, and the voltage V_N3 of the third node N3 may increase to a high level VH during the fifth period t5. Therefore, the fifteenth transistor T15 may be turned off during the sixth period t6. Since the driving current Ids is not applied to the first sub-light emitting element REL1 during the sixth period t6, the first sub-light emitting element REL1 may not emit light during the sixth period t6.

Further, as shown in FIG. 12, when the PWM data voltage Vdata of the gate electrode of the first transistor T1 is the PWM data voltage of a gray level, the voltage VG_T1 of the gate electrode of the first transistor T1 may have a level higher than the first power voltage VDD1 during the first sub-period t61, and may have a level lower than the first power voltage VDD1 during the second sub-period t62 due to a decrease in the voltage of the $k^{th}$ sweep signal SWPk. Therefore, the first transistor T1 may be turned on during the second sub-period t62 of the sixth period t6. In this case, since the control current Ic of the first transistor T1 flows to the third node N3 during the second sub-period t62, the voltage V_N3 of the third node N3 may have the high level VH during the second sub-period t62. Therefore, the fifteenth transistor T15 may be turned off during the second sub-period t62. Hence, the driving current Ids is applied to the first sub-light emitting element REL1 during the first sub-period t61 and is not applied to the first sub-light emitting element REL1 during the second sub-period t62. That is, the first sub-light emitting element REL1 may emit light during the first sub-period t61 that is a part of the sixth period t6. As the first sub-pixel RP expresses a gray level close to the peak black gray level, an emission period SET of the first sub-light emitting element REL1 may decrease. Further, as the first sub-pixel RP expresses a gray level close to a peak white gray level, the emission period SET of the first sub-light emitting element REL1 may increase.

Further, as shown in FIG. 12, when the PWM data voltage Vdata of the gate electrode of the first transistor T1 is the PWM data voltage of the peak white gray level, the voltage VG_T1 of the gate electrode of the first transistor T1 may be higher than the first power voltage VDD1 during the sixth period t6 despite the decrease in the voltage of the $k^{th}$ sweep signal SWPk. Therefore, the first transistor T1 may be turned off during the sixth period t6. In this case, the control current Ic of the first transistor T1 does not flow to the third node N3 throughout the sixth period t6, so that the voltage of the third node N3 may be maintained at the initialization voltage VINT. Therefore, the fifteenth transistor T15 may be turned on throughout the sixth period t6. Therefore, the driving current Ids may be applied to the first sub-light emitting element REL1 throughout the sixth period t6, and the first sub-light emitting element REL1 may emit light throughout the sixth period t6.

Further, as the $k^{th}$ sweep signal SWPk rises from the gate-on voltage VGL to the gate-off voltage VGH at the end of the sixth period t6, the voltage VG_T1 of the gate electrode of the first transistor T1 may increase to a level that is substantially the same as that in the fifth period t5 at the end of the sixth period t6.

Meanwhile, when the digital video data converted to the PWM data voltages is 8 bits, the digital video data of the peak black gray level may be 0, and the digital video data of the peak white gray level may be 255. Further, the digital video data of a black gray level region may be 0 to 63, the digital video data of a gray level region may be 64 to 191, and the digital video data of a white gray level region may be 192 to 255.

Further, the seventh period t7, the eighth period t8, and the ninth period t9 of each of the second to $n^{th}$ emission periods EP2 to EPn are substantially the same as the first period t1, the fifth period t5, and the sixth period t6 that are described above, respectively. That is, in each of the second to $n^{th}$ emission periods EP2 to EPn, after the third node N3 is initialized, the period in which the driving current Ids generated in response to the first PAM data voltage Rdata written in the gate electrode of the eighth transistor T8 is applied to the first sub-light emitting element REL1 may be adjusted based on the PWM data voltage Vdata written in the gate electrode of the first transistor T1 during the address period ADDR.

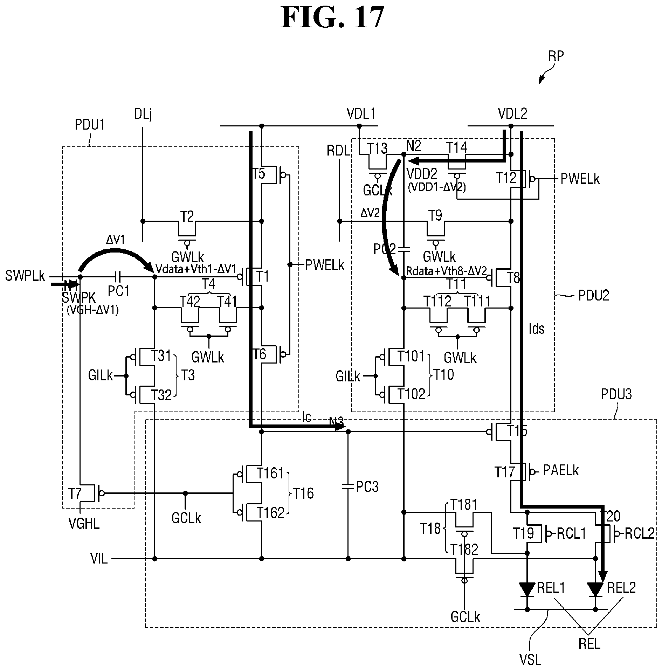

FIG. 17 is an equivalent circuit diagram showing the operation of the first sub-pixel during the sixth period of the $(N+1)^{th}$ frame period of FIG. 11.

Referring to FIG. 17, during the $(N+1)^{th}$ frame period, the nineteenth transistor T19 is turned off by the first emission control signal RCS1 of the gate-off voltage VGH, and the twentieth transistor T20 is turned on by the second emission control signal RCS2 of the gate-on voltage VGL. Therefore, when the seventeenth transistor T17 is turned on, the first electrode of the second sub-light emitting element REL2 may be connected to the second electrode of the fifteenth transistor T15. Accordingly, during the sixth period t6, the driving current Ids may be applied to the second sub-light emitting element REL2, and the second sub-light emitting element REL2 may emit light.

That is, the operation of the first sub-pixel RP during the sixth period t6 of the $(N+1)^{th}$ frame period is substantially the same as the operation of the first sub-pixel RP during the sixth period t6 of the $N^{th}$ frame period described in conjunction with FIG. 16 except that the second sub-light emitting element REL2 emits light instead of the first sub-light emitting element REL1, so that description thereof will be omitted.

As described above, the emission period SET of the first sub-light emitting element REL1 and the emission period of the second sub-light emitting element REL2 may be adjusted by adjusting the PWM data voltage applied to the gate electrode of the first transistor T1. Therefore, the gray level to be expressed by the first sub-pixel RP may be adjusted by adjusting the period in which the driving current Ids is applied to the first sub-light emitting element REL1 or the second sub-light emitting element REL2 while maintaining the driving current Ids at a constant level rather than by adjusting the magnitude of the driving current Ids.

Further, in the first sub-pixel RP, the first sub-light emitting element REL1 emits light during the $N^{th}$ frame period, and the second sub-light emitting element REL2 emits light during the $(N+1)^{th}$ frame period. That is, the first sub-light emitting element REL1 and the second sub-light emitting element REL2 of the first sub-pixel RP emit light during different periods. Therefore, the emission period SET of the first sub-light emitting element REL1 and the emission period of the second sub-light emitting element REL2 may be reduced by half compared to the emission period of the second light emitting element GEL and the emission period of the third light emitting element BEL, respectively. Accordingly, the amount of heat generated by the first sub-light emitting element REL1 and the amount of heat generated by the second sub-light emitting element REL2 may be reduced, which makes it possible to lower the temperature of the first sub-light emitting element REL1 and the temperature of the second sub-light emitting element REL2. Therefore, it is possible to suppress or prevent a decrease in the emission luminance of the first sub-light emitting element REL1 and the emission luminance of the second sub-light emitting element REL2 due to the heat generated by the first sub-light emitting element REL1 and the heat generated by the second sub-light emitting element REL2.

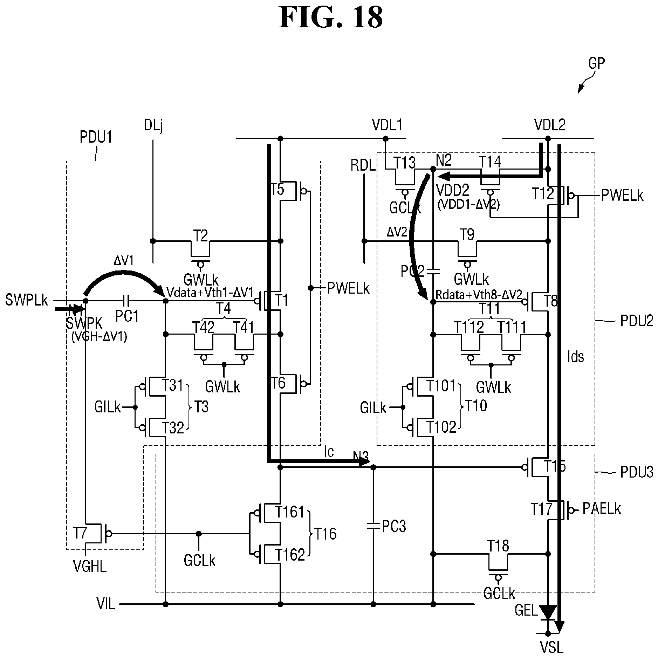

FIG. 18 is a circuit diagram showing the operation of the second sub-pixel during the sixth period of the $N^{th}$ frame period and the $(N+1)^{th}$ frame period of FIG. 11.

Referring to FIG. 18, the second sub-pixel GP may include one second light emitting element GEL, and when the seventeenth transistor T17 is turned on, the first electrode of the second light emitting element GEL may be connected to the second electrode of the fifteenth transistor T15. Accordingly, the driving current Ids may be applied to the second light emitting element GEL during the sixth period t6, and the second light emitting element GEL may emit light.

That is, the operation of the second sub-pixel GP during the sixth period t6 is substantially the same as the operation of the first sub-pixel RP during the sixth period t6 of the $N^{th}$ frame period described in conjunction with in FIG. 16 except that the second light emitting element GEL emits light regardless of the $N^{th}$ frame period and the $(N+1)^{th}$ frame period, so that description thereof will be omitted.

Further, the operation of the second sub-pixel GP during the first to fifth periods t1 to t5 is substantially the same as the operation of the first sub-pixel RP during the first to fifth periods t1 to t5 described in conjunction with FIGS. 11 to 16, so that description thereof will be omitted.

Meanwhile, the operation of the third sub-pixel BP is substantially the same as that of the second sub-pixel GP, so that description of the operation of the third sub-pixel BP during the first to sixth periods t1 to t6 of the $N^{th}$ frame period and the $(N+1)^{th}$ frame period will be omitted.

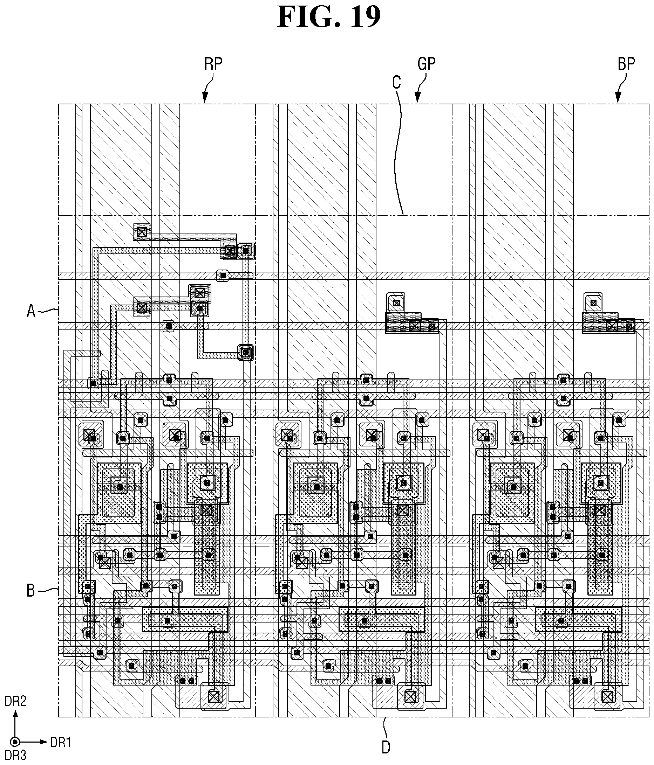

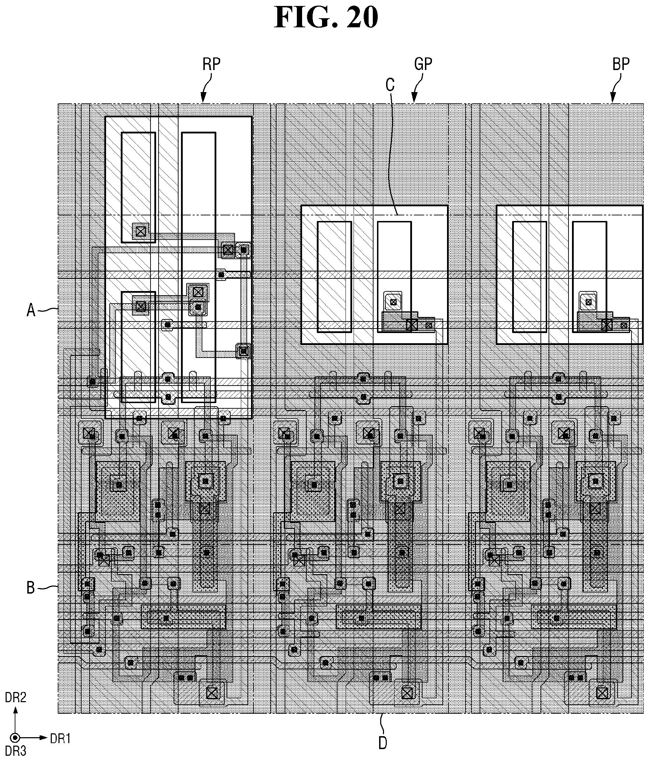

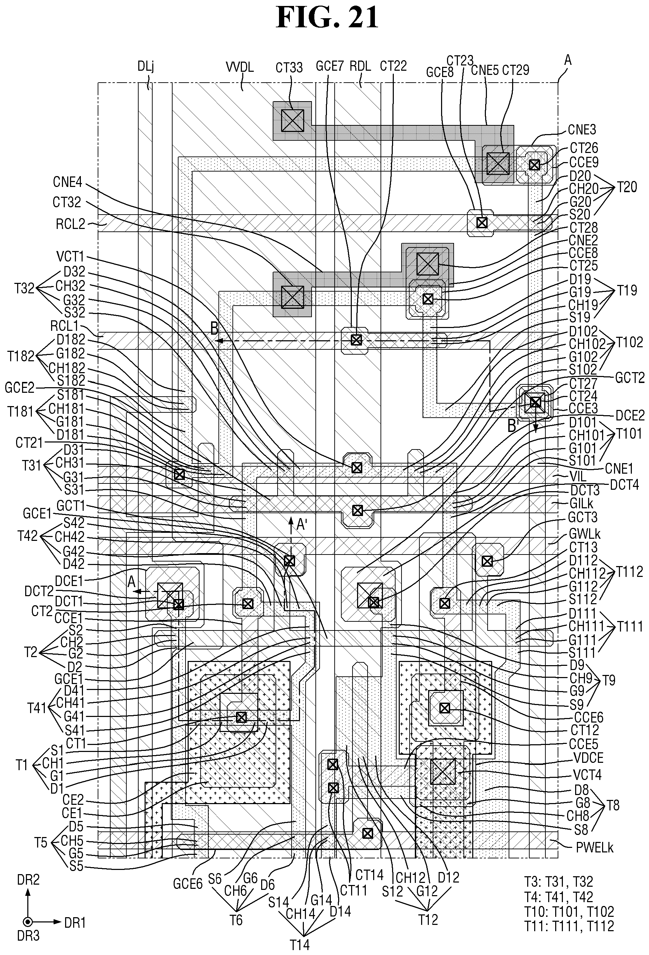

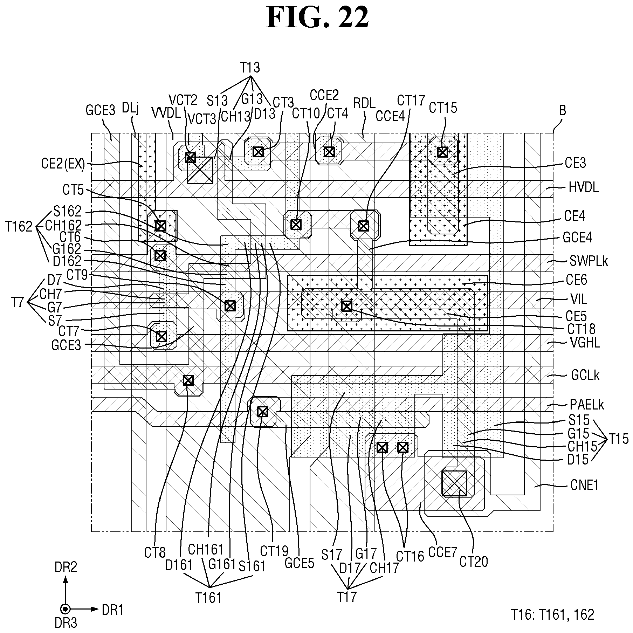

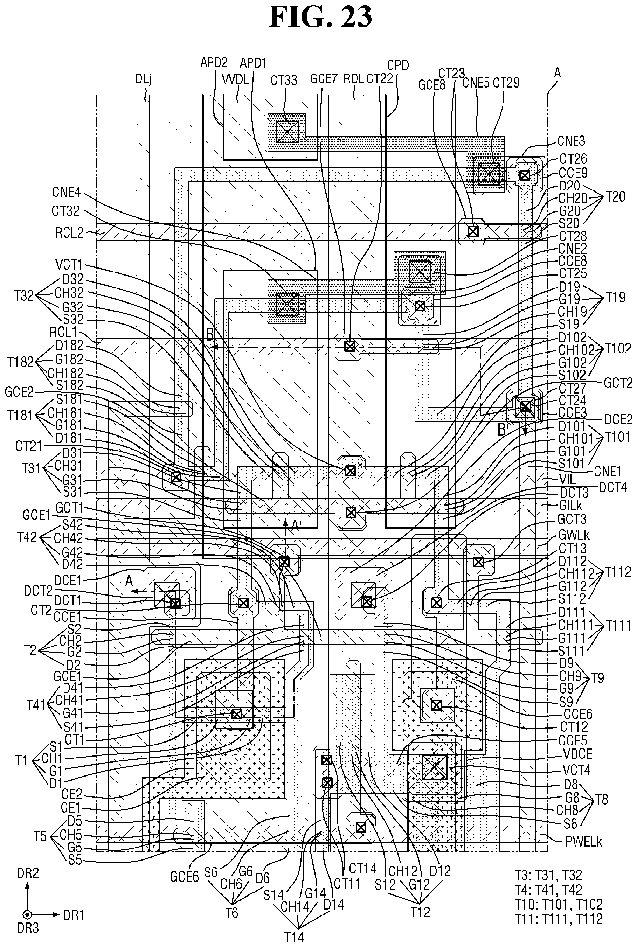

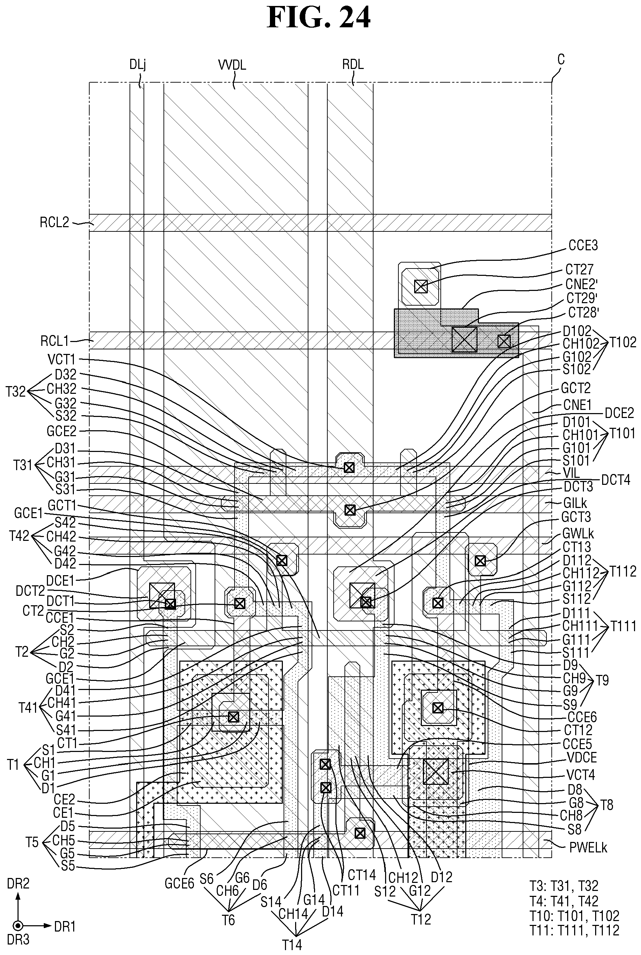

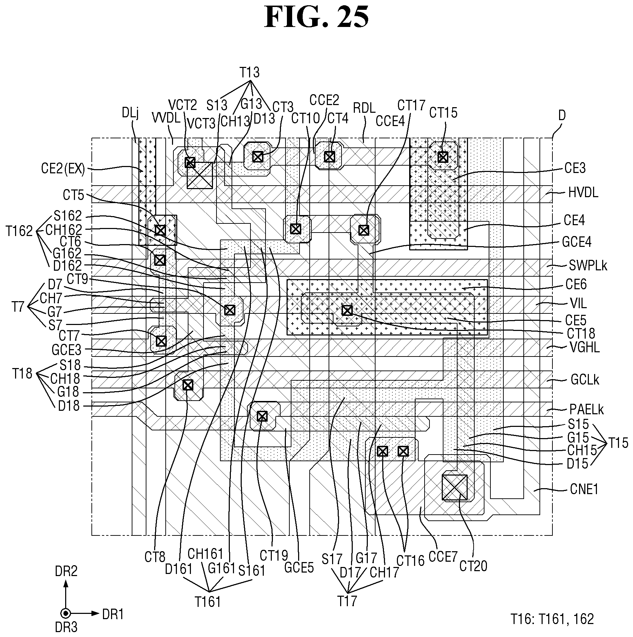

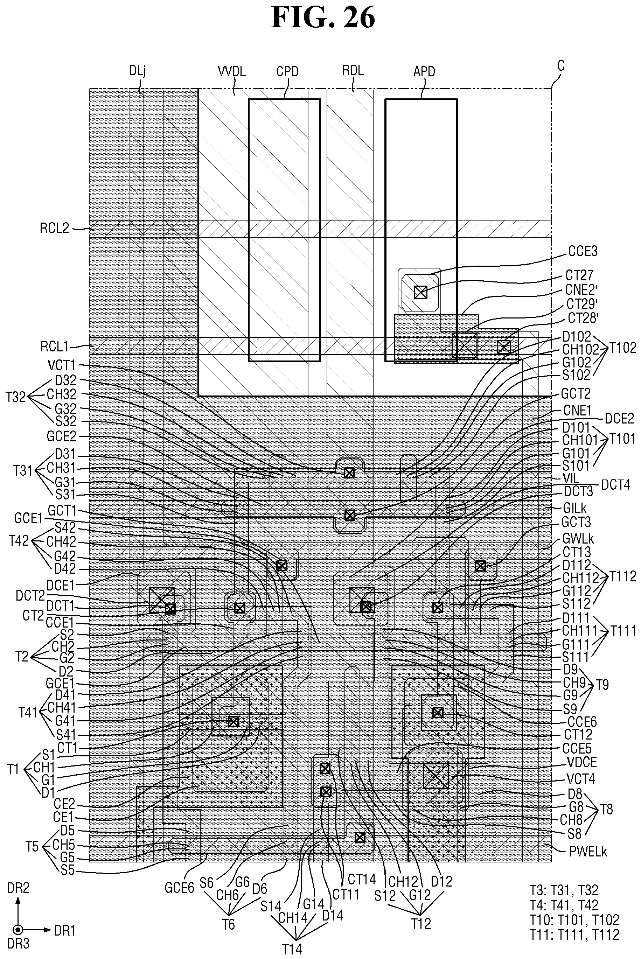

FIGS. 19 and 20 are layout diagrams showing pixels according to one embodiment. FIG. 21 is an enlarged layout view illustrating area A of FIG. 19 in detail. FIG. 22 is an enlarged layout view illustrating area B of FIG. 19 in detail. FIG. 23 is an enlarged layout view illustrating area A of FIG. 20 in detail. FIG. 24 is an enlarged layout view illustrating area C of FIG. 19 in detail. FIG. 25 is an enlarged layout view illustrating area D of FIG. 19 in detail. FIG. 26 is an enlarged layout view illustrating area C of FIG. 20 in detail.

FIGS. 19, 21, 22, 24, and 25 show the layout of a lower metal layer, an active layer, a first gate metal layer, a second gate metal layer, a first source metal layer, and a second source metal layer of a pixel according to one embodiment. FIG. 20 shows the layout of a third source metal layer and a fourth source metal layer in addition to the layout of FIG. 19, and FIG. 23 shows the layout of the third source metal layer and the fourth source metal layer in addition to the layout of FIG. 21. FIG. 26 shows the layout of the third source metal layer and the fourth source metal layer in addition to the layout of FIG. 25.

Referring to FIGS. 19 to 26, the initialization voltage lines VIL, the $k^{th}$ scan initialization line GILk, the $k^{th}$ scan write line GWLk, the $k^{th}$ PWM emission line PWELk, a first horizontal power line HVDL, the gate-off voltage line VGHL, the $k^{th}$ sweep signal line SWPLk, the $k^{th}$ scan control line GCLk, the $k^{th}$ PAM emission line PAELk, the first emission control line RCL1, and the second emission control line RCL2 may extend in the first direction DR1. The initialization voltage lines VIL, the $k^{th}$ scan initialization line GILk, the $k^{th}$ scan write line GWLk, the $k^{th}$ PWM emission line PWELk, the first horizontal power line HVDL, the gate-off voltage line VGHL, the $k^{th}$ sweep signal line SWPLk, the $k^{th}$ scan control line GCLk, the $k^{th}$ PAM emission line PAELk, the test signal line, and the third power line VSL may be spaced apart from each other in the second direction DR2.

The $j^{th}$ PWM data line DLj, the first vertical power line VVDL, and the first PAM data line RDL may extend in the second direction DR2. Further, the second PAM data line GDL and the third PAM data line BDL illustrated in FIG. 1 may extend in the second direction DR2. The $j^{th}$ PWM data line DLj, the first vertical power line VVDL, the first PAM data line RDL, the second PAM data line GDL, and the third PAM data line BDL may be spaced apart from each other in the first direction DR1.

First, the layout of the first sub-pixel RP will be described in detail with reference to FIGS. 19 to 23.

Referring to FIGS. 19 to 23, the first sub-pixel RP includes the first to twentieth transistors T1 to T20, first to sixth capacitor electrodes CE1 to CE6, first to eighth gate connection electrodes GCE1 to GCE8, first and second data connection electrodes DCE1 and DCE2, first to ninth source connection electrodes CCE1 to CCE9, first to fifth connection electrodes CNE1 to CNE5, a first anode pad electrode APD1, a second anode pad electrode APD2, a cathode pad electrode CPD, the first sub-light emitting element REL1, and the second sub-light emitting element REL2.

The first transistor T1 includes a first channel CH1, a first gate electrode G1, a first source electrode S1, and a first drain electrode D1. The first channel CH1 may extend in the first direction DR1. The first channel CH1 may overlap the first gate electrode G1 in a third direction DR3. The first gate electrode G1 may be connected to the first source connection electrode CCE1 through a first contact hole CT1. The first gate electrode G1 may be integrally formed with the first capacitor electrode CE1. The first gate electrode G1 may overlap the second capacitor electrode CE2 in the third direction DR3. The first source electrode S1 may be disposed on one side of the first channel CH1, and the first drain electrode D1 may be disposed on the other side of the first channel CH1. The first source electrode S1 may be connected to a second drain electrode D2 and a fifth drain electrode D5. The first drain electrode D1 may be connected to a third sub-source electrode S41 and a sixth source electrode S6. The first source electrode S1 and the first drain electrode D1 may not overlap the first gate electrode G1 in the third direction DR3. The first source electrode S1 and the first drain electrode D1 may overlap the second capacitor electrode CE2 in the third direction DR3 .

The second transistor T2 includes a second channel CH2, a second gate electrode G2, a second source electrode S2, and the second drain electrode D2. The second channel CH2 may overlap the second gate electrode G2 in the third direction DR3. The second gate electrode G2 may be integrally formed with the first gate connection electrode GCE1. The second source electrode S2 may be disposed on one side of the second channel CH2, and the second drain electrode D2 may be disposed on the other side of the second channel CH2. The second source electrode S2 may be connected to the first data connection electrode DCE1 through a first data contact hole DCT1. The second drain electrode D2 may be connected to the first source electrode S1. The second source electrode S2 and the second drain electrode D2 may not overlap the second gate electrode G2 in the third direction DR3. The second drain electrode D2 may extend in the second direction DR2.

The first sub-transistor T31 of the third transistor T3 includes a first sub-channel CH31, a first sub-gate electrode G31, a first sub-source electrode S31, and a first sub-drain electrode D31. The first sub-channel CH31 may overlap the first sub-gate electrode G31 in the third direction DR3. The first sub-gate electrode G31 may be integrally formed with the second gate connection electrode GCE2. The first sub-source electrode S31 may be disposed on one side of the first sub-channel CH31, and the first sub-drain electrode D31 may be disposed on the other side of the first sub-channel CH31. The first sub-source electrode S31 may be connected to a fourth sub-drain electrode D42, and the first sub-drain electrode D31 may be connected to a second sub-source electrode S32. The first sub-source electrode S31 and the first sub-drain electrode D31 may not overlap the first sub-gate electrode G31. The first sub-source electrode S31 may overlap the $k^{th}$ scan write line GWLk in the third direction DR3. The first sub-drain electrode D31 may overlap the initialization voltage line VIL in the third direction DR3.

The second sub-transistor T32 of the third transistor T3 includes a second sub-channel CH32, a second sub-gate electrode G32, the second sub-source electrode S32, and a second sub-drain electrode D32. The second sub-channel CH32 may overlap the second sub-gate electrode G32 in the third direction DR3. The second sub-gate electrode G32 may be integrally formed with the second gate connection electrode GCE2. The second sub-source electrode S32 may be disposed on one side of the second sub-channel CH32, and the second sub-drain electrode D32 may be disposed on the other side of the second sub-channel CH32. The second sub-source electrode S32 may be connected to the first sub-drain electrode D31, and the second sub-drain electrode D32 may be connected to the initialization voltage line VIL through a first power contact hole VCT1. The second sub-source electrode S32 and the second sub-drain electrode D32 may not overlap the second sub-gate electrode G32. The second sub-source electrode S32 and the second sub-drain electrode D32 may overlap the initialization voltage line VIL in the third direction DR3.

The third sub-transistor T41 of the fourth transistor T4 includes a third sub-channel CH41, a third sub-gate electrode G41, the third sub-source electrode S41, and a third sub-drain electrode D41. The third sub-channel CH41 may overlap the third sub-gate electrode G41 in the third direction DR3. The third sub-gate electrode G41 may be integrally formed with the first gate connection electrode GCE1. The third sub-source electrode S41 may be disposed on one side of the third sub-channel CH41, and the third sub-drain electrode D31 may be disposed on the other side of the third sub-channel CH41. The third sub-source electrode S41 may be connected to the first drain electrode D1, and the third sub-drain electrode D41 may be connected to a fourth sub-source electrode S42. The third sub-source electrode S41 and the third sub-drain electrode D41 may not overlap the third sub-gate electrode G41.

The fourth sub-transistor T42 of the fourth transistor T4 includes a fourth sub-channel CH42, a fourth sub-gate electrode G42, the fourth sub-source electrode S42, and the fourth sub-drain electrode D42. The fourth sub-channel CH42 may overlap the fourth sub-gate electrode G42 in the third direction DR3. The fourth sub-gate electrode G42 may be integrally formed with the second gate connection electrode GCE2. The fourth sub-source electrode S42 may be disposed on one side of the fourth sub-channel CH42, and the fourth sub-drain electrode D42 may be disposed on the other side of the fourth sub-channel CH42. The fourth sub-source electrode S42 may be connected to the third sub-drain electrode D32, and the fourth sub-drain electrode D42 may be connected to the first sub-source electrode S31. The fourth sub-source electrode S42 and the fourth sub-drain electrode D42 may not overlap the fourth sub-gate electrode G42.

The fifth transistor T5 includes a fifth channel CH5, a fifth gate electrode G5, a fifth source electrode S5, and the fifth drain electrode D5. The fifth channel CH5 may overlap the fifth gate electrode G5 in the third direction DR3. The fifth gate electrode G5 may be integrally formed with a sixth gate connection electrode GCE6. The fifth source electrode S5 may be disposed on one side of the fifth channel CH5, and the fifth drain electrode D5 may be disposed on the other side of the fifth channel CH5. The fifth source electrode S5 may be connected to the first horizontal power line HVDL through a second power contact hole VCT2. The fifth drain electrode D5 may be connected to the first source electrode S1. The fifth source electrode S5 and the fifth drain electrode D5 may not overlap the fifth gate electrode G5 in the third direction DR3. The fifth drain electrode D5 may overlap an extension portion E of the second capacitor electrode CE2 in the third direction DR3.

The sixth transistor T6 includes a sixth channel CH6, a sixth gate electrode G6, a sixth source electrode S6, and a sixth drain electrode D6. The sixth channel CH6 may overlap the sixth gate electrode G6 in the third direction DR3. The sixth gate electrode G6 may be integrally formed with the sixth gate connection electrode GCE6. The sixth source electrode S6 may be disposed on one side of the sixth channel CH6, and the sixth drain electrode D6 may be disposed on the other side of the sixth channel CH6. The sixth source electrode S6 may be connected to the first drain electrode D1. The sixth drain electrode D6 may be connected to the fourth source connection electrode CCE4 through a tenth contact hole CT10. The sixth source electrode S6 and the sixth drain electrode D6 may not overlap the sixth gate electrode G6 in the third direction DR3. The sixth drain electrode D6 may overlap the second source connection electrode CCE2 and the first horizontal power line HVDL in the third direction DR3.

The seventh transistor T7 includes a seventh channel CH7, a seventh gate electrode G7, a seventh source electrode S7, and a seventh drain electrode D7. The seventh channel CH7 may overlap the seventh gate electrode G7 in the third direction DR3. The seventh gate electrode G7 may be integrally formed with the third gate connection electrode GCE3. The seventh gate electrode G7 may overlap the initialization voltage line VIL in the third direction DR3. The seventh source electrode S7 may be disposed on one side of the seventh channel CH7, and the seventh drain electrode D7 may be disposed on the other side of the seventh channel CH7. The seventh source electrode S7 may be connected to the gate-off voltage line VGHL through a seventh contact hole CT7. The seventh drain electrode D7 may be connected to the $k^{th}$ sweep signal line SWPLk through a sixth contact hole CT6. The seventh source electrode S7 and the seventh drain electrode D7 may not overlap the seventh gate electrode G7 in the third direction DR3.

The eighth transistor T8 includes an eighth channel CH8, an eighth gate electrode G8, an eighth source electrode S8, and an eighth drain electrode D8. The eighth channel CH8 may overlap the eighth gate electrode G8 in the third direction DR3. The eighth gate electrode G8 may extend in the second direction DR2. The eighth gate electrode G8 may be integrally formed with the third capacitor electrode CE3. The eighth source electrode S8 may be disposed on one side of the eighth channel CH8, and the eighth drain electrode D8 may be disposed on the other side of the eighth channel CH8. The eighth source electrode S8 may be connected to a ninth drain electrode D9 and a twelfth drain electrode D12. The eighth drain electrode D8 may be connected to a seventh sub-source electrode S 111. The eighth source electrode S8 and the eighth drain electrode D8 may not overlap the eighth gate electrode G8 in the third direction DR3.

The ninth transistor T9 includes a ninth channel CH9, a ninth gate electrode G9, a ninth source electrode S9, and the ninth drain electrode D9. The ninth channel CH9 may overlap the ninth gate electrode G9 in the third direction DR3. The ninth gate electrode G9 may extend in the second direction DR2. The ninth gate electrode G9 may be integrally formed with the first gate connection electrode GCE1. The ninth source electrode S9 may be disposed on one side of the ninth channel CH9, and the ninth drain electrode D9 may be disposed on the other side of the ninth channel CH9. The ninth source electrode S9 may be connected to the second data connection electrode DCE2 through a third data contact hole DCT3. The ninth drain electrode D9 may be connected to the eighth source electrode D8. The ninth source electrode S9 and the ninth drain electrode D9 may not overlap the ninth gate electrode G9 in the third direction DR3.

The fifth sub-transistor T101 of the tenth transistor T10 includes a fifth sub-channel CH101, a fifth sub-gate electrode G101, a fifth sub-source electrode S101, and a fifth sub-drain electrode D101. The fifth sub-channel CH101 may overlap the fifth sub-gate electrode G101 in the third direction DR3. The fifth sub-gate electrode G101 may be integrally formed with the second gate connection electrode GCE2. The fifth sub-source electrode S101 may be disposed on one side of the fifth sub-channel CH101, and the fifth sub-drain electrode D101 may be disposed on the other side of the fifth sub-channel CH101. The fifth sub-source electrode S 101 may be connected to an eighth sub-drain electrode D112, and the fifth sub-drain electrode D101 may be connected to a sixth sub-source electrode S102. The fifth sub-source electrode S101 and the fifth sub-drain electrode D101 may not overlap the fifth sub-gate electrode G101. The fifth sub-source electrode S101 may overlap the $k^{th}$ scan write line GWLk in the third direction DR3. The fifth sub-drain electrode D101 may overlap the initialization voltage line VIL in the third direction DR3.

The sixth sub-transistor T102 of the tenth transistor T10 includes a sixth sub-channel CH102, a sixth sub-gate electrode G102, the sixth sub-source electrode S102, and a sixth sub-drain electrode D102. The sixth sub-channel CH102 may overlap the sixth sub-gate electrode G102 in the third direction DR3. The sixth sub-gate electrode G102 may be integrally formed with the second gate connection electrode GCE2. The sixth sub-source electrode S102 may be disposed on one side of the sixth sub-channel CH102, and the sixth sub-drain electrode D102 may be disposed on the other side of the sixth sub-channel CH102. The sixth sub-source electrode S102 may be connected to the fifth sub-drain electrode D101, and the sixth sub-drain electrode D102 may be connected to the initialization voltage line VIL through the first power contact hole VCT1. The sixth sub-source electrode S102 and the sixth sub-drain electrode D102 may not overlap the sixth sub-gate electrode G102. The sixth sub-source electrode S102 and the sixth sub-drain electrode D102 may overlap the initialization voltage line VIL in the third direction DR3.

The seventh sub-transistor T111 of the eleventh transistor T11 includes a seventh sub-channel CH111, a seventh sub-gate electrode G111, the seventh sub-source electrode 5111, and a seventh sub-drain electrode D111. The seventh sub-channel CH111 may overlap the seventh sub-gate electrode G111 in the third direction DR3. The seventh sub-gate electrode G111 may be integrally formed with the first gate connection electrode GCE1. The seventh sub-source electrode S111 may be disposed on one side of the seventh sub-channel CH111, and the seventh sub-drain electrode D111 may be disposed on the other side of the seventh sub-channel CH111. The seventh sub-source electrode S111 may be connected to the eighth drain electrode D8, and the seventh sub-drain electrode D111 may be connected to an eighth sub-source electrode S112. The seventh sub-source electrode S111 and the seventh sub-drain electrode D111 may not overlap the seventh sub-gate electrode G111.

The eighth sub-transistor T112 of the eleventh transistor T11 includes an eighth sub-channel CH112, an eighth sub-gate electrode G112, the eighth sub-source electrode S112, and the eighth sub-drain electrode D112. The eighth sub-channel CH112 may overlap the eighth sub-gate electrode G112 in the third direction DR3. The eighth sub-gate electrode G112 may be integrally formed with the first gate connection electrode GCE1. The eighth sub-source electrode S112 may be disposed on one side of the eighth sub-channel CH112, and the eighth sub-drain electrode D112 may be disposed on the other side of the eighth sub-channel CH112. The eighth sub-source electrode S 112 may be connected to the seventh sub-drain electrode D111, and the eighth sub-drain electrode D112 may be connected to the fifth sub-source electrode S101. The eighth sub-source electrode S112 and the eighth sub-drain electrode D112 may not overlap the eighth sub-gate electrode G112.

The twelfth transistor T12 includes a twelfth channel CH12, a twelfth gate electrode G12, a twelfth source electrode S12, and the twelfth drain electrode D12. The twelfth channel CH12 may overlap the twelfth gate electrode G12 in the third direction DR3. The twelfth gate electrode G12 may be integrally formed with the sixth gate connection electrode GCE6. The twelfth source electrode S12 may be disposed on one side of the twelfth channel CH12, and the twelfth drain electrode D12 may be disposed on the other side of the twelfth channel CH12. The twelfth source electrode S12 may be connected to the fifth source connection electrode CCE5 through eleventh contact holes CT11. The twelfth source electrode S12 and the twelfth drain electrode D12 may not overlap the twelfth gate electrode G12 in the third direction DR3.

The thirteenth transistor T13 includes a thirteenth channel CH13, a thirteenth gate electrode G13, a thirteenth source electrode S13, and a thirteenth drain electrode D13. The thirteenth channel CH13 may overlap the thirteenth gate electrode G13 in the third direction DR3. The thirteenth gate electrode G13 may be integrally formed with the third gate connection electrode GCE3. The thirteenth source electrode S13 may be disposed on one side of the thirteenth channel CH13, and the thirteenth drain electrode D13 may be disposed on the other side of the thirteenth channel CH13. The thirteenth source electrode S13 may be connected to the first horizontal power line HVDL through the second power contact hole VCT2. The thirteenth drain electrode D13 may be connected to the second source connection electrode CCE2 through a third contact hole CT3. The thirteenth source electrode S13 and the thirteenth drain electrode D13 may not overlap the thirteenth gate electrode G13 in the third direction DR3.

The fourteenth transistor T14 includes a fourteenth channel CH14, a fourteenth gate electrode G14, a fourteenth source electrode S14, and a fourteenth drain electrode D14. The fourteenth channel CH14 may overlap the fourteenth gate electrode G14 in the third direction DR3. The fourteenth gate electrode G14 may be integrally formed with the sixth gate connection electrode GCE6. The fourteenth source electrode S14 may be disposed on one side of the fourteenth channel CH14, and the fourteenth drain electrode D14 may be disposed on the other side of the fourteenth channel CH14. The fourteenth source electrode S14 may be connected to the fifth source connection electrode CCE5 through eleventh contact holes CT11. The fourteenth drain electrode D14 may be connected to the second source connection electrode CCE2 through a fourth contact hole CT4. The fourteenth source electrode S14 and the fourteenth drain electrode D14 may not overlap the fourteenth gate electrode G14 in the third direction DR3.

The fifteenth transistor T15 includes a fifteenth channel CH15, a fifteenth gate electrode G15, a fifteenth source electrode S15, and a fifteenth drain electrode D15. The fifteenth channel CH15 may overlap the fifteenth gate electrode G15 in the third direction DR3. The fifteenth gate electrode G15 may be integrally formed with the fifth capacitor electrode CE5. The fifteenth source electrode S15 may be disposed on one side of the fifteenth channel CH15, and the fifteenth drain electrode D15 may be disposed on the other side of the fifteenth channel CH15. The fifteenth source electrode S15 may be connected to the ninth drain electrode D5. The fifteenth drain electrode D15 may be connected to a seventeenth source electrode S17. The fifteenth source electrode S15 and the fifteenth drain electrode D15 may not overlap the fifteenth gate electrode G15 in the third direction DR3.

The ninth sub-transistor T161 of the sixteenth transistor T16 includes a ninth sub-channel CH161, a ninth sub-gate electrode G161, a ninth sub-source electrode S161, and a ninth sub-drain electrode D161. The ninth sub-channel CH161 may overlap the ninth sub-gate electrode G161 in the third direction DR3. The ninth sub-gate electrode G161 may be integrally formed with the third gate connection electrode GCE3. The ninth sub-source electrode S161 may be disposed on one side of the ninth sub-channel CH161, and the ninth sub-drain electrode D161 may be disposed on the other side of the ninth sub-channel CH161. The ninth sub-source electrode S161 may be connected to the fourth source connection electrode CCE4 through the tenth contact hole CT10, and the ninth sub-drain electrode D161 may be connected to a tenth sub-source electrode S162. The ninth sub-source electrode S161 and the ninth sub-drain electrode D161 may not overlap the ninth sub-gate electrode G161.

The tenth sub-transistor T162 of the sixteenth transistor T16 includes a tenth sub-channel CH162, a tenth sub-gate electrode G162, the tenth sub-source electrode S162, and a tenth sub-drain electrode D162. The tenth sub-channel CH162 may overlap the tenth sub-gate electrode G162 in the third direction DR3. The tenth sub-gate electrode G162 may be integrally formed with the third gate connection electrode GCE3. The tenth sub-source electrode S162 may be disposed on one side of the tenth sub-channel CH162, and the tenth sub-drain electrode D162 may be disposed on the other side of the tenth sub-channel CH162. The tenth sub-source electrode S162 may be connected to the ninth sub-drain electrode D161, and the tenth sub-drain electrode D162 may be connected to the initialization voltage line VIL through a ninth contact hole CT9. The tenth sub-source electrode S162 and the tenth sub-drain electrode D162 may not overlap the tenth sub-gate electrode G162.

The seventeenth transistor T17 includes a seventeenth channel CH17, a seventeenth gate electrode G17, the seventeenth source electrode S17, and a seventeenth drain electrode D17. The seventeenth channel CH17 may overlap the seventeenth gate electrode G17 in the third direction DR3. The seventeenth gate electrode G17 may be integrally formed with the fifth gate connection electrode GCE5. The seventeenth source electrode S17 may be disposed on one side of the seventeenth channel CH17, and the seventeenth drain electrode D17 may be disposed on the other side of the seventeenth channel CH17. The seventeenth source electrode S17 may be connected to the fifteenth drain electrode D15. The seventeenth drain electrode D17 may be connected to the seventh source connection electrode CCE7 through sixteenth contact holes CT16. The seventeenth source electrode S17 and the seventeenth drain electrode D17 may not overlap the seventeenth gate electrode G17 in the third direction DR3.

The eleventh sub-transistor T181 of the eighteenth transistor T18 includes an eleventh sub-channel CH181, an eleventh sub-gate electrode G181, an eleventh sub-source electrode S181, and an eleventh sub-drain electrode D181. The eleventh sub-channel CH181 may overlap the eleventh sub-gate electrode G181 in the third direction DR3. The eleventh sub-gate electrode G181 may be integrally formed with the third gate connection electrode GCE3. The eleventh sub-source electrode S181 may be disposed on one side of the eleventh sub-channel CH181, and the eleventh sub-drain electrode D181 may be disposed on the other side of the eleventh sub-channel CH181. The eleventh sub-source electrode S181 may be connected to the initialization voltage line VIL through a twenty-first contact hole CT21. The eleventh sub-drain electrode D181 may be connected to the eighth source connection electrode CCE8 through a twenty-fifth contact hole CT25. The eleventh sub-source electrode S181 and the eleventh sub-drain electrode D181 may not overlap the eleventh sub-gate electrode G181 in the third direction DR3.

The twelfth sub-transistor T182 of the eighteenth transistor T18 includes a twelfth sub-channel CH182, a twelfth sub-gate electrode G182, a twelfth sub-source electrode S182, and a twelfth sub-drain electrode D182. The twelfth sub-channel CH182 may overlap the twelfth sub-gate electrode G182 in the third direction DR3. The twelfth sub-gate electrode G182 may be integrally formed with the third gate connection electrode GCE3. The twelfth sub-source electrode S182 may be disposed on one side of the twelfth sub-channel CH182, and the twelfth sub-drain electrode D182 may be disposed on the other side of the twelfth sub-channel CH182. The twelfth sub-source electrode S182 may be connected to the initialization voltage line VIL through the twenty-first contact hole CT21. The twelfth sub-drain electrode D182 may be connected to the ninth source connection electrode CCE9 through a twenty-sixth contact hole CT26. The twelfth sub-source electrode S182 and the twelfth sub-drain electrode D182 may not overlap the twelfth sub-gate electrode G182 in the third direction DR3.

The nineteenth transistor T19 includes a nineteenth channel CH19, a nineteenth gate electrode G19, a nineteenth source electrode S19, and a nineteenth drain electrode D19. The nineteenth channel CH19 may overlap the nineteenth gate electrode G19 in the third direction DR3. The nineteenth gate electrode G19 may be integrally formed with the seventh gate connection electrode GCE7. The nineteenth source electrode S19 may be disposed on one side of the nineteenth channel CH19, and the nineteenth drain electrode D19 may be disposed on the other side of the nineteenth channel CH19. The nineteenth source electrode S19 may be connected to the third source connection electrode CCE3 through a twenty-fourth contact hole CT24. The nineteenth drain electrode D19 may be connected to the eighth source connection electrode CCE8 through the twenty-fifth contact hole CT25. The nineteenth source electrode S19 and the nineteenth drain electrode D19 may not overlap the nineteenth gate electrode G19 in the third direction DR3.

The twentieth transistor T20 includes a twentieth channel CH20, a twentieth gate electrode G20, a twentieth source electrode S20, and a twentieth drain electrode D20. The twentieth channel CH20 may overlap the twentieth gate electrode G20 in the third direction DR3. The twentieth gate electrode G20 may be integrally formed with the eighth gate connection electrode GCE8. The twentieth source electrode S20 may be disposed on one side of the twentieth channel CH20, and the twentieth drain electrode D20 may be disposed on the other side of the twentieth channel CH20. The twentieth source electrode S20 may be connected to the third source connection electrode CCE3 through the twenty-fourth contact hole CT24. The twentieth drain electrode D20 may be connected to the ninth source connection electrode CCE9 through the twenty-sixth contact hole CT26. The twentieth source electrode S20 and the twentieth drain electrode D20 may not overlap the twentieth gate electrode G20 in the third direction DR3.

The first capacitor electrode CE1 may be integrally formed with the first gate electrode G1. The second capacitor electrode CE2 may overlap the first capacitor electrode CE1 in the third direction DR3. The first capacitor electrode CE1 may be one electrode of the first capacitor C1, and the second capacitor electrode CE2 may be the other electrode of the first capacitor C1.

The second capacitor electrode CE2 includes the hole exposing the first gate electrode G1, and the first source connection electrode CCE1 may be connected to the first gate electrode G1 through the first contact hole CT1 in the hole.

The second capacitor electrode CE2 may include the extension portion EX extending in the second direction DR2. The extension portion EX of the second capacitor electrode CE2 may intersect the $k^{th}$ PWM emission line PWELk and the first horizontal voltage line HVDL. The extension portion EX of the second capacitor CE2 may be connected to the $k^{th}$ sweep signal line SWPLk through a fifth contact hole CT5.

The third capacitor electrode CE3 may be integrally formed with the eighth gate electrode G8. The fourth capacitor electrode CE4 may overlap the third capacitor electrode CE3 in the third direction DR3. The third capacitor electrode CE3 may be one electrode of the second capacitor PC2, and the fourth capacitor electrode CE4 may be the other electrode of the second capacitor PC2.

The fourth capacitor electrode CE4 includes the hole exposing the eighth gate electrode G8, and the sixth source connection electrode CCE6 may be connected to the eighth gate electrode G8 through a twelfth contact hole CT12 in the hole.

The fifth capacitor electrode CE5 may be integrally formed with the fourth gate connection electrode GCE4 and the fifteenth gate electrode G15. The sixth capacitor electrode CE6 may overlap the fifth capacitor electrode CE5 in the third direction DR3. The fifth capacitor electrode CE5 may be one electrode of the third capacitor PC3, and the sixth capacitor electrode CE6 may be the other electrode of the third capacitor PC3. The sixth capacitor electrode CE6 may be connected to the initialization voltage line VIL through an eighteenth contact hole CT18.

The first gate connection electrode GCE1 may be connected to the $k^{th}$ scan write line GWLk through the first gate contact hole GCT1 and the third gate contact hole GCT3. The second gate connection electrode GCE2 may be connected to the $k^{th}$ scan initialization line GILk through the second gate contact hole GCT2. The third gate connection electrode GCE3 may be connected to the $k^{th}$ scan control line GCLk through an eighth contact hole CT8. The fourth gate connection electrode GCE4 may be connected to the fourth source connection electrode CCE4 through a seventeenth contact hole CT17. The fifth gate connection electrode GCE5 may be connected to the $k^{th}$ PAM emission line PAELk through a nineteenth contact hole CT19. The sixth gate connection electrode GCE6 may be connected to the $k^{th}$ PWM emission line PWELk through a fourteenth contact hole CT14. The seventh gate connection electrode GCE7 may be connected to the first emission control line RCL1 through a twenty-second contact hole CT22. The eighth gate connection electrode GCE8 may be connected to the second emission control line RCL2 through a twenty-third contact hole CT23.

The first data connection electrode DCE1 may be connected to the second source electrode S2 through the first data contact hole DCT1, and may be connected to the $j^{th}$ PWM data line DLj through a second data contact hole DCT2. The second data connection electrode DCE2 may be connected to the ninth source electrode S9 through the third data contact hole DCT3, and may be connected to the first PAM data line RDL through a fourth data contact hole DCT4.

The first source connection electrode CCE1 may extend in the second direction DR2. The first source connection electrode CCE1 may be connected to the first gate electrode G1 through the first contact hole CT1, and may be connected to the first sub-source electrode S31 and the fourth sub-drain electrode D42 through a second contact hole CT2.

The second source connection electrode CCE2 may extend in the first direction DR1. The second source connection electrode CCE2 may be connected to the twelfth drain electrode D12 through the third contact hole CT3, may be connected to the fourteenth drain electrode D14 through the fourth contact hole CT4, and may be connected to the fourth capacitor electrode CE4 through a fifteenth contact hole CT15.

The third source connection electrode CCE3 may be connected to the nineteenth source electrode S19 and the twentieth source electrode S20 through the twenty-fourth contact hole CT24, and may be connected to the first connection electrode CNE1 through a twenty-seventh contact hole CT27.

The fourth source connection electrode CCE4 may extend in the first direction DR1. The fourth source connection electrode CCE4 may be connected to the sixth drain electrode D6 and the ninth sub-source electrode S161 through the tenth contact hole CT10, and may be connected to the fourth gate electrode GCE4 through the seventeenth contact hole CT17.

The fifth source connection electrode CCE5 may extend in the first direction DR1. The fifth source connection electrode CCE5 may be connected to the twelfth source electrode S12 and the fourteenth source electrode S14 through the eleventh contact holes CT11, and may be connected to the fourth capacitor electrode CE4 through a fourth power contact hole VCT4.

The sixth source connection electrode CCE6 may extend in the second direction DR2. The sixth source connection electrode CCE6 may be connected to the third capacitor electrode CE3 through the twelfth contact hole CT12, and may be connected to the fifth sub-source electrode S101 and the eighth sub-drain electrode D 112 through a thirteenth contact hole CT13.

The seventh source connection electrode CCE7 may be connected to the seventeenth drain electrode D17 and the eighteenth drain electrode D18 through the sixteenth contact holes CT16. The seventh source connection electrode CCE7 may be connected to the first connection electrode CNE1 through a twentieth contact hole CT20.

The eighth source connection electrode CCE8 may be connected to the eleventh sub-drain electrode D181 of the eleventh sub-transistor T181 of the eighteenth transistor T18 and the nineteenth drain electrode D19 of the nineteenth transistor T19 through the twenty-fifth contact hole CT25. The eighth source connection electrode CCE8 may be connected to the second connection electrode CNE2 through a twenty-eighth contact hole CT28.

The ninth source connection electrode CCE9 may be connected to the twelfth sub-drain electrode D182 of the twelfth sub-transistor T182 of the eighteenth transistor T18 and the twentieth drain electrode D20 of the twentieth transistor T20 through the twenty-sixth contact hole CT26. The ninth source connection electrode CCE9 may be connected to the third connection electrode CNE3 through a twenty-ninth contact hole CT29.

The first connection electrode CNE1 may extend in the second direction DR2. The first connection electrode CNE1 may be connected to the seventh source connection electrode CCE7 through the twentieth contact hole CT20, and may be connected to the third source connection electrode CCE3 through the twenty-seventh contact hole CT27.

The second connection electrode CNE2 may be connected to the eighth source connection electrode CCE8 through the twenty-eighth contact hole CT28, and may be connected to the fourth connection electrode CNE4 through a thirtieth contact hole CT30.

The third connection electrode CNE3 may be connected to the ninth source connection electrode CCE9 through the twenty-ninth contact hole CT29, and may be connected to the fifth connection electrode CNE5 through a thirty-first contact hole CT31.

The fourth connection electrode CNE4 may be connected to the second connection electrode CNE2 through the thirtieth contact hole CT30, and may be connected to the first anode pad electrode APD1 through a thirty-second contact hole CT32.

The fifth connection electrode CNE5 may be connected to the third connection electrode CNE3 through the thirty-first contact hole CT31, and may be connected to the second anode pad electrode APD2 through a thirty-third contact hole CT33.

The first anode pad electrode APD1, the second anode pad electrode APD2, and the cathode pad electrode CPD may extend in the second direction DR2. The length of the first anode pad electrode APD1 in the second direction DR2 may be smaller than the length of the cathode pad electrode CPD in the second direction DR2. The length of the second anode pad electrode APD2 in the second direction DR2 may be smaller than the length of the cathode pad electrode CPD in the second direction DR2. The area of the cathode pad electrode CPD may be larger than the area of the first anode pad electrode APD1 or the area of the second anode pad electrode APD2.

The first anode pad electrode APD1 and the second anode pad electrode APD2 may be disposed in the second direction DR2. The first anode pad electrode APD1 and the cathode pad electrode CPD may be disposed in the first direction DR1. The second anode pad electrode APD2 and the cathode pad electrode CPD may be disposed in the first direction DR1. The first anode pad electrode APD1 and the second anode pad electrode APD2 may be disposed on one side, e.g., on the left side of the cathode pad electrode CPD.

Parts of the first anode pad electrode APD1 and the cathode pad electrode CPD may overlap in the first direction DR1, and some other parts of the second anode pad electrode APD2 and the cathode pad electrode CPD may overlap in the first direction DR1.

The first anode pad electrode APD1 may be connected to the fourth connection electrode CNE4 through the thirty-second contact hole CT32. The second anode pad electrode APD2 may be connected to the fifth connection electrode CNE5 through the thirty-third contact hole CT33.

A second power connection electrode VDCE may extend in the second direction DR2. The second power connection electrode VDCE may be connected to the fifth source connection electrode CCE5 through a fourth power contact hole VCT4.

The first sub-light emitting element REL1 may be disposed on the first anode pad electrode APD1 and the cathode pad electrode CPD. The first electrode of the first sub-light emitting element REL1 may be connected to the first anode pad electrode APD1, and the second electrode thereof may be connected to the cathode pad electrode CPD.

The second sub-light emitting element REL2 may be disposed on the second anode pad electrode APD2 and the cathode pad electrode CPD. The first electrode of the second sub-light emitting element REL2 may be connected to the second anode pad electrode APD2, and the second electrode thereof may be connected to the cathode pad electrode CPD.

Second, the layout of the second sub-pixel GP will be described in detail with reference to FIGS. 19, 20, and 24 to 26.

Referring to FIGS. 19, 20, and 24 to 26, the second sub-pixel GP includes the first to eighteenth transistors T1 to T18, the first to sixth capacitor electrodes CE1 to CE6., the first to sixth gate connection electrodes GCE1 to GCE6, the first and second data connection electrodes DCE1 and DCE2, the first to seventh source connection electrodes CCE1 to CCE7, the first and second connection electrodes CNE1 and CNE2, an anode pad electrode APD, the cathode pad electrode CPD, and the second light emitting element GEL.

In the embodiment of the second sub-pixel GP of FIGS. 19, 20, and 24 to 26, redundant description of parts already described in the embodiment of the first sub-pixel RP in conjunction with FIGS. 19 to 23 will be omitted, and the differences will be mainly described.

Referring to FIGS. 19, 20, and 24 to 26, the eighteenth transistor T18 includes an eighteenth channel CH 18, an eighteenth gate electrode G18, an eighteenth source electrode S18, and an eighteenth drain electrode D18. The eighteenth channel CH18 may overlap the eighteenth gate electrode G18 in the third direction DR3. The eighteenth gate electrode G18 may be integrally formed with the third gate connection electrode GCE3. The eighteenth source electrode S18 may be disposed on one side of the eighteenth channel CH18, and the eighteenth drain electrode D18 may be disposed on the other side of the eighteenth channel CH18. The eighteenth source electrode S18 may be connected to the initialization voltage line VIL through the ninth contact hole CT9. The eighteenth drain electrode D18 may be connected to the seventh source connection electrode CCE7 through sixteenth contact holes CT 16. The eighteenth source electrode S18 and the eighteenth drain electrode D18 may not overlap the eighteenth gate electrode G18 in the third direction DR3.

A second connection electrode CNE2' may be connected to the third source connection electrode CCE3 through a twenty-eighth contact hole CT28'. The anode pad electrode APD may be disposed on the other side, e.g., on the right side of the cathode pad electrode CPD. The anode pad electrode APD may be connected to the second connection electrode CNE2' through a twenty-ninth contact hole CT29'. The area of the cathode pad electrode CPD of the second sub-pixel GP may be smaller than the area of the cathode pad electrode CPD of the first sub-pixel RP. For example, referring to FIGS. 23 and 26, the length of the cathode pad electrode CPD of the second sub-pixel GP in the second direction DR2 may be smaller than the length of the cathode pad electrode CPD of the first sub-pixel RP in the second direction DR2.

The second light emitting element GEL may be disposed on the anode pad electrode APD and the cathode pad electrode CPD. The first electrode of the second light emitting element GEL may be connected to the anode pad electrode APD, and the second electrode may be connected to the cathode pad electrode CPD.

Meanwhile, the layout of the third sub-pixel BP is substantially the same as the layout of the second sub-pixel GP, so that description thereof will be omitted.

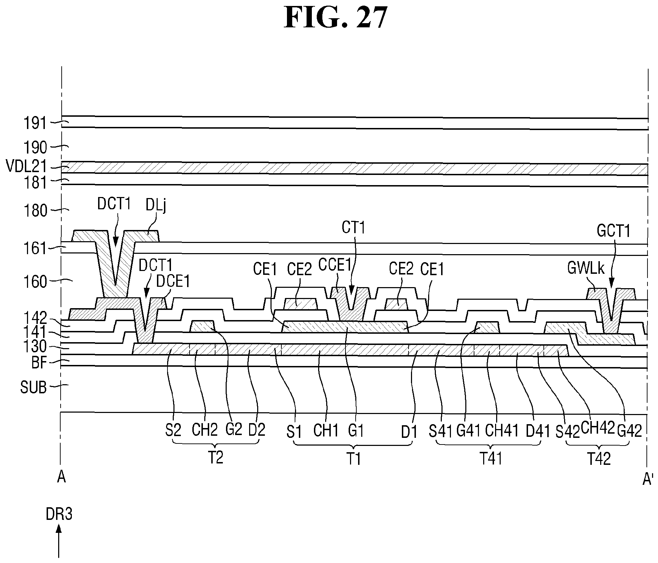

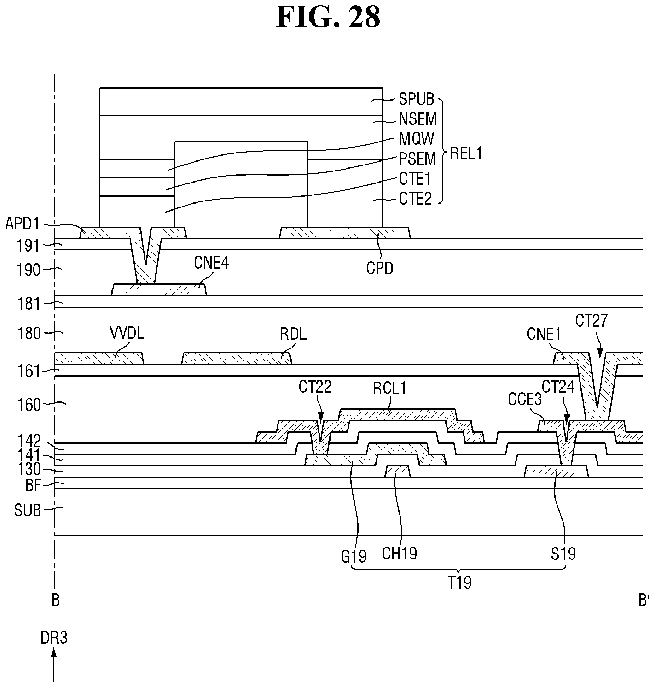

FIG. 27 is a cross-sectional view illustrating an example of the display panel taken along line A-A' of FIG. 21. FIG. 28 is a cross-sectional view illustrating an example of a display panel taken along line B-B' of FIGS. 21 and 24.

Referring to FIGS. 27 and 28, a buffer layer BF may be disposed on the substrate SUB. The substrate SUB may be formed of an insulating material such as glass or a polymer resin. For example, when the substrate SUB is formed of a polymer resin, it may include polyimide. The substrate SUB may be a flexible substrate which can be bent, folded or rolled.

The buffer layer BF may be formed of a plurality of inorganic layers that are alternately stacked. For example, the buffer layer BF may be formed of multiple layers in which one or more inorganic layers of a silicon nitride layer, a silicon oxynitride layer, a silicon oxide layer, a titanium oxide layer and an aluminum oxide layer are alternately stacked. The buffer layer BF may be omitted.

An active layer may be disposed on the buffer layer BF. The active layer includes channels, source electrodes, and drain electrodes of the first to twentieth transistors T1 to T20. The active layer may include polycrystalline silicon, monocrystalline silicon, low-temperature polycrystalline silicon, amorphous silicon, or an oxide semiconductor.

The channels of the first to twentieth transistors T1 to T20 may respectively overlap gate electrodes in the third direction DR3. The source electrodes and the drain electrodes of the first to twentieth transistors T1 to T20 may not overlap the gate electrodes in the third direction DR3. The source electrodes and the drain electrodes of the first to twentieth transistors T1 to T20 may be regions having conductivity by doping a silicon semiconductor or an oxide semiconductor with ions or impurities.

A gate insulating layer 130 may be disposed on the active layer. The gate insulating layer 130 may be formed of an inorganic layer, for example, a silicon nitride layer, a silicon oxynitride layer, a silicon oxide layer, a titanium oxide layer, or an aluminum oxide layer.

A first gate metal layer may be disposed on the gate insulating layer 130. The first gate metal layer includes the gate electrodes of the first to twentieth transistors T1 to T20, the first capacitor electrode CE1, the third capacitor electrode CE3, the fifth capacitor electrode CE5, and the first to and sixth gate connection electrodes GCE1 to GCE6. The gate electrodes of the first to twentieth transistors T1 to T20, the first capacitor electrode CE1, the third capacitor electrode CE3, the fifth capacitor electrode CE5, and the first to sixth gate connection electrodes GCE1 to GCE6 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

A first interlayer insulating layer 141 may be disposed on the first gate metal layer. The first interlayer insulating layer 141 may be formed of an inorganic layer, for example, a silicon nitride layer, a silicon oxynitride layer, a silicon oxide layer, a titanium oxide layer, or an aluminum oxide layer.

A second gate metal layer may be disposed on the first interlayer insulating layer 141. The second gate metal layer may include the second capacitor electrode CE2, the fourth capacitor electrode CE4, and the sixth capacitor electrode CE6. The second gate metal layer may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The second capacitor electrode CE2 may overlap the first capacitor electrode CE1 in the third direction DR3, the fourth capacitor electrode CE4 may overlap the third capacitor electrode CE3 in the third direction DR3, and the sixth capacitor electrode CE6 may overlap the fifth capacitor electrode CE5 in the third direction DR3. Since the first interlayer insulating layer 141 has a predetermined dielectric constant, the first capacitor PC1 may be formed by the first capacitor electrode CE1, the second capacitor electrode CE2, and the first interlayer insulating layer 141 disposed therebetween. Further, the second capacitor PC2 may be formed by the third capacitor electrode CE3, the fourth capacitor electrode CE4, and the first interlayer insulating layer 141 disposed therebetween. The third capacitor PC3 may be formed by the fifth capacitor electrode CE5, the sixth capacitor electrode CE6, and the first interlayer insulating layer 141 disposed therebetween.

A second interlayer insulating layer 142 may be disposed on the second gate metal layer. The second interlayer insulating layer 142 may be formed of an inorganic layer, for example, a silicon nitride layer, a silicon oxynitride layer, a silicon oxide layer, a titanium oxide layer, or an aluminum oxide layer.

A first source metal layer may be disposed on the second interlayer insulating layer 142. The first source metal layer may include the initialization voltage lines VIL, the $k^{th}$ scan initialization line GILk, the $k^{th}$ scan write line GWLk, the $k^{th}$ PWM emission line PWELk, the first horizontal power line HVDL, the gate-off voltage line VGHL, the $k^{th}$ sweep signal line SWPLk, the $k^{th}$ scan control line GCLk, the $k^{th}$ PAM emission line PAELk, the first emission control line RCL1, the second emission control line RCL2, and the third power line VSL. Further, the first source metal layer may include the first and second data connection electrodes DCE1 and DCE2 and the first to ninth source connection electrodes CCE1 to CCE9. The first source metal layer may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The $k^{th}$ scan write line GWLk may be connected to the first gate electrode GCE1 through the first gate contact hole GCT1 and the third gate contact hole GCT3 penetrating the first interlayer insulating layer 141 and the second interlayer insulating layer 142. The $k^{th}$ scan initialization line GILk may be connected to the second gate connection electrode GCE2 through the second gate contact hole GCT2 penetrating the first interlayer insulating layer 141 and the second interlayer insulating layer 142. The $k^{th}$ scan control line GCLk may be connected to the third gate connection electrode GCE3 through the eighth contact hole CT8 penetrating the first interlayer insulating layer 141 and the second interlayer insulating layer 142. The $k^{th}$ PAM emission line PAELk may be connected to the fifth gate connection electrode GCE5 through the nineteenth contact hole CT 19 penetrating the first interlayer insulating layer 141 and the second interlayer insulating layer 142. The $k^{th}$ PWM emission line PWELk may be connected to the sixth gate connection electrode GCE6 through the fourteenth contact hole CT14 penetrating the first interlayer insulating layer 141 and the second interlayer insulating layer 142.

The initialization voltage line VIL may be connected to the second sub-drain electrode D32 and the sixth sub-drain electrode D102 through the first power contact hole VCT1 penetrating the gate insulating layer 130, the first interlayer insulating layer 141, and the second interlayer insulating layer 142. The initialization voltage line VIL may be connected to the tenth sub-drain electrode D162 and the eighteenth drain electrode D18 through the ninth contact hole CT9 penetrating the gate insulating layer 130, the first interlayer insulating layer 141, and the second interlayer insulating layer 142. The initialization voltage line VIL may be connected to the sixth capacitor electrode CE6 through the eighteenth contact hole CT18 penetrating the second interlayer insulating layer 142. The first horizontal power line HVDL may be connected to the fifth source electrode S5 and the thirteenth source electrode S13 through the second power contact hole VCT2 penetrating the gate insulating layer 130, the first interlayer insulating layer 141, and the second interlayer insulating layer 142. The gate-off voltage line VGHL may be connected to the seventh source electrode S7 through the seventh contact hole CT7 penetrating the gate insulating layer 130, the first interlayer insulating layer 141, and the second interlayer insulating layer 142. The test signal line may be connected to the nineteenth gate electrode G19 through the twenty-third contact hole CT23 penetrating the first interlayer insulating layer 141 and the second interlayer insulating layer 142. The third power line VSL may be connected to the nineteenth drain electrode D19 through the twenty-fourth contact hole CT24 penetrating the gate insulating layer 130, the first interlayer insulating layer 141, and the second interlayer insulating layer 142.

The first data connection electrode DCE1 may be connected to the second source electrode S2 through the first data contact hole DCT1 penetrating the gate insulating layer 130, the first interlayer insulating layer 141, and the second interlayer insulating layer 142. The second data connection electrode DCE2 may be connected to the ninth source electrode S9 through the third data contact hole DCT3 penetrating the gate insulating layer 130, the first interlayer insulating layer 141, and the second interlayer insulating layer 142.

The first source connection electrode CCE1 may be connected to the first gate electrode G1 through the first contact hole CT1 penetrating the first interlayer insulating layer 141 and the second interlayer insulating layer 142, and may be connected to the first sub-source electrode S31 and the fourth sub-drain electrode D42 through the second contact hole CT2 penetrating the gate insulating layer 130, the first interlayer insulating layer 141, and the second interlayer insulating layer 142.

The second source connection electrode CCE2 may be connected to the seventeenth drain electrode D17 through the third contact hole CT3 penetrating the gate insulating layer 130, the first interlayer insulating layer 141, and the second interlayer insulating layer 142, may be connected to the fourteenth drain electrode D14 through the fourth contact hole CT4 penetrating the gate insulating layer 130, the first interlayer insulating layer 141, and the second interlayer insulating layer 142, and may be connected to the fourth capacitor electrode CE4 through the fifteenth contact hole CT15 penetrating the second interlayer insulating layer 142.

The third source connection electrode CCE3 may be connected to the nineteenth source electrode S19 through the twenty-first contact hole CT21 penetrating the gate insulating layer 130, the first interlayer insulating layer 141, and the second interlayer insulating layer 142.

The fourth source connection electrode CCE4 may be connected to the sixth drain electrode D6 through the tenth contact hole CT10 penetrating the gate insulating layer 130, the first interlayer insulating layer 141, and the second interlayer insulating layer 142, and may be connected to the fourth gate connection electrode GCE4 through the seventeenth contact hole CT17 penetrating the first interlayer insulating layer 141 and the second interlayer insulating layer 142.

The fifth source connection electrode CCE5 may be connected to the twelfth source electrode S12 and the fourteenth source electrode S14 through the eleventh contact holes CT11 penetrating the gate insulating layer 130, the first interlayer insulating layer 141, and the second interlayer insulating layer 142.

The sixth source connection electrode CCE6 may be connected to the eighth gate electrode G8 through the twelfth contact hole CT12 penetrating the first interlayer insulating layer 141 and the second interlayer insulating layer 142, and may be connected to the fifth sub-source electrode S101 and the eighth sub-drain electrode D112 through the thirteenth contact hole CT13 penetrating the gate insulating layer 130, the first interlayer insulating layer 141, and the second interlayer insulating layer 142.

The seventh source connection electrode CCE7 may be connected to the seventeenth drain electrode D17 and the eighteenth drain electrode D18 through the sixteenth contact holes CT16 penetrating the gate insulating layer 130, the first interlayer insulating layer 141, and the second interlayer insulating layer 142.

The eighth source connection electrode CCE8 may be connected to the eleventh sub-drain electrode D181 and the nineteenth drain electrode D19 through the twenty-fifth contact hole CT25 penetrating the gate insulating layer 130, the first interlayer insulating layer 141, and the second interlayer insulating layer 142.

The ninth source connection electrode CCE9 may be connected to the twelfth sub-drain electrode D182 and the twentieth drain electrode D20 through the twenty-sixth contact hole CT26 penetrating the gate insulating layer 130, the first interlayer insulating layer 141, and the second interlayer insulating layer 142.

A first planarization layer 160 may be disposed on the first source metal layer. The first planarization layer 160 may be formed of an organic layer such as acryl resin, epoxy resin, phenolic resin, polyamide resin, polyimide resin and the like.

A first inorganic insulating layer 161 may be disposed on the first planarization layer 160. The first inorganic insulating layer 161 may be formed of an inorganic layer, for example, a silicon nitride layer, a silicon oxynitride layer, a silicon oxide layer, a titanium oxide layer, or an aluminum oxide layer.

The second source metal layer may be disposed on the first inorganic insulating layer 161. The second source metal layer may include the j$^{th}$ PWM data line DLj, the first vertical power line VVDL, and the first PAM data line RDL. Further, the second source metal layer may include the first to third connection electrodes CNE1, CNE2, and CNE3 and the second power connection electrode VDCE. The second source metal layer may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The j$^{th}$ PWM data line DLj may be connected to the first data connection electrode DCE1 through the second data contact hole DCT2 penetrating the first planarization layer 160 and the first inorganic insulating layer 161. The first PAM data line RDL may be connected to the second data connection electrode DCE2 through the fourth data contact hole DCT4 penetrating the first planarization layer 160 and the first inorganic insulating layer 161. The first vertical power line VVDL may be connected to the first horizontal power line HVDL through a third power contact hole VCT3 penetrating the first planarization layer 160 and the first inorganic insulating layer 161. The third power contact hole VCT3 may overlap the second power contact hole VCT2 in the third direction DR3. The area of the third power contact hole VCT3 may be larger than the area of the second power contact hole VCT2.

The first connection electrode CNE1 may be connected to the seventh source connection electrode CCE7 through the twentieth contact hole CT20 penetrating the first planarization layer 160 and the first inorganic insulating layer 161, and may be connected to the third source connection electrode CCE3 through the twenty-seventh contact hole CT27 penetrating the first planarization layer 160 and the first inorganic insulating layer 161.

The second connection electrode CNE2 may be connected to the eleventh sub-drain electrode D181 and the nineteenth drain electrode D19 through the twenty-fifth contact hole CT25 penetrating the first planarization layer 160 and the first inorganic insulating layer 161.

The third connection electrode CNE3 may be connected to the twelfth sub-drain electrode D182 and the twentieth drain electrode D20 through the twenty-sixth contact hole CT26 penetrating the first planarization layer 160 and the first inorganic insulating layer 161.

The second power connection electrode VDCE may be connected to the fifth source connection electrode CCE5 through the fourth power contact hole VCT4 penetrating the first planarization layer 160 and the first inorganic insulating layer 161.

A second planarization layer 180 may be disposed on the second source metal layer. The second planarization layer 180 may be formed of an organic layer such as acryl resin, epoxy resin, phenolic resin, polyamide resin, polyimide resin and the like.

A second inorganic insulating layer 181 may be disposed on the second planarization layer 180. The second inorganic insulating layer 181 may be formed of an inorganic layer, for example, a silicon nitride layer, a silicon oxynitride layer, a silicon oxide layer, a titanium oxide layer, or an aluminum oxide layer.

The third source metal layer may be disposed on the second inorganic insulating layer 181. The third source metal layer may include a first sub power line VDL21, the fourth connection electrode CNE4, and the fifth connection electrode CNE5. The third source metal layer may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The first sub power line VDL21 may be connected to the second power connection electrode VDCE through the fifth power contact hole penetrating the second planarization layer 180 and the second inorganic insulating layer 181. The fourth connection electrode CNE4 may be connected to the second connection electrode CNE2 through the twenty-eighth contact hole CT28 penetrating the second planarization layer 180 and the second inorganic insulating layer 181. The fifth connection electrode CNE5 may be connected to the third connection electrode CNE3 through the twenty-ninth contact hole CT29 penetrating the second planarization layer 180 and the second inorganic insulating layer 181.

A third planarization layer 190 may be disposed on the third source metal layer. The third planarization layer 190 may be formed of an organic layer such as acryl resin, epoxy resin, phenolic resin, polyamide resin, polyimide resin and the like. The third planarization layer 190 may be referred to as a sixth insulating layer.

A third inorganic insulating layer 191 may be disposed on the third planarization layer 190. The third inorganic insulating layer 191 may be formed of an inorganic layer, for example, a silicon nitride layer, a silicon oxynitride layer, a silicon oxide layer, a titanium oxide layer, or an aluminum oxide layer. The second interlayer insulating layer 142 may be referred to as a third insulating layer.

The fourth source metal layer may be disposed on the third inorganic insulating layer 191. The fourth source metal layer may include the first anode pad electrode APD1, the second anode pad electrode APD2, and the cathode pad electrode CPD. The first anode pad electrode APD1, the second anode pad electrode APD2, and the cathode pad electrode CPD may be formed as a single layer or multiple layers including any one of molybdenum (Mo), aluminum (Al), chromium (Cr), gold (Au), titanium (Ti), nickel (Ni), neodymium (Nd), and copper (Cu), or an alloy thereof.

The first anode pad electrode APD1 may be connected to the fourth connection electrode CNE4 through the thirty-second contact hole CT32 penetrating the third planarization layer 190 and the third inorganic insulating layer 191. The second anode pad electrode APD2 may be connected to the fifth connection electrode CNE5 through the thirty-third contact hole CT33 penetrating the third planarization layer 190 and the third inorganic insulating layer 191.

Although not shown, the cathode pad electrode CPD may be connected to the cathode line of the fourth source metal layer. Since the third power voltage VSS is applied to the cathode line, the third power voltage VSS may be applied to the cathode pad electrode CPD.

A transparent metal layer may be disposed on the fourth source metal layer. The transparent metal layer may include pad electrodes. The pad electrodes may be respectively disposed on the first anode pad electrode APD 1, the second anode pad electrode APD2, and the cathode pad electrode CPD. The transparent metal layer may be formed of a transparent conductive material (TCO) such as indium tin oxide (ITO) or indium zinc oxide (IZO) capable of transmitting light.

FIG. 28 illustrates that each of the light emitting elements RLE1, RLE2, GLE, and BLE is a flip-chip type micro LED in which a first contact electrode CTE1 faces the anode pad electrode APD1/APD2/APD, and a second contact electrode CTE2 faces the cathode pad electrode CPD. Each of the light emitting elements RLE1, RLE2, GLE, and BLE may be formed of an inorganic material such as GaN. The first sub-light emitting element RLE1 may have a length of several to several hundreds of $\mu$m in the first direction DR1, the second direction DR2, and the third direction DR3. For example, each of the light emitting elements RLE1, RLE2, GLE and BLE may have a length of about 100 $\mu$m or less in each of the first direction DR1, the second direction DR2, and the third direction DR3.

Each of the light emitting elements RLE1, RLE2, GLE, and BLE may grow to be formed on a semiconductor substrate such as a silicon wafer. Each of the light emitting elements RLE1, RLE2, GLE, and BLE may be directly transferred from the silicon wafer onto the anode pad electrode APD1/APD2/APD and the cathode pad electrode CPD of the substrate SUB. Alternatively, each of the light emitting elements RLE1, RLE2, GLE, and BLE may be transferred onto the anode pad electrode APD1/APD2/APD and the cathode pad electrode CPD of the substrate SUB by an electrostatic method using an electrostatic head or a stamp method using an elastic polymer material such as polydimethylsiloxane (PDMS), silicon, or the like as a transfer substrate.

Each of the light emitting elements RLE1, RLE2, GLE, and BLE may be a light emitting structure including a base substrate SSUB, an n-type semiconductor NSEM, an active layer MQW, a p-type semiconductor PSEM, the first contact electrode CTE1, and the second contact electrode CTE2.

The base substrate SPUB may be a sapphire substrate, but the embodiment of the present specification is not limited thereto.

The n-type semiconductor NSEM may be disposed on one surface of the base substrate SPUB. For example, the n-type semiconductor NSEM may be disposed on the bottom surface of the base substrate SPUB. The n-type semiconductor NSEM may be formed of GaN doped with an n-type conductive dopant such as Si, Ge, Se, Sn, or the like.

The active layer MQW may be disposed on a part of one surface of the n-type semiconductor NSEM. The active layer MQW may include a material having a single or multiple quantum well structure. When the active layer MQW contains a material having a multiple quantum well structure, the active layer MQW may have the structure in which a plurality of well layers and barrier layers are alternately laminated. At this time, the well layer may be formed of InGaN, and the barrier layer may be formed of GaN or AlGaN, but the present disclosure is not limited thereto. Alternatively, the active layer MQW may have a structure in which semiconductor materials having large band gap energy and semiconductor materials having small band gap energy are alternately stacked, and may include other group III to V semiconductor materials according to the wavelength band of the emitted light.

The p-type semiconductor PSEM may be disposed on one surface of the active layer MQW. The p-type semiconductor PSEM may be formed of GaN doped with a p-type conductive dopant such as Mg, Zn, Ca, Ba, or the like.

The first contact electrode CTE1 may be disposed on the p-type semiconductor PSEM, and the second contact electrode CTE2 may be disposed on another part of one surface of the n-type semiconductor NSEM. Another part of one surface of the n-type semiconductor NSEM on which the second contact electrode CTE2 is disposed may be spaced apart from a part of one surface of the n-type semiconductor NSEM on which the active layer MQW is disposed.

The first contact electrode CTE1 and the anode pad electrode APD1/APD2/APD may be bonded to each other by a conductive adhesive member such as an anisotropic conductive film (ACF) or an anisotropic conductive paste (ACP). Alternatively, the first contact electrode CTE1 and the anode pad electrode APD1/APD2/APD may be bonded to each other by a soldering process.

The second contact electrode CTE2 and the cathode pad electrode CPD may be bonded to each other by a conductive adhesive member such as an anisotropic conductive film (ACF) or an anisotropic conductive paste (ACP). Alternatively, the second contact electrode CTE2 and the cathode pad electrode CPD may be bonded to each other by a soldering process.

As described above, in the first sub-pixel RP, two light emitting elements, i.e., the first sub-light emitting element RLE1 and the second sub-light emitting element RLE2, are connected to one pixel circuit, so that the emission period SET of the first sub-light emitting element REL1 and the emission period SET of the second sub-light emitting element REL2 may be reduced. Accordingly, the amount of heat generated by the first sub-light emitting element REL1 and the amount of heat generated by the second sub-light emitting element REL2 may be reduced, which makes it possible to lower the temperature of the first sub-light emitting element REL1 and the temperature of the second sub-light emitting element REL2. Therefore, it is possible to suppress or prevent a decrease in the emission luminance of the first sub-light emitting element REL1 and the emission luminance of the second sub-light emitting element REL2 due to the heat generated by the first sub-light emitting element REL1 and the heat generated by the second sub-light emitting element REL2.

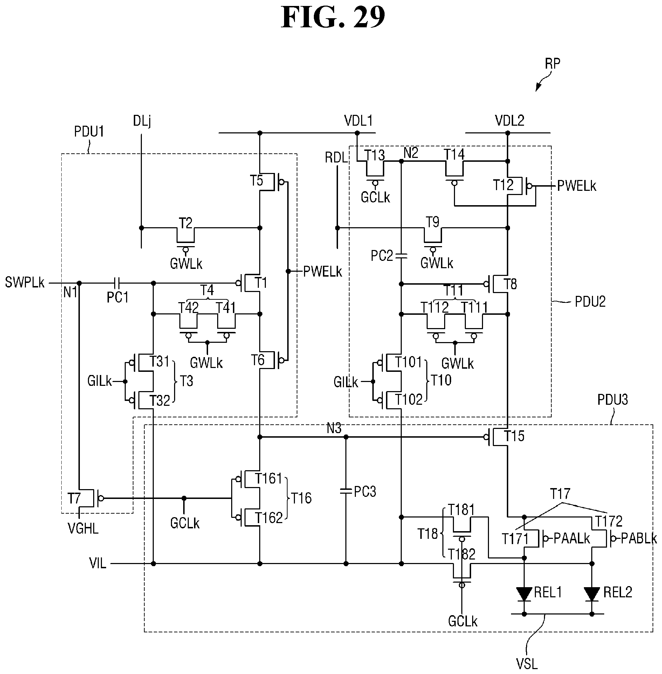

FIG. 29 is an equivalent circuit diagram showing a first sub-pixel according to one embodiment.

The embodiment of FIG. 29 is different from the embodiment of FIG. 6 in that the seventeenth transistor T17 of the first sub-pixel RP includes a thirteenth sub-transistor T171 and a fourteenth sub-transistor T172, and the nineteenth transistor T19 and the twentieth transistor T20 are omitted. In FIG. 29, redundant description of parts already described in the embodiment of FIG. 6 will be omitted.

Referring to FIG. 29, the seventeenth transistor T17 may include the thirteenth sub-transistor T171 and the fourteenth sub-transistor T172.

The thirteenth sub-transistor T171 is turned on by a $k^{th}$ PAMA emission signal of a $k^{th}$ PAMA emission line PAALk to connect the second electrode of the fifteenth transistor T15 to the first electrode of the first sub-light emitting element REL1. The gate electrode of the thirteenth sub-transistor T171 may be connected to the $k^{th}$ PAMA emission line PAALk, the first electrode thereof may be connected to the second electrode of the fifteenth transistor T15, and the second electrode thereof may be connected to the first electrode of the first sub-light emitting element REL1.

The fourteenth sub-transistor T172 is turned on by a $k^{th}$ PAMB emission signal of a $k^{th}$ PAMB emission line PABLk to connect the second electrode of the fifteenth transistor T15 to the first electrode of the second sub-light emitting element REL2. The gate electrode of the fourteenth sub-transistor T172 may be connected to the $k^{th}$ PAMB emission line PABLk, the first electrode thereof may be connected to the second electrode of the fifteenth transistor T15, and the second electrode thereof may be connected to the first electrode of the second sub-light emitting element REL2.

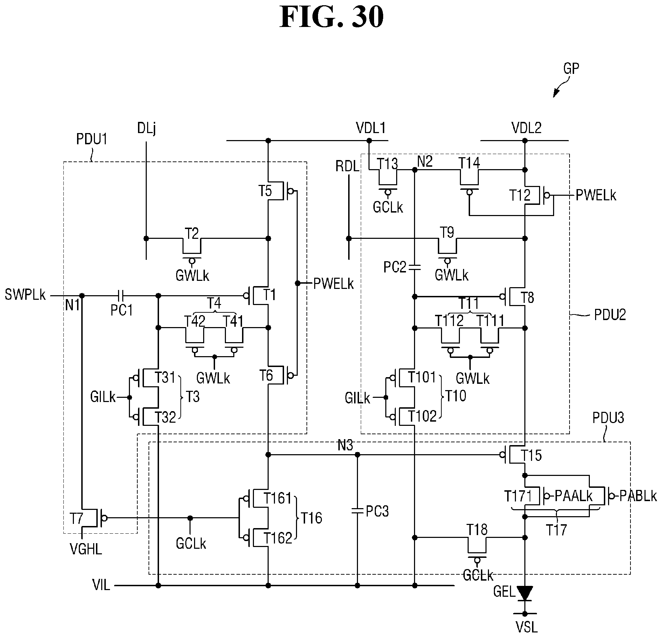

FIG. 30 is an equivalent circuit diagram illustrating a second sub-pixel according to one embodiment. The embodiment of FIG. 30 is different from the embodiment of FIG. 29 in that the second sub-pixel GP includes one second light emitting element GEL. In FIG. 30, redundant description of parts already described in the embodiment of FIG. 29 will be omitted.

Referring to FIG. 30, the second light emitting element GEL emits the second light in response to the driving current Ids generated by the second pixel driver PDU2. The second light emitting element GEL may be disposed between the thirteenth sub-transistor T171 of the seventeenth transistor T17 and the third power line VSL and between the fourteenth sub-transistor T172 of the seventeenth transistor T17 and the third power line VSL. The first electrode of the second light emitting element GEL may be connected to the second electrode of the thirteenth sub-transistor T171 of the seventeenth transistor T17 and the second electrode of the fourteenth sub-transistor T172, and the second electrode thereof may be connected to the third power line VSL.

The eighteenth transistor T18 is turned on by the $k^{th}$ scan control signal of the $k^{th}$ scan control line GCLk to connect the initialization voltage line VIL to the first electrode of the second light emitting element GEL. Accordingly, during the turn-on period of the eighteenth transistor T18, the first electrode of the second light emitting element GEL may be discharged to the initialization voltage VINT of the initialization voltage line VIL. The gate electrode of the eighteenth transistor T18 may be connected to the $k^{th}$ scan control line GCLk, the first electrode thereof may be connected to the first electrode of the second light emitting element GEL, and the second electrode thereof may be connected to the initialization voltage line VIL.

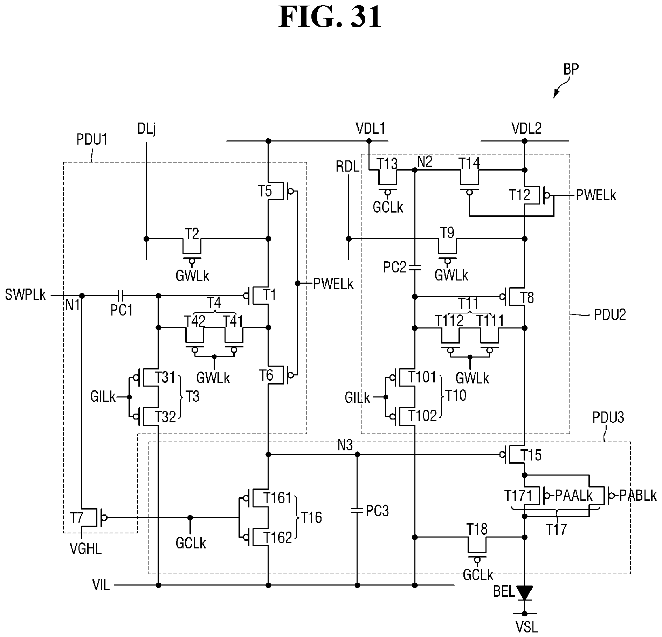

FIG. 31 is an equivalent circuit diagram illustrating a third sub-pixel according to one embodiment.

The embodiment of FIG. 31 is different from the embodiment of FIG. 29 in that the third sub-pixel BP includes one third light emitting element BEL. In FIG. 31, redundant description of parts already described in the embodiment of FIG. 29 will be omitted.

Referring to FIG. 31, the third light emitting element BEL emits the third light in response to the driving current Ids generated by the third pixel driver PDU3. The third light emitting element BEL may be disposed between the thirteenth sub-transistor T171 of the seventeenth transistor T17 and the third power line VSL and between the fourteenth sub-transistor T172 of the seventeenth transistor T17 and the third power line VSL. The first electrode of the third light emitting element BEL may be connected to the second electrode of the thirteenth sub-transistor T171 of the seventeenth transistor T17 and the second electrode of the fourteenth sub-transistor T172, and the second electrode thereof may be connected to the third power line VSL.

The eighteenth transistor T18 is substantially the same as that described in conjunction with FIG. 30 except that it is connected to the third light emitting element BEL instead of the second light emitting element GEL, so that description thereof will be omitted.

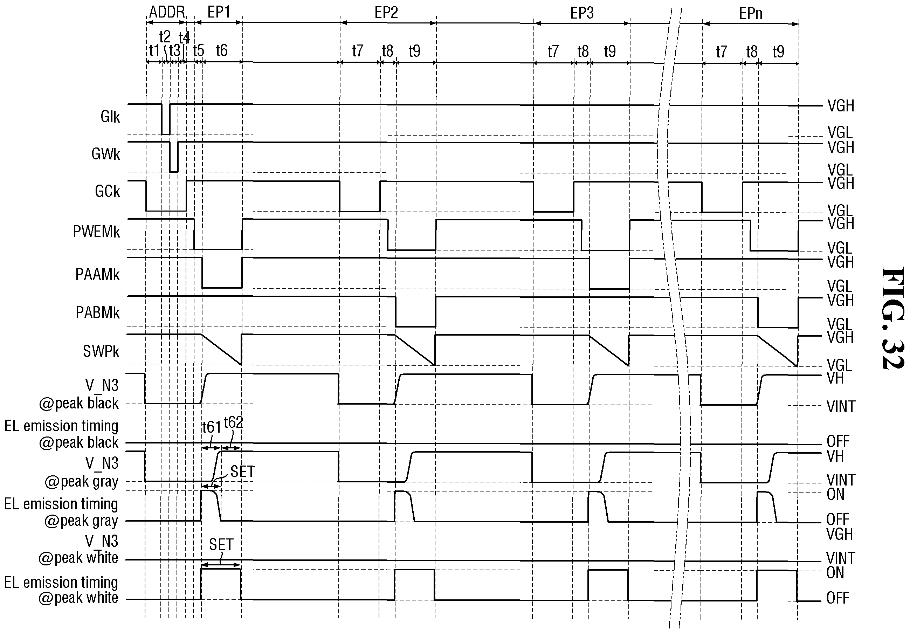

FIG. 32 is a waveform diagram showing the $k^{th}$ scan initialization signal, the $k^{th}$ scan write signal, the $k^{th}$ scan control signal, the $k^{th}$ PWM emission signal, the $k^{th}$ PAMA emission signal, the $k^{th}$ PAMB emission signal, and the $k^{th}$ sweep signal applied to the first sub-pixel disposed in the $k^{th}$ row line, the voltage of the third node, and the period in which a driving current is applied to a light emitting element in the $N^{h}$ frame period according to one embodiment.

The embodiment of FIG. 32 is different from the embodiment of FIG. 11 in that the $k^{th}$ PAM emission signal PAEMk is omitted and the $k^{th}$ PAMA emission signal PAAMk and the $k^{th}$ PAMB emission signal PAMBk are added.

Referring to FIG. 32, the $k^{th}$ PAMA emission signal PAAMk indicates the signal applied to the $k^{th}$ PAMA emission line PAALk, and the $k^{th}$ PAMB emission signal PAMBk indicates the signal applied to the $k^{th}$ PAMB emission line PABLk.

The $k^{th}$ PAMA emission signal PAAMk is the signal for controlling turn-on and turn-off of the thirteenth sub-transistor T171 of the seventeenth transistor T17. The $k^{th}$ PAMB emission signal PAMBk is the signal for controlling turn-on and turn-off of the fourteenth sub-transistor T172 of the seventeenth transistor T17. The $k^{th}$ PAMA emission signal PAAMk and the $k^{th}$ PAMA emission signal PAAMk may be generated at intervals of one frame period.

The $k^{th}$ PAMA emission signal PAAMk may have the gate-on voltage VGL during odd emission periods EP1, EP3, ..., EPn-1 among the plurality of emission periods EP1 to EPn of one frame period, and may have the gate-off voltage VGH during the remaining periods. The $k^{th}$ PAMA emission signal PAAMk may include PAM pulses generated by the gate-on voltage VGL during the sixth period t6 or the ninth period t9 of each of the odd emission periods EP1, EP3, ..., EPn-1.

The $k^{th}$ PAMB emission signal PAMBk may have the gate-on voltage VGL during even emission periods EP2, EP4, ..., EPn among the plurality of emission periods EP1 to EPn of one frame period, and may have the gate-off voltage VGH during the remaining periods. The $k^{th}$ PAMB emission signal PAMBk may include PAM pulses generated by the gate-on voltage VGL during the sixth period t6 or the ninth period t9 of each of the even emission periods EP2, EP4, ..., EPn.

Referring to FIGS. 29 and 32, the thirteenth sub-transistor T171 and the fourteenth transistor T172 may be turned on during different emission periods among the plurality of emission periods EP1 to EPn of one frame period. Therefore, the first sub-light emitting element RLE1 may receive the driving current Ids through the thirteenth sub-transistor T171 during the odd emission periods EP1, EP3, ..., EPn-1 among the plurality of emission periods EP1 to EPn of one frame period, and the second sub-light emitting element RLE2 may receive the driving current Ids through the fourteenth sub-transistor T172 during the even emission periods EP2, EP4, ..., EPn.

Further, referring to FIGS. 30 to 32, each of the second light emitting element GEL and the third light emitting element BEL may receive the driving current Ids through the thirteenth sub-transistor T171 during the odd emission periods EP1, EP3, ..., EPn-1 among the plurality of emission periods EP1 to EPn of one frame period, and may receive the driving current Ids through the fourteenth sub-transistor T172 during the even emission periods EP2, EP4, ..., EPn. Therefore, each of the second light emitting element GEL and the third light emitting element BEL may emit light throughout the plurality of emission periods EP1 to EPn of one frame period.

That is, as shown in FIGS. 29 to 32, the first sub-light emitting element REL1 and the second sub-light emitting element REL2 of the first sub pixel RP emit light during different periods. Therefore, the emission period of the first sub-light emitting element REL1 and the emission period of the second sub-light emitting element REL2 may be reduced by half compared to the emission period of the second light emitting element GEL and the emission period of the third light emitting element BEL, respectively. Accordingly, the amount of heat generated by the first sub-light emitting element REL1 and the amount of heat generated by the second sub-light emitting element REL2 may be reduced, which makes it possible to lower the temperature of the first sub-light emitting element REL1 and the temperature of the second sub-light emitting element REL2. Hence, it is possible to suppress or prevent a decrease in the emission luminance of the first sub-light emitting element REL1 and the emission luminance of the second sub-light emitting element REL2 due to the heat generated by the first sub-light emitting element REL1 and the heat generated by the second sub-light emitting element REL2.

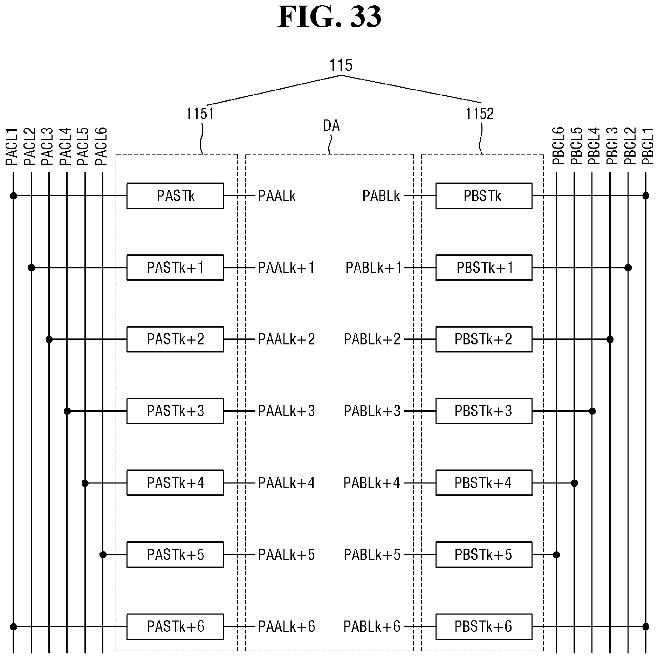

FIG. 33 is an exemplary diagram showing a PAMA emission signal output unit and a PAMB emission signal output unit according to one embodiment.

FIG. 33 illustrates, for simplicity of description, $k^{th}$ to $(k+6)^{th}$ PAMA stages PASTk to PASTk+6 of a PAMA emission signal output unit 1151 and $k^{th}$ to $(k+6)^{th}$ PAMA stages PASTk to PASTk+6 of a PAMB emission signal output unit 1152.

In the following description, "front stage" indicates a stage located in front of a reference stage. For example, the front stages of a $(k+1)^{th}$ stage indicate first to $k^{th}$ stages, and the front stages of a $(k+2)^{th}$ stage indicate first to $(k+1)^{th}$ stages.

Referring to FIG. 33, the emission control signal driver 115 includes the PAMA emission signal output unit 1151 and the PAMB emission signal output unit 1152. Although it is illustrated that the PAMA emission signal output unit 1151 is disposed on one side, e.g., on the left side of the display area DA, and the PAMB emission signal output unit 1152 is disposed on the other side, e.g., on the right side of the display area DA, the embodiment of the present specification is not limited thereto. For example, both the PAMA emission signal output unit 1151 and the PAMB emission signal output unit 1152 may be disposed on one side of the display area DA, or may be disposed on both sides of the display area DA.

PAMA clock lines PACL1 to PACL6 to which PAMA clock signals whose phases are sequentially delayed are applied may be disposed on one sides, e.g., on the left sides of the $k^{th}$ to $(k+6)^{th}$ PAMA stages PASTk to PASTk+6. PAMB clock lines PBCL1 to PBCL6 to which PAMB clock signals whose phases are sequentially delayed are applied may be disposed on one sides, e.g., on the right sides of the $k^{th}$ to $(k+6)^{th}$ PAMB stages PBSTk to PBSTk+6.

Although FIG. 33 illustrates six PAMA clock lines PACL1 to PACL6 and six PAMB clock lines PBCL1 to PBCL6, the number of PAMA clock lines PACL1 to PACL6 and the number of PBMA clock lines PBCL1 to PBCL6 are not limited thereto.

Each of the $k^{th}$ to $(k+6)^{th}$ PAMA stages PASTk to PASTk+6 may be connected to any one of the six PAMA clock lines PACL1 to PACL6 and any one of the $k^{th}$ to $(k+6)^{th}$ PAMA emission lines PAALk to PAALk+6. The $k^{th}$ to $(k+6)^{th}$ PAMA stages PASTk to PASTk+6 may be alternately connected to the six PAMA clock lines PACL1 to PACL6. For example, the $k^{th}$ PAMA stages PASTk may be connected to a first PAMA clock line PACL1, the $(k+1)^{th}$ PAMA stages PASTk+1 may be connected to a second PAMA clock line PACL2, the $(k+2)^{th}$ PAMA stages PASTk+2 may be connected to a third PAMA clock line PACL3, and the $(k+3)^{th}$ PAMA stages PASTk+3 may be connected to a fourth PAMA clock line PACL4. Further, the $(k+4)^{th}$ PAMA stages PASTk+4 may be connected to a fifth PAMA clock line PACL5, the $(k+5)^{th}$ PAMA stages PASTk+5 may be connected to a sixth PAMA clock line PACL6, and the $(k+6)^{th}$ PAMA stages PASTk+6 may be connected to the first PAMA clock line PACL1. Similarly, the $k^{th}$ to $(k+6)^{th}$ PAMA stages PASTk to PASTk+6 may be connected to any one of the six PAMB clock lines PBCL1 to PBCL6 and any one of the $k^{th}$ to $(k+6)^{th}$ PAMB emission lines PABLk to PABLk+6.

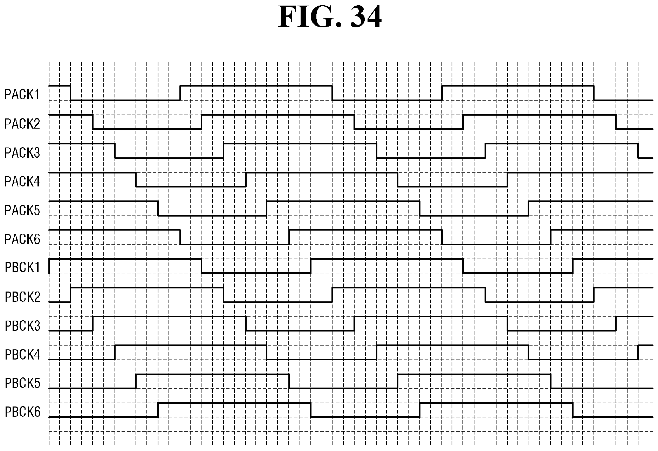

FIG. 34 is a waveform diagram showing the PAMA clock signals and the PAMB clock signals.

Referring to FIG. 34, first to sixth PAMA clock signals PACK1 to PACK6 indicate signals respectively applied to the first to sixth PAMA clock lines PACL1 to PACL6. First to sixth PAMB clock signals PBCK1 to PBCK6 indicate signals respectively applied to the first to sixth PAMB clock lines PBCL1 to PBCL6.

The first to sixth PAMA clock signals PACK1 to PACK6 and the first to sixth PAMB clock lines PBCL1 to PBCL6 may be signals whose phases are sequentially delayed. For example, the phase of the second PAMA clock signal PACK2 may be delayed by one horizontal period from the first PAMA clock signal PACK1, the phase of the third PAMA clock signal PACK3 may be delayed by one horizontal period from the second PAMA clock signal PACK2, the phase of the fourth PAMA clock signal PACK4 may be delayed by one horizontal period from the third PAMA clock signal PACK3, the phase of the fifth PAMA clock signal PACKS may be delayed by one horizontal period from the fourth PAMA clock signal PACK4, and the phase of the sixth PAMA clock signal PACK6 may be delayed by one horizontal period from the fifth PAMA clock signal PACKS.

Further, the phase of the first PAMB clock signal PBCK1 may be delayed by one horizontal period from the sixth PAMA clock signal PACK6, the phase of the second PAMB clock signal PBCK2 may be delayed by one horizontal period from the first PAMB clock signal PBCK1, the phase of the third PAMB clock signal PBCK3 may be delayed by one horizontal period from the second PAMB clock signal PBCK2, the phase of the fourth PAMB clock signal PBCK4 may be delayed by one horizontal period from the third PAMB clock signal PBCK3, the phase of the fifth PAMB clock signal PBCK5 may be delayed by one horizontal period from the fourth PAMB clock signal PBCK4, and the phase of the sixth PAMB clock signal PBCK6 may be delayed by one horizontal period from the fifth PAMB clock signal PBCKS.

Referring to FIGS. 33 and 34, each of the $k^{th}$ to $(k+6)^{th}$ PAMA stages PASTk to PASTk+6 may output the PAM pulses of the PAMA clock signal applied through the PAMA clock line connected thereto to the corresponding PAMA emission line. For example, the $k^{th}$ PAMA stages PASTk may output the PAM pulses of the gate-on voltage VGL of the first PAMA clock signal PACK1 of the first PAMA clock line PACL1 to the $k^{th}$ PAMA emission line PAALk. The $(k+1)^{th}$ PAMA stages PASTk+1 may output the PAM pulses of the gate-on voltage VGL of the second PAMA clock signal PACK2 of the second PAMA clock line PACL2 to the $(k+1)^{th}$ PAMA emission line PAALk+1. The $(k+2)^{th}$ PAMA stages PASTk+2 may output the PAM pulses of the gate-on voltage VGL of the third PAMA clock signal PACK3 of the third PAMA clock line PACL3 to the $(k+2)^{th}$ PAMA emission line PAALk+2. The $(k+3)^{th}$ PAMA stages PASTk+3 may output the PAM pulses of the gate-on voltage VGL of the fourth PAMA clock signal PACK4 of the fourth PAMA clock line PACL4 to the $(k+3)^{th}$ PAMA emission line PAALk+3. Similarly, each of the $k^{th}$ to $(k+6)^{th}$ PAMB stages PBSTk to PBSTk+6 may output PAM pulses of the PAMB clock signal applied through the PAMB clock line connected thereto to the corresponding PAMB emission line.

Further, the $(k+4)^{th}$ PAMA stages PASTk+4 may output the PAM pulses of the gate-on voltage VGL of the fifth PAMA clock signal PACKS of the fifth PAMA clock line PACL5 to the $(k+4)^{th}$ PAMA emission line PAALk+4. The $(k+5)^{th}$ PAMA stages PASTk+5 may output the PAM pulses of the gate-on voltage VGL of the sixth PAMA clock signal PACK6 of the sixth PAMA clock line PACL6 to the $(k+5)^{th}$ PAMA emission line PAALk+5. The $(k+6)^{th}$ PAMA stages PASTk+6 may output the PAM pulses of the gate-on voltage VGL of the first PAMA clock signal PACK1 of the first PAMA clock line PACL1 to the $(k+6)^{th}$ PAMA emission line PAALk+6.

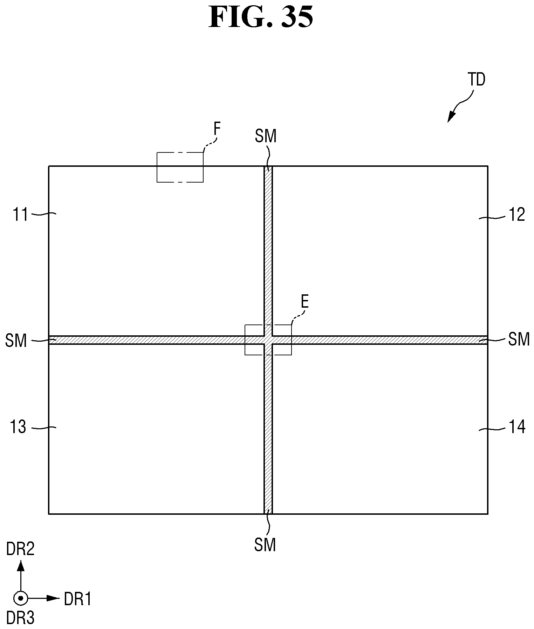

FIG. 35 is a perspective view illustrating a tiled display device including a plurality of display devices according to one embodiment.

Referring to FIG. 35, a tiled display device TD may include a plurality of display devices 11, 12, 13, and 14, and a seam SM. For example, the tiled display device TD may include a first display device 11, a second display device 12, a third display device 13, and a fourth display device 14.

The plurality of display devices 11, 12, 13, and 14 may be arranged in a grid shape. The plurality of display devices 11, 12, 13, and 14 may be arranged in a matrix shape in M (M being a positive integer) rows and N (N being a positive integer) columns. For example, the first display device 11 and the second display device 12 may be adjacent to each other in the first direction DR1. The first display device 11 and the third display device 13 may be adjacent to each other in the second direction DR2. The third display device 13 and the fourth display device 14 may be adjacent to each other in the first direction DR1. The second display device 12 and the fourth display device 14 may be adjacent to each other in the second direction DR2.

However, the number and arrangement of the plurality of display devices 11, 12, 13, and 14 in the tiled display device TD are not limited to those illustrated in FIG. 35. The number and arrangement of the display devices 11, 12, 13, and 14 in the tiled display device TD may be determined by the sizes of the display device 10 and the tiled display device TD and the shape of the tiled display device TD.

The plurality of display devices 11, 12, 13, and 14 may have the same size, but the present disclosure is not limited thereto. For example, the plurality of display devices 11, 12, 13, and 14 may have different sizes.

Each of the plurality of display devices 11, 12, 13, and 14 may have a rectangular shape including long sides and short sides. The plurality of display devices 11, 12, 13, and 14 may be disposed such that the long sides or the short sides thereof are connected to each other. Some or all of the plurality of display devices 11, 12, 13, and 14 may be disposed at the edge of the tiled display device TD, and may form one side of the tiled display device TD. At least one of the plurality of display devices 11, 12, 13, and 14 may be disposed at at least one corner of the tiled display device TD, and may form two adjacent sides of the tiled display device TD. At least one of the plurality of display devices 11, 12, 13, and 14 may be surrounded by other display devices.

Each of the plurality of display devices 11, 12, 13, and 14 may be substantially the same as the display device 100 described in conjunction with FIG. 1. Therefore, description of each of the plurality of display devices 11, 12, 13, and 14 will be omitted.

The seam SM may include a coupling member or an adhesive member. In this case, the plurality of display devices 11, 12, 13, and 14 may be connected to each other by the coupling member or the adhesive member of the seam SM. The seam SM may be disposed between the first display device 11 and the second display device 12, between the first display device 11 and the third display device 13, between the second display device 12 and the fourth display device 14, and between the third display device 13 and the fourth display device 14.

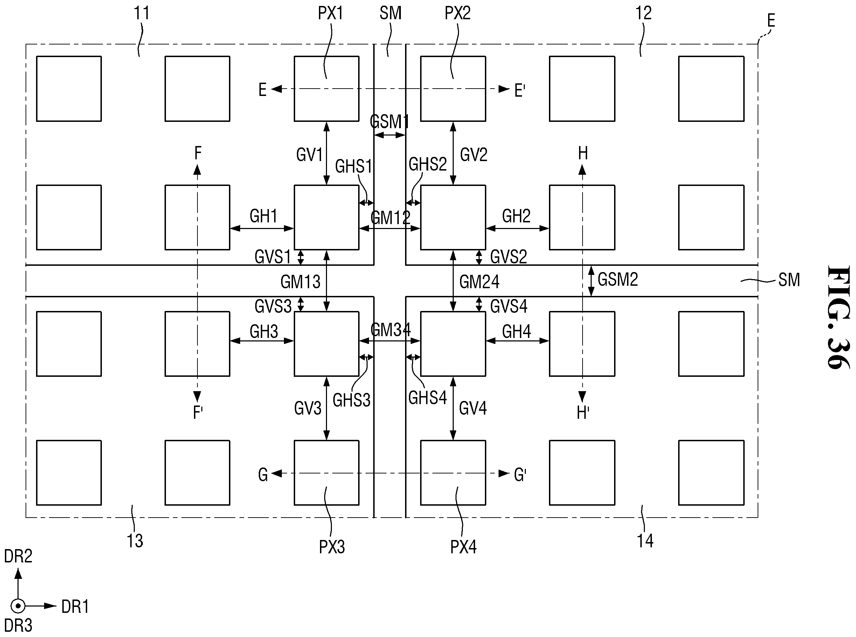

FIG. 36 is an enlarged layout view illustrating area E of FIG. 35 in detail.

Referring to FIG. 36, the seam SM may have a planar shape of the Chinese character 'ten', a cross, or a plus sign at the central region of the tiled display device TD where the first display device 11, the second display device 12, the third display device 13, and the fourth display device 14 are adjacent to each other. The seam SM may be disposed between the first display device 11 and the second display device 12, between the first display device 11 and the third display device 13, between the second display device 12 and the fourth display device 14, and between the third display device 13 and the fourth display device 14.

The first display device 11 may include first pixels PX1 arranged in a matrix shape in the first direction DR1 and the second direction DR2 to display an image. The second display device 12 may include second pixels PX2 arranged in a matrix shape in the first direction DR1 and the second direction DR2 to display an image. The third display device 13 may include third pixels PX3 arranged in a matrix shape in the first direction DR1 and the second direction DR2 to display an image. The fourth display device 14 may include fourth pixels PX4 arranged in a matrix shape in the first direction DR1 and the second direction DR2 to display an image.

The minimum distance between the first pixels PX1 adjacent in the first direction DR1 may be defined as a first horizontal distance GH1, and the minimum distance between the second pixels PX2 adjacent in the first direction DR1 may be defined as a second horizontal distance GH2. The first horizontal distance GH1 and the second horizontal distance GH2 may be substantially the same.

The seam SM may be disposed between the first pixel PX1 and the second pixel PX2 adjacent in the first direction DR1. A minimum distance GM12 between the first pixel PX1 and the second pixel PX2 adjacent in the first direction DR1 may be the sum of a minimum distance GHS1 between the first pixel PX1 and the seam SM in the first direction DR1, a minimum distance GHS2 between the second pixel PX2 and the seam SM in the first direction DR1, and a width GSM1 of the seam SM in the first direction DR1.

The minimum distance GM12 between the first pixel PX1 and the second pixel PX2 adjacent in the first direction DR1, the first horizontal distance GH1, and the second horizontal distance GH2 may be substantially the same. To this end, the minimum distance GHS1 between the first pixel PX1 and the seam SM in the first direction DR1 may be smaller than the first horizontal distance GH1, and the minimum distance GHS2 between the second pixel PX2 and the seam SM in the first direction DR1 may be smaller than the second horizontal distance GH2. Further, the width GSM1 of the seam SM in the first direction DR1 may be smaller than the first horizontal distance GH1 or the second horizontal distance GH2.

The minimum distance between the third pixels PX3 adjacent in the first direction DR1 may be defined as a third horizontal distance GH3, and the minimum distance between the fourth pixels PX4 adjacent in the first direction DR1 may be defined as a fourth horizontal distance GH4. The third horizontal distance GH3 and the fourth horizontal distance GH4 may be substantially the same.

The seam SM may be disposed between the third pixel PX3 and the fourth pixel PX4 adjacent in the first direction DR1. A minimum distance GM34 between the third pixel PX3 and the fourth pixel PX4 adjacent in the first direction DR1 may be the sum of a minimum distance GHS3 between the third pixel PX3 and the seam SM in the first direction DR1, a minimum distance GHS4 between the fourth pixel PX4 and the seam SM in the first direction DR1, and the width GSM1 of the seam SM in the first direction DR1.

The minimum distance GM34 between the third pixel PX3 and the fourth pixel PX4 adjacent in the first direction DR1, the third horizontal distance GH3, and the fourth horizontal distance GH4 may be substantially the same. To this end, the minimum distance GHS3 between the third pixel PX3 and the seam SM in the first direction DR1 may be smaller than the third horizontal distance GH3, and the minimum distance GHS4 between the fourth pixel PX4 and the seam SM in the first direction DR1 may be smaller than the fourth horizontal distance GH4. Further, the width GSM1 of the seam SM in the first direction DR1 may be smaller than the third horizontal distance GH3 or the fourth horizontal distance GH4.

The minimum distance between the first pixels PX1 adjacent in the second direction DR2 may be defined as a first vertical distance GV1, and the minimum distance between the third pixels PX3 adjacent in the second direction DR2 may be defined as a third vertical distance GV3. The first vertical distance GV1 and the third vertical distance GV3 may be substantially the same.

The seam SM may be disposed between the first pixel PX1 and the third pixel PX3 adjacent in the second direction DR2. A minimum distance GM13 between the first pixel PX1 and the third pixel PX3 adjacent in the second direction DR2 may be the sum of a minimum distance GVS1 between the first pixel PX1 and the seam SM in the second direction DR2, a minimum distance GVS3 between the third pixel PX3 and the seam SM in the second direction DR2, and a width GSM2 of the seam SM in the second direction DR2.

The minimum distance GM13 between the first pixel PX1 and the third pixel PX3 adjacent in the second direction DR2, the first vertical distance GV1, and the third vertical distance GV3 may be substantially the same. To this end, the minimum distance GVS1 between the first pixel PX1 and the seam SM in the second direction DR2 may be smaller than the first vertical distance GV1, and the minimum distance GVS3 between the third pixel PX3 and the seam SM in the second direction DR2 may be smaller than the third vertical distance GV3. Further, the width GSM2 of the seam SM in the second direction DR2 may be smaller than the first vertical distance GV1 or the third vertical distance GV3.

The minimum distance between the second pixels PX2 adjacent in the second direction DR2 may be defined as a second vertical distance GV2, and the minimum distance between the fourth pixels PX4 adjacent in the second direction DR2 may be defined as a fourth vertical distance GV4. The second vertical distance GV2 and the fourth vertical distance GV4 may be substantially the same.

The seam SM may be disposed between the second pixel PX2 and the fourth pixel PX4 adjacent in the second direction DR2. A minimum distance GM24 between the second pixel PX2 and the fourth pixel PX4 adjacent in the second direction DR2 may be the sum of a minimum distance GVS2 between the second pixel PX2 and the seam SM in the second direction DR2, a minimum distance GVS4 between the fourth pixel PX4 and the seam SM in the second direction DR2, and the width GSM2 of the seam SM in the second direction DR2.

The minimum distance GM24 between the second pixel PX2 and the fourth pixel PX4 adjacent in the second direction DR2, the second vertical distance GV2, and the fourth vertical distance GV4 may be substantially the same. To this end, the minimum distance GVS2 between the second pixel PX2 and the seam SM in the second direction DR2 may be smaller than the second vertical distance GV2, and the minimum distance GVS4 between the fourth pixel PX4 and the seam SM in the second direction DR2 may be smaller than the fourth vertical distance GV4. Further, the width GSM2 of the seam SM in the second direction DR2 may be smaller than the second vertical distance GV2 or the fourth vertical distance GV4.

As shown in FIG. 36, the minimum distance between pixels of adjacent display devices may be substantially the same as the minimum distance between pixels of each of the display devices in order to prevent the seam SM from being visually recognized between the images displayed by the plurality of display devices 11, 12, 13, and 14.

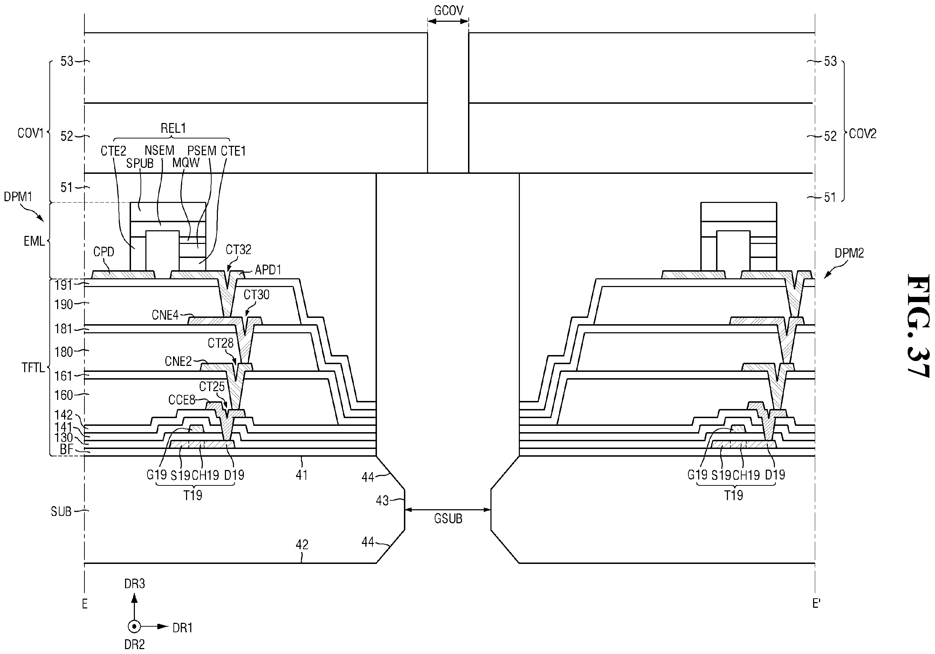

FIG. 37 is a cross-sectional view illustrating an example of a tiled display device taken along line E-E' of FIG. 36.

Referring to FIG. 37, the first display device 11 includes a first display module DPM1 and a first front cover COV1. The second display device 12 includes a second display module DPM2 and a second front cover COV2.

Each of the first display module DPM1 and the second display module DPM2 includes the substrate SUB, the thin film transistor layer TFTL, and the light emitting element layer EML. The thin film transistor layer TFTL and the light emitting element layer EML have already been described in detail with reference to FIGS. 27 and 28. In FIG. 37, redundant description of parts already described in the embodiment of FIGS. 27 and 28 will be omitted.

The substrate SUB may include a first surface 41 on which the thin film transistor layer TFTL is disposed, a second surface 42 facing the first surface, and a first side surface 43 disposed between the first surface 41 and the second surface 42. The first surface 41 may be the front surface or the top surface of the substrate SUB, and the second surface 42 may be the rear surface or the bottom surface of the substrate SUB.

Further, the substrate SUB may further include a chamfer surface 44 disposed between the first surface 41 and the first side surface 43 and between the second surface 42 and the first side surface 43. The thin film transistor layer TFTL and the light emitting element layer EML may not be disposed on the chamfer surface 44. Due to the chamfer surface 44, it is possible to prevent damage caused by collision of the substrate SUB of the first display device 11 and the substrate SUB of the second display device 12.

The chamfer surface 44 may be disposed between the first surface 41 and each of other side surfaces except the first side surface 43 and between the second surface 42 and each of other side surfaces except the first side surface 43. For example, when the first display device 11 and the second display device 12 have a rectangular planar shape as shown in FIG. 35, the chamfer surface 44 may be disposed between the first surface 41 and each of a second side surface, a third side surface, and a fourth side surface and between the second surface 42 and each of the second side surface, the third side surface, and the fourth side surface.

The first front cover COV1 may be disposed on the chamfer surface 44 of the substrate SUB. That is, the first front cover COV1 may protrude more than the substrate SUB in the first direction DR1 and the second direction DR2. Therefore, a distance GSUB between the substrate SUB of the first display device 11 and the substrate SUB of the second display device 12 may be greater than a distance GCOV between the first front cover COV1 and the second front cover COV2.

Each of the first front cover COV1 and the second front cover COV2 may include an adhesive member 51, a light transmittance control layer 52 disposed on the adhesive member 51, and an anti-glare layer 53 disposed on the light transmittance control layer 52.

The adhesive member 51 of the first front cover COV1 serves to attach the light emitting element layer EML of the first display module DPM1 to the first front cover COV1. The adhesive member 51 of the second front cover COV2 serves to attach the light emitting element layer EML of the second display module DPM2 to the second front cover COV2. The adhesive member 51 may be a transparent adhesive member capable of transmitting light. For example, the adhesive member 51 may be an optically clear adhesive film or an optically clear resin.

The anti-glare layer 53 may be designed to diffusely reflect external light in order to prevent a decrease in visibility of an image due to reflection of external light. Accordingly, the contrast ratio of images displayed by the first display device 11 and the second display device 12 may be increased due to the anti-glare layer 53.

The light transmittance control layer 52 may be designed to reduce transmittance of external light or light reflected from the first display module DPM1 and the second display module DPM2. Accordingly, the gap GSUB between the substrate SUB of the first display module DPM1 and the substrate SUB of the second display module DPM2 may be prevented from being visually recognized from the outside.

The anti-glare layer 53 may be implemented as a polarizing plate, and the light transmittance control layer 52 may be implemented as a phase delay layer, but the embodiment of the present specification is not limited thereto.

Meanwhile, an example of a tiled display device TD taken along lines F-F', G-G', and H-H' of FIG. 36 is substantially the same as an example of a tiled display device TD taken along line E-E' described in conjunction with FIG. 37, so that description thereof will be omitted.

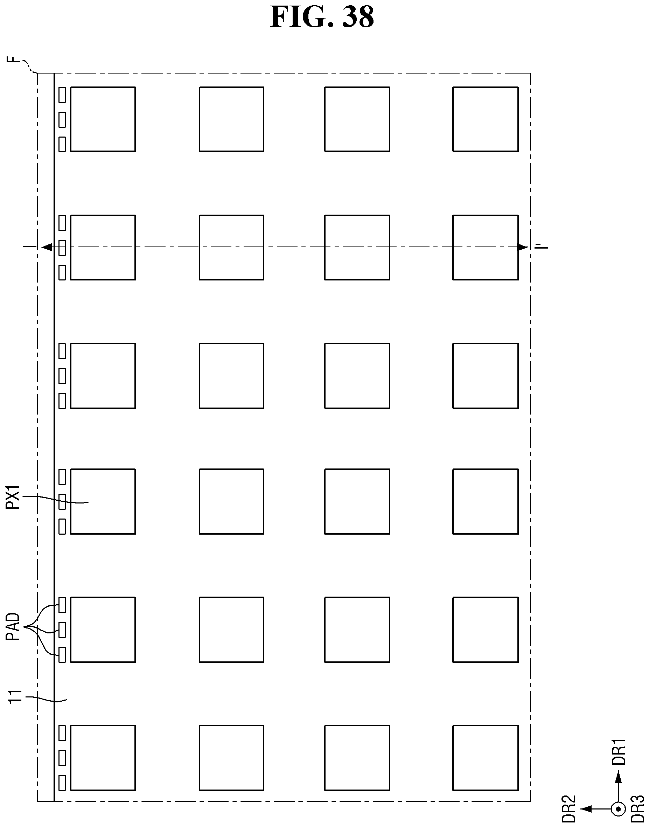

FIG. 38 is an enlarged layout view illustrating area F of FIG. 35 in detail.

FIG. 38 illustrates pads PAD and the second sub-pixels GP of the first pixel PX1 disposed on the upper side of the first display device 10.

Referring to FIG. 38, the pads PAD may be disposed at upper edges of the first display device 11. When the PWM data lines DL of the first display device 10 extend in the second direction DR2, the pads PAD may be disposed at upper and lower edges of the first display device 11. Alternatively, when the PWM data lines DL of the first display device 10 extend in the first direction DR1, the pads PAD may be disposed at left and right edges of the first display device 10.

Each of the pads PAD may be connected to the PWM data line DL. Further, each of the pads PAD may be connected to a side surface line SSL. The side surface line SSL may be disposed on one side surface and the bottom surface (or the rear surface) of the substrate SUB. The side surface line SSL may be connected to a connection line CCL (see FIG. 37) on the bottom surface of the substrate SUB.

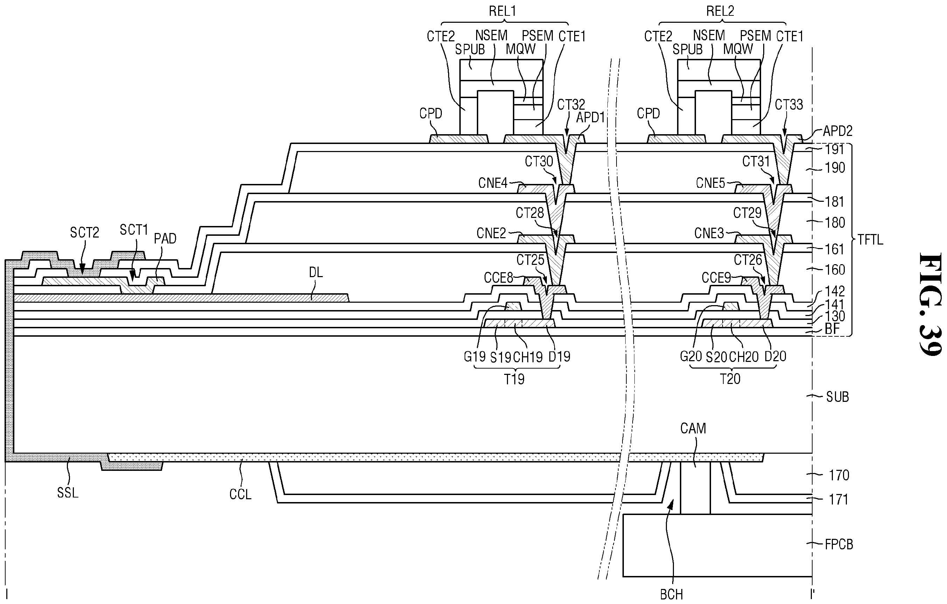

FIG. 39 is a cross-sectional view illustrating an example of a tiled display device taken along line I-I' of FIG. 38. In FIG. 39, redundant description of parts already described in the embodiment of FIGS. 27 and 28 will be omitted.

Referring to FIG. 39, the pad PAD may be disposed on the first insulating layer 161. The pad PAD may be exposed without being covered by the second insulating layer 181 and the third insulating layer 191. Although it is illustrated that the pad PAD is included in the second data metal layer, the embodiment of the present specification is not limited thereto. For example, the pad PAD may be included in the third data metal layer. The pad PAD may be connected to the PWM data line DL through a first side surface pad contact hole SCT1 penetrating the first planarization layer 160 and the first insulating layer 161.

The connection line CCL may be disposed on the bottom surface of the substrate SUB. The connection line CCL may be a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The third planarization layer 170 may be disposed on a part of the connection line CCL. The third planarization layer 170 may be formed of an organic layer such as acryl resin, epoxy resin, phenolic resin, polyamide resin, polyimide resin and the like.

The fourth insulating layer 171 may be disposed on the third planarization layer 170. The fourth insulating layer 171 may be formed of an inorganic layer, for example, a silicon nitride layer, a silicon oxynitride layer, a silicon oxide layer, a titanium oxide layer, or an aluminum oxide layer.

The side surface line SSL may be disposed at the bottom surface edge, the side surface, and the top surface edge of the substrate SUB. One end of the side surface line SSL may be connected to the connection line CCL. One end of the side surface line SSL may be in contact with the side surface and the bottom surface of the connection line CCL. The other end of the side surface line SSL may be connected to the pad PAD. The other end of the side surface line SSL may be connected to the pad PAD through a second side surface pad contact hole SCT2 penetrating the second insulating layer 181 and the third insulating layer 191.

The side surface line SSL may be disposed on the side surface of the substrate SUB, the side surface of the buffer layer BF, the side surface of the gate insulating layer 130, the side surface of the first interlayer insulating layer 141, the side surface of the second interlayer insulating layer 142, the side surface of the first insulating layer 161, the side surface of the second insulating layer 181, and the side surface of the third insulating layer 191.

A flexible film FPCB may be disposed on the bottom surface of the fourth insulating layer 171. The flexible film FPCB may be connected to the connection line CCL through a rear surface contact hole BCT penetrating the third planarization layer 170 and the third insulating layer 171 using a conductive adhesive member CAM. A source driving circuit SIC for supplying data voltages to the PWM data lines DL may be disposed on the bottom surface of the flexible film FPCB. The conductive adhesive member CAM may be an anisotropic conductive film or an anisotropic conductive paste.

As shown in FIGS. 38 and 39, in the first display device 11, the source driving circuit SIC of the flexible film FPCB disposed under the substrate SUB may be connected to the PWM data line DL through the connection line CCL, the side surface line SSL, and the pad PAD. That is, the source driving circuit SIC is disposed on the substrate SUB, so that the non-display area NDA may be eliminated, which makes it possible to form the pixels PX at the edges of the substrate SUB.

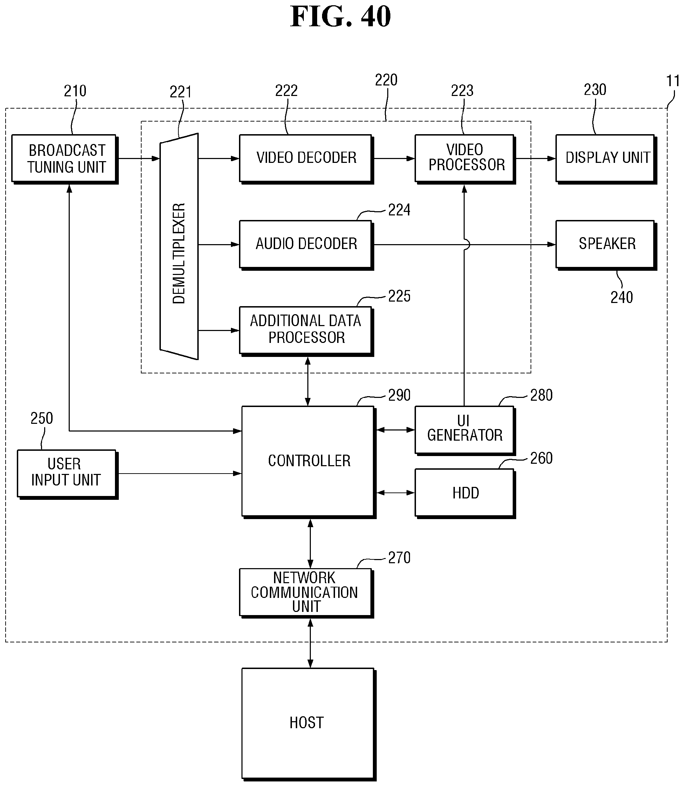

FIG. 40 is a block diagram illustrating a tiled display device according to one embodiment.

FIG. 40 illustrates the first display device 11 and a host system HOST for simplicity of description.

Referring to FIG. 40, the tiled display device TD according to one embodiment may include the host system HOST, a broadcast tuning unit 210, a signal processor 220, a display unit 230, a speaker 240, a user input unit 250, an HDD 260, a network communication unit 270, a UI generator 280, and a controller 290.

The host system HOST may be implemented as any one of a television system, a home theater system, a set-top box, a navigation system, a DVD player, a Blu-ray player, a personal computer (PC), a mobile phone system, and a tablet.

A user's command may be inputted to the host system HOST in various manners. For example, a command may be inputted to the host system HOST by a user's touch input. Alternatively, a user's command may be inputted to the host system HOST by a keyboard input or a button input of a remote controller.

The host system HOST may receive original video data corresponding to an original image from the outside. The host system HOST may divide the original video data by the number of display devices. For example, the host system HOST may divide the original video data into a first video data corresponding to a first image, a second video data corresponding to a second image, a third video data corresponding to a third image, and a fourth video data corresponding to a fourth image to correspond to the first display device 11, the second display device 12, the third display device 13, and the fourth display device 14. The host system HOST may transmit the first video data to the first display device 11, the second video data to the second display device 12, the third video data to the third display device 13, and the fourth video data to the fourth display device 14.

The first display device 11 may display the first image in response to the first video data, the second display device 12 may display the second image in response to the second video data, the third display device 13 may display the third image in response to the third video data, and the fourth display device 14 may display the fourth image in response to the fourth video data. Accordingly, a user may view the original image in which the first to fourth images displayed on the first to fourth display devices 11, 12, 13 and 14 are combined.

The first display device 11 may include the broadcast tuning unit 210, the signal processor 220, the display unit 230, the speaker 240, the user input unit 250, the HDD 260, the network communication unit 270, the UI generator 280, and the controller 290.

The broadcast tuning unit 210 may tune a predetermined channel frequency under the control of the controller 290 to receive a broadcast signal of the corresponding channel through an antenna. The broadcast tuning unit 210 may include a channel detection module and an RF demodulation module.

The broadcast signal demodulated by the broadcast tuning unit 210 is processed by the signal processor 220 and outputted to the display unit 230 and the speaker 240. Here, the signal processor 220 may include a demultiplexer 221, a video decoder 222, a video processor 223, an audio decoder 224, and an additional data processor 225.

The demultiplexer 221 separates the demodulated broadcast signal into a video signal, an audio signal, and additional data. The separated video signal, audio signal, and additional data are restored by the video decoder 222, the audio decoder 224, and the additional data processor 225, respectively. In this case, the video decoder 222, the audio decoder 224, and the additional data processor 225 restore them in a decoding format corresponding to an encoding format at the time of transmitting a broadcast signal.

Meanwhile, the decoded video signal is converted by the video processor 223 to have a vertical frequency, a resolution, an aspect ratio, and the like suitable for the output standard of the display unit 230, and the decoded audio signal is outputted to the speaker 240.

The display unit 230 includes a display panel 100 on which an image is displayed and a panel driver for controlling driving of the display panel 100. The detailed block diagram of the display panel 100 and the panel driver has already been described in detail in conjunction with FIG. 4.

The user input unit 250 may receive the signal transmitted by the host system HOST. The user input unit 250 may be provided to allow a user to select a command related to communication with other display devices as well as data related to selection of a channel transmitted by the host system HOST and selection and manipulation of a user interface (UI) menu, and to input the input data.

The storage device 260, which stores various software programs including OS programs, recorded broadcast programs, moving pictures, photos, and other data, may include a storage medium such as a hard disk, a non-volatile memory, or the like.

The network communication unit 270, which is used for short-distance communication with the host system HOST and other display devices, may be implemented as a communication module including an antenna pattern capable of implementing mobile communication, data communication, Bluetooth, RF, Ethernet, or the like.

The network communication unit 270 may transmit/receive a wireless signal with at least one of a base station, an external terminal, or a server on a mobile communication network constructed based on technical standards or communication methods (e.g., global system for mobile communication (GSM), code division multi access (CDMA), code division multi access (CDMA2000), enhanced voice-data optimized or enhanced voice-data only (EV-DO), wideband CDMA (WCDMA), high speed downlink packet access (HSDPA), high speed uplink packet access (HSUPA), long term evolution (LTE), long term evolution-advanced (LTE-A), 5G, or the like) for mobile communication through an antenna pattern to be described later.

The network communication unit 270 may transmit/receive a wireless signal in a communication network according to wireless Internet technologies through an antenna pattern to be described later. The wireless Internet technology may be, e.g., wireless LAN (WLAN), wireless fidelity (Wi-Fi), wireless fidelity (Wi-Fi) direct, digital living network alliance (DLNA), wireless broadband (WiBro), world interoperability for microwave access (WiMAX), high speed downlink packet access (HSDPA), high speed uplink packet access (HSUPA), long term evolution (LTE), long term evolution-advanced (LTE-A), or the like, and the antenna pattern may transmit/receive data according to at least one wireless Internet technology within a range including Internet technologies not listed above.

The UI generator 280, which generates a UI menu for communication with the host system HOST and other display devices, may be implemented by an algorithm code and an OSD IC. The UI menu for communication with the host system HOST and other display devices may be a menu for designating a counterpart digital TV for communication and selecting a desired function.

The controller 290, which is responsible for overall control of the first display device 11 and communication control of the host system HOST and the second to fourth display devices 12, 13, and 14, may be implemented by a micro controller unit (MCU) in which the corresponding algorithm code for control is stored and the stored algorithm code is executed.

The controller 290 transmits the corresponding control command and data to the host system HOST and the second to fourth display devices 12, 13, and 14 through the network communication unit 270 in response to the input and selection of the user input unit 250. When a predetermined control command and data are inputted from the host system HOST and the second to fourth display devices 12, 13, and 14, an operation is performed in response to the corresponding control command.

Meanwhile, the block diagram of the second display device 12, the block diagram of the third display device 13, and the block diagram of the fourth display device 14 are substantially the same as the block diagram of the first display device 11 described in conjunction with FIG. 4, so that description thereof will be omitted.

The above description is an example of technical features of the disclosure, and those skilled in the art to which the disclosure pertains will be able to make various modifications and variations. Therefore, the embodiments of the disclosure described above may be implemented separately or in combination with each other.

Therefore, the embodiments disclosed in the disclosure are not intended to limit the technical spirit of the disclosure, but to describe the technical spirit of the disclosure, and the scope of the technical spirit of the disclosure is not limited by these embodiments. The protection scope of the disclosure should be interpreted by the following claims, and it should be interpreted that all technical spirits within the equivalent scope are included in the scope of the disclosure.

< Descriptions of Reference Numerals >

| 10: | display device | 100: | display panel |
|---|---|---|---|
| 110: | scan driver | 200: | source driver |
| 300: | timing controller | 400: | power supply unit |

**Claims**

1. A display device comprising:

   a first sub-pixel and a second sub-pixel emitting different lights,
   wherein the first sub-pixel comprises:

   a first anode pad electrode and a second anode pad electrode spaced apart from each other in plan view;
   a first cathode pad electrode spaced apart from the first anode pad electrode and the second anode pad electrode in plan view; and
   a first light emitting element comprising a first sub-light emitting element disposed on the first anode pad electrode and the first cathode pad electrode, and a second sub-light emitting element disposed on the second anode pad electrode and the first cathode pad electrode,
   wherein an area of the first cathode pad electrode is larger than an area of the first anode pad electrode or an area of the second anode pad electrode,
   the first sub-light emitting element and the second sub-light emitting element emit light during different periods, and
   the first sub-light emitting element and the second sub-light emitting element emit the same light.

2. The display device of claim 1, wherein a length of the first cathode pad electrode in one direction is greater than a length of the first anode pad electrode in one direction or a length of the second anode pad electrode in one direction.

3. The display device of claim 1, wherein the second sub-pixel comprises:

a third anode pad electrode;
a second cathode pad electrode spaced apart from the third anode pad electrode; and
a second light emitting element disposed on the third anode pad electrode and the second cathode pad electrode.

4. The display device of claim 3, wherein an area of the first cathode pad electrode is larger than an area of the second cathode pad electrode.

5. The display device of claim 3, wherein a length of the first cathode pad electrode in one direction is greater than a length of the second cathode pad electrode in one direction.

6. The display device of claim 1, further comprising a third sub-pixel emitting light different from those of the first sub-pixel and the second sub-pixel,
wherein the third sub-pixel comprises:

a fourth anode pad electrode;
a third cathode pad electrode spaced apart from the third anode pad electrode in plan view; and
a third light emitting element disposed on the fourth anode pad electrode and the third cathode pad electrode.

7. The display device of claim 6, wherein an area of the first cathode pad electrode is larger than an area of the third cathode pad electrode.

8. The display device of claim 7, wherein a length of the first cathode pad electrode in one direction is greater than a length of the third cathode pad electrode in one direction.

9. The display device of claim 8, wherein the first sub-light emitting element and the second sub-light emitting element emit first light, the second light emitting element emits second light, and the third light emitting element emits third light.

10. The display device of claim 6, wherein the first light is red light, the second light is green light, and the third light is blue light.

11. A display device comprising:

a first data line to which a first data voltage is applied;
a second data line to which a second data voltage is applied;
a first emission control line to which a first emission control signal is applied;
a second emission control line to which a second emission control signal is applied; and
a first sub-pixel connected to the first data line, the second data line, the first emission control line, and the second emission control line,
wherein the first sub-pixel comprises:

a first light emitting element comprising a first sub-light emitting element and a second sub-light emitting element emitting first light;
a first pixel driver configured to generate a control current in response to the first data voltage of the first data line;
a second pixel driver configured to generate a first driving current applied to the first sub-light emitting element or the second sub-light emitting element in response to the second data voltage of the second data line; and
a third pixel driver configured to control a period in which the first driving current is applied to the first sub-light emitting element or the second sub-light emitting element in response to the control current of the first pixel driver,
wherein the third pixel driver comprises:

a first transistor configured to supply the first driving current to the first light emitting element in response to the first emission control signal; and
a second transistor configured to supply the first driving current to the second light emitting element in response to the second emission control signal,

wherein the first emission control signal has a gate-on voltage during an $N^{th}$ frame period and a gate-off voltage during an $(N+1)^{th}$ frame period, and

the second emission control signal has the gate-off voltage during the $N^{th}$ frame period and has the gate-on voltage during the $(N+1)^{th}$ frame period.

12. The display device of claim 11, further comprising:

a first initialization signal line to which a first initialization signal is applied; and

an initialization voltage line to which an initialization voltage is applied,

wherein the first sub-pixel further comprises:

a third transistor configured to supply the initialization voltage to a first electrode of the first sub-light emitting element in response to the first initialization signal; and

a fourth transistor configured to supply the initialization voltage to a first electrode of the second light emitting element in response to the first initialization signal.

13. The display device of claim 12, further comprising:

an emission signal line to which an emission signal is applied; and

a second sub-pixel connected to the emission signal line and the first initialization signal line,

wherein the second sub-pixel comprises:

a second light emitting element emitting second light;

a fifth transistor configured to supply a second driving current to the second light emitting element in response to the first emission signal; and

a sixth transistor configured to supply the initialization voltage to the first electrode of the second light emitting element in response to the first initialization signal.

14. The display device of claim 13, wherein the first light is red light, and the second light is green light or blue light.

15. A display device comprising:

a first data line to which a first data voltage is applied;

a second data line to which a second data voltage is applied;

a first emission signal line to which a first emission signal is applied;

a second emission signal line to which a second emission signal is applied; and

a first sub-pixel connected to the first data line, the second data line, the first emission signal line, and the second emission signal line,

wherein the first sub-pixel comprises:

a first light emitting element comprising a first sub-light emitting element and a second sub-light emitting element emitting first light;

a first pixel driver configured to generate a control current in response to the first data voltage of the first data line;

a second pixel driver configured to generate a first driving current applied to the first sub-light emitting element or the second sub-light emitting element in response to the second data voltage of the second data line; and

a third pixel driver configured to control a period in which the first driving current is applied to the first sub-light emitting element or the second sub-light emitting element in response to the control current of the first pixel driver,

wherein the third pixel driver comprises:

a first transistor configured to supply the first driving current to the first sub-light emitting element in response to the first emission signal; and

a second transistor configured to supply the first driving current to the second light emitting element in response to the second emission signal,

wherein one frame period comprises a plurality of emission periods, and

the first transistor and the second transistor are turned on during different emission periods among the plurality of emission periods.

16. The display device of claim 15, wherein the first transistor is turned on during odd emission periods among the plurality of emission periods, and
the second transistor is turned on during even emission periods among the plurality of emission periods.

17. The display device of claim 15, wherein during odd emission periods among the plurality of emission periods, the first emission signal has a gate-on voltage, and the second emission signal has a gate-off voltage, and
during even emission periods among the plurality of emission periods, the second emission signal has the gate-on voltage, and the first emission signal has the gate-off voltage.

18. The display device of claim 15, further comprising:

a first initialization signal line to which a first initialization signal is applied; and
an initialization voltage line to which an initialization voltage is applied,
wherein the first sub-pixel further comprises:

a third transistor configured to supply the initialization voltage to a first electrode of the first sub-light emitting element in response to the first initialization signal; and
a fourth transistor configured to supply the initialization voltage to a first electrode of the second light emitting element in response to the first initialization signal.

19. The display device of claim 18, further comprising:

a second sub-pixel connected to the first emission signal line and the second emission line,
wherein the second sub-pixel comprises:

a second light emitting element emitting second light;
a fifth transistor configured to supply a second driving current to the second light emitting element in response to the first emission signal; and
a sixth transistor configured to supply the second driving current to the second light emitting element in response to the second emission signal.

20. The display device of claim 19, further comprising:

a first initialization signal line to which a first initialization signal is applied; and
an initialization voltage line to which an initialization voltage is applied,
wherein the second sub-pixel further comprises:
a seventh transistor configured to supply the initialization voltage to the first electrode of the second light emitting element in response to the first initialization signal.

21. The display device of claim 19, wherein the first light is red light, and the second light is green light or blue light.

# FIG. 1

# FIG. 2

RP    GP    BP    PX

DR2

DR3 ⊙ → DR1

# FIG. 3

# FIG. 4

# FIG. 5

# FIG. 6

# FIG. 7

# FIG. 8

# FIG. 9

# FIG. 10

# FIG. 11

# FIG. 12

# FIG. 13

# FIG. 14

# FIG. 15

# FIG. 16

# FIG. 17

# FIG. 18

# FIG. 19

# FIG. 20

# FIG. 21

# FIG. 22

FIG. 23

EP 4 471 756 A1

64

# FIG. 24

# FIG. 25

FIG. 26

67

# FIG. 27

# FIG. 28

# FIG. 29

# FIG. 30

# FIG. 31

FIG. 32

EP 4 471 756 A1

# FIG. 33

115

1151        DA        1152

| PASTk | PAALk | PABLk | PBSTk |
|---|---|---|---|
| PASTk+1 | PAALk+1 | PABLk+1 | PBSTk+1 |
| PASTk+2 | PAALk+2 | PABLk+2 | PBSTk+2 |
| PASTk+3 | PAALk+3 | PABLk+3 | PBSTk+3 |
| PASTk+4 | PAALk+4 | PABLk+4 | PBSTk+4 |
| PASTk+5 | PAALk+5 | PABLk+5 | PBSTk+5 |
| PASTk+6 | PAALk+6 | PABLk+6 | PBSTk+6 |

PACL1 PACL2 PACL3 PACL4 PACL5 PACL6

PBCL6 PBCL5 PBCL4 PBCL3 PBCL2 PBCL1

# FIG. 34

# FIG. 35

# FIG. 36

# FIG. 37

# FIG. 38

# FIG. 39

# FIG. 40

<table>
<tr><td colspan="2" align="center"><b>INTERNATIONAL SEARCH REPORT</b></td><td>International application No.<br><br><b>PCT/KR2023/000539</b></td></tr>
</table>

| | |
|---|---|
| **A.** **CLASSIFICATION OF SUBJECT MATTER** | |

G09G 3/32(2006.01)i; **H01L 33/38**(2010.01)i; **H01L 33/62**(2010.01)i; **H01L 27/12**(2006.01)i

According to International Patent Classification (IPC) or to both national classification and IPC

**B.** **FIELDS SEARCHED**

Minimum documentation searched (classification system followed by classification symbols)

G09G 3/32(2006.01); G09G 3/30(2006.01); H01L 25/075(2006.01); H01L 25/13(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 제1 서브 화소(first sub-pixel), 제2 서브 화소(second sub-pixel), 제1 애노드 패드 전극(first anode pad electrode), 제2 애노드 패드 전극(second anode pad electrode), 캐소드 패드 전극(cathode pad electrode), 면적(size), 다른 기간(different period)

**C.** **DOCUMENTS CONSIDERED TO BE RELEVANT**

| Category* | Citation of document, with indication, where appropriate, of the relevant passages | Relevant to claim No. |
|---|---|---|
| Y<br><br>A | KR 10-2009-0131405 A (SAMSUNG MOBILE DISPLAY CO., LTD.) 29 December 2009 (2009-12-29)<br>See paragraphs [0036] and [0045]-[0053]; claims 7-12; and figures 4-5. | 1-3,6,11,15-17<br><br>4-5,7-10,12-14,18-21 |
| Y | KR 10-2018-0105834 A (LUMENS CO., LTD.) 01 October 2018 (2018-10-01)<br>See paragraph [0071]; and figure 9. | 1-3,6 |
| Y | KR 10-2020-0115003 A (SAMSUNG ELECTRONICS CO., LTD.) 07 October 2020 (2020-10-07)<br>See paragraphs [0108]-[0127]; and figures 9-11. | 11,15-17 |
| A | KR 10-2020-0106576 A (SAMSUNG DISPLAY CO., LTD.) 15 September 2020 (2020-09-15)<br>See paragraphs [0146]-[0232]; and figures 6-9. | 1-21 |
| A | US 2005-0110723 A1 (SHIN, Dong-Yong) 26 May 2005 (2005-05-26)<br>See paragraphs [0083]-[0097]; and figure 12. | 1-21 |

☐ Further documents are listed in the continuation of Box C.  ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **19 April 2023** | **19 April 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.

**PCT/KR2023/000539**

| Patent document cited in search report | | | Publication date (day/month/year) | Patent family member(s) | | | Publication date (day/month/year) |
|---|---|---|---|---|---|---|---|
| KR | 10-2009-0131405 | A | 29 December 2009 | KR | 10-0952814 | B1 | 14 April 2010 |
| | | | | US | 2009-0315874 | A1 | 24 December 2009 |
| KR | 10-2018-0105834 | A | 01 October 2018 | CN | 109314105 | A | 05 February 2019 |
| | | | | EP | 3564996 | A1 | 06 November 2019 |
| | | | | JP | 2018-109736 | A | 12 July 2018 |
| | | | | JP | 2018-112745 | A | 19 July 2018 |
| | | | | JP | 2019-053328 | A | 04 April 2019 |
| | | | | JP | 6289718 | B1 | 07 March 2018 |
| | | | | JP | 6461389 | B2 | 30 January 2019 |
| | | | | KR | 10-2018-0079814 | A | 11 July 2018 |
| | | | | KR | 10-2018-0095183 | A | 27 August 2018 |
| | | | | KR | 10-2318283 | B1 | 28 October 2021 |
| | | | | US | 10210795 | B2 | 19 February 2019 |
| | | | | US | 2018-0190184 | A1 | 05 July 2018 |
| | | | | US | 2019-0156734 | A1 | 23 May 2019 |
| | | | | WO | 2018-124424 | A1 | 05 July 2018 |
| KR | 10-2020-0115003 | A | 07 October 2020 | CN | 113396452 | A | 14 September 2021 |
| | | | | EP | 3871211 | A1 | 01 September 2021 |
| | | | | KR | 10-2020-0114980 | A | 07 October 2020 |
| | | | | US | 11100840 | B2 | 24 August 2021 |
| | | | | US | 11508287 | B2 | 22 November 2022 |
| | | | | US | 2020-0312216 | A1 | 01 October 2020 |
| | | | | US | 2021-0375185 | A1 | 02 December 2021 |
| | | | | WO | 2020-204487 | A1 | 08 October 2020 |
| KR | 10-2020-0106576 | A | 15 September 2020 | CN | 113557561 | A | 26 October 2021 |
| | | | | US | 11605335 | B2 | 14 March 2023 |
| | | | | US | 2022-0130325 | A1 | 28 April 2022 |
| | | | | WO | 2020-180036 | A1 | 10 September 2020 |
| US | 2005-0110723 | A1 | 26 May 2005 | AT | 366976 | T | 15 August 2007 |
| | | | | CN | 100463245 | C | 18 February 2009 |
| | | | | CN | 1622723 | A | 01 June 2005 |
| | | | | DE | 602004007457 | T2 | 20 March 2008 |
| | | | | EP | 1536406 | A1 | 01 June 2005 |
| | | | | EP | 1536406 | B1 | 11 July 2007 |
| | | | | EP | 1837851 | A2 | 26 September 2007 |
| | | | | EP | 1837851 | A3 | 20 February 2008 |
| | | | | EP | 1837851 | B1 | 17 July 2013 |
| | | | | JP | 2005-157258 | A | 16 June 2005 |
| | | | | JP | 4295163 | B2 | 15 July 2009 |
| | | | | KR | 10-0741961 | B1 | 23 July 2007 |
| | | | | KR | 10-2005-0050484 | A | 31 May 2005 |
| | | | | US | 9082344 | B2 | 14 July 2015 |

Form PCT/ISA/210 (patent family annex) (July 2022)